# EUROPEAN PATENT APPLICATION

(11) **EP 4 312 269 A1**
(43) Date of publication of application: **31.01.2024**
(21) Application number: 23184915.9
(22) Date of filing: 12.07.2023
(51) Int. Cl.: H01L 25/075, H01L 25/13, H01L 33/48, H01L 33/62

(54) **A SEMICONDUCTOR LIGHT EMITTING DEVICE PACKAGE AND A DISPLAY DEVICE**

(30) Priority: 29.07.2022 KR 20220094463
(71) Applicant: LG Electronics Inc., Yeongdeungpo-gu Seoul 07336 (KR)
(72) Inventor: OH, Taesu, Seoul 06772 (KR); PARK, Sungjin, Seoul 06772 (KR); KIM, Myoungsoo, Seoul 06772 (KR); KIM, Jungsub, Seoul 06772 (KR)
(74) Representative: Schornack, Oliver

(57) **Abstract**

A semiconductor light emitting device package can include a first layer having a first region and a second region surrounding the first region, a common electrode wiring on the first region of the first layer, a plurality of semiconductor light emitting devices on the common electrode wiring, a plurality of electrode wirings on upper sides of the plurality of semiconductor light emitting devices, a plurality of electrode pads on the second region of the first layer, and a second layer on the plurality of semiconductor light emitting devices, the plurality of electrode wirings, and the plurality of electrode pads.

The first layer and the second layer can have an elliptical shape. The plurality of electrode pads can include a first electrode pad, a second electrode pad, a third electrode pad, and at least one or more common electrode pads. The first electrode pad, the second electrode pad, and the third electrode pad can be configured to be disposed on the second region located on the minor axis of the elliptical shape. The common electrode pad can be configured to be disposed on the second region located on the major axis of the elliptical shape. The common electrode wiring can be configured to commonly connect lower sides of the plurality of semiconductor light emitting devices to the common electrode pad.

## Description

### The Background

### 1. The field

The embodiment relates to a semiconductor light emitting device package and a display device.

### 2. Description of the related art

A large-area display includes LCD display, OLED display, micro-LED display or the like.

A micro-LED display is a display using a semiconductor light emitting device having a diameter of 100 µm or less or a very small cross-sectional area, that is, a micro-LED as a display element.

The micro-LED display has excellent performance in many characteristics such as contrast ratio, response speed, color reproducibility, viewing angle, brightness, resolution, lifespan, luminous efficiency or luminance because it uses micro-LED, which is a semiconductor light emitting device, as a display element.

In particular, the micro-LED display has the advantage of being free to adjust the size or resolution as the screens can be separated and combined in a modular manner, and has the advantage of being able to implement a flexible display.

However, since a large-sized micro-LED display requires millions of micro-LEDs, there is a technical problem in that it is difficult to quickly and accurately transfer the micro-LEDs to a display panel.

Recently developed transfer technology includes a pick and place process, a laser lift-off method, or a self-assembly method.

Among them, the self-assembly method is a method in which a semiconductor light emitting device finds an assembly position in a fluid by itself, and is an advantageous method for implementing a large-screen display device.

However, research on the technology for manufacturing a display through self-assembly of micro-LED is still insufficient.

In particular, in the case of rapidly transferring millions or more semiconductor light emitting devices to a large-sized display in the related art, there is a technical problem that the transfer speed can be improved, but the transfer error rate increases, resulting in a low transfer yield.

In related technologies, a self-assembly type transfer process using dielectrophoresis (DEP) has been attempted, but there is a problem in that the assembly yield is lowered due to non-uniformity of DEP force.

Meanwhile, in the self-assembly method, assembly processes of a red light emitting device, a green light emitting device, and a blue light emitting device are separately performed. In each assembly process, a fluid input process, a light emitting device drop process, the assembly processes of the light emitting devices and recovery processes of the light emitting devices are performed. Therefore, there is a problem in that it takes a very long process time to sequentially assemble the red light emitting device, the green light emitting device, and the blue light emitting device on the substrate. In addition, when light emitting devices that have not been recovered in the previous assembly process are assembled together with other light emitting devices, there is a problem in that it is difficult to implement full color due to color mixing since light emitting devices emitting light of different colors in a specific color area are assembled.

In order to shorten the process time, a self-assembly method of simultaneously assembling the red light emitting device, the green light emitting device, and the blue color light emitting device has been proposed. However, since the shape and size of each of the red light emitting device, the green light emitting device, and the blue light emitting device are different to implement simultaneous assembly. Thus, there is a problem in that the color gamut is lowered because the amount of light of each of the red light emitting device, the green light emitting device, and the blue light emitting device is different from each other.

Meanwhile, the red light emitting device, the green light emitting device, and the blue light emitting device are disposed in an assembly hole of each sub-pixel in the pixel of the substrate. In this case, there is a limitation to reducing the distance between the assembly holes of each sub-pixel. Thus, due to the limitation, it is difficult to reduce the size of pixels so that it is difficult to implement ultra-high resolution.

### The Summary

An object of the embodiment is to solve the foregoing and other problems.

Another object of the embodiment is to provide a light emitting device package and a display device capable of improving assembly speed.

In addition, another object of the embodiment is to provide a light emitting device package and a display device that can solve the color gamut degradation.

Another object of the embodiment is to provide a light emitting device package and a display device capable of implementing ultra-high resolution.

The technical problem of the embodiment is not limited to those described in this section, and include those that can be grasped through the description of the invention.

According to one aspect of the embodiment to achieve the above or other object, a semiconductor light emitting device package, comprising: a first layer having a first region and a second region surrounding the first region; a common electrode wiring on the first region of the first layer; a plurality of semiconductor light emitting devices on the common electrode wiring; a plurality of electrode wirings on upper sides of the plurality of semiconductor light emitting devices; a plurality of electrode pads on the second region of the first layer; and a second layer on the plurality of semiconductor light emitting devices, the plurality of electrode wirings, and the plurality of electrode pads, wherein the first layer and the second layer have an elliptical shape, wherein the plurality of electrode pads comprise a first electrode pad, a second electrode pad, a third electrode pad, and at least one or more common electrode pads, wherein the first electrode pad, the second electrode pad, and the third electrode pad are configured to be disposed on the second region located on the minor axis of the elliptical shape, wherein the common electrode pad is configured to be disposed on the second region located on the major axis of the elliptical shape, and wherein the common electrode wiring is configured to commonly connect lower sides of the plurality of semiconductor light emitting devices to the common electrode pad.

The second region can comprise a second-first region on a first side of the first region and a second-second region on a second side of the first region along the minor axis direction of the elliptical shape; and a second-third region on a third side of the first region and a second-fourth region on a fourth side of the first region along the major axis direction of the elliptical shape. The plurality of semiconductor light emitting devices can comprise a first semiconductor light emitting device, a second semiconductor light emitting device, and a third semiconductor light emitting device constituting a first pixel. The first semiconductor light emitting device, the second semiconductor light emitting device, and the third semiconductor light emitting device can be arranged in a line along the major axis direction of the elliptical shape.

The plurality of semiconductor light emitting devices can comprise a fourth semiconductor light emitting device, a fifth semiconductor light emitting device, and a sixth semiconductor light emitting device constituting a second pixel. The plurality of electrode pads can comprise a fourth electrode pad, a fifth electrode pad, and a sixth electrode pad. The first to sixth electrode pads can be configured to be connected to the first to sixth semiconductor light emitting devices.

The plurality of semiconductor light emitting devices can comprise a fourth semiconductor light emitting device, a fifth semiconductor light emitting device, and a sixth semiconductor light emitting device constituting a redundancy pixel. The plurality of electrode pads can comprise a fourth electrode pad, a fifth electrode pad, and a sixth electrode pad. The first to sixth electrode pads can be configured to be connected to the first to sixth semiconductor light emitting devices.

The first to third semiconductor light emitting devices can emit a first light.

The semiconductor light emitting device package can comprise a color conversion layer between the first to third semiconductor light emitting devices and the second layer. The color conversion layer can comprise a first color conversion pattern configured to output a second light using the first light emitted from the second semiconductor light emitting device; and a second color conversion pattern configured to output a third light using the first light emitted from the third semiconductor light emitting device. The first light, the second light, and the third light can be different from each other.

The semiconductor light emitting device package can comprise at least one layer of a reflective layer or a magnetic layer below the first layer.

According to another aspect of the embodiment, a display device, comprising: a substrate; a plurality of first signal lines and a plurality of second signal lines on the substrate, at least one or more first signal lines among the plurality of first signal lines comprising a first assembling wiring, and at least one or more second signal lines among the plurality of second signal lines comprising a second assembling wiring; a barrier rib having an assembly hole on the first assembling wiring and the second assembling wiring; and a semiconductor light emitting device package in the assembly hole, wherein the semiconductor light emitting device package comprises: a first layer having a first region and a second region surrounding the first region; a common electrode wiring on the first region of the first layer; a plurality of semiconductor light emitting devices on the common electrode wiring; a plurality of electrode wirings on upper sides of the plurality of semiconductor light emitting devices; a plurality of electrode pads on the second region of the first layer; and a second layer on the plurality of semiconductor light emitting devices, the plurality of electrode wirings, and the plurality of electrode pads, wherein the assembly hole has a shape corresponding to a shape of the semiconductor light emitting device package, and wherein the first layer and the second layer have an elliptical shape.

The plurality of electrode pads can comprise a first electrode pad, a second electrode pad, a third electrode pad, and at least one or more common electrode pads. The first electrode pad, the second electrode pad, and the third electrode pad can be disposed on the second region located on the minor axis of the elliptical shape. The plurality of electrode wirings can be configured to connect upper sides of the plurality of semiconductor light emitting devices to the first electrode pad, the second electrode pad, and the third electrode pad. The common electrode pad can be disposed on the second region located on the major axis of the elliptical shape. The common electrode wiring can be configured to commonly connects lower sides of the plurality of semiconductor light emitting devices to the common electrode pad.

The plurality of first signal lines can comprise a first-first signal line, a first-second signal line, a first-third signal line, and a first-fourth signal line crossing the first-third signal line. The first-first signal line among the first-first signal line, the first-second signal line, and the first-third signal line can be closest to the assembly hole. The plurality of second signal lines can comprise a second-first signal line, a second-second signal line, and a second-third signal line disposed in parallel with the plurality of first signal lines and a second-fourth signal line crossing the second-third signal line. The second-first signal line among the second-first signal line, the second-second signal line, and the second-third signal line can be closest to the assembly hole.

The first assembling wiring can be configured to extend from the first-first signal line toward the assembly hole. The second assembling wiring can be configured to extend from the second-first signal line toward the assembly hole. The first assembling wiring and the second assembling wiring can be disposed on the same layer.

The first assembling wiring can be configured to extend from the first-first signal line toward the assembly hole. The second assembling wiring can be configured to extend from the second-first signal line toward the assembly hole. The first assembling wiring and the second assembling wiring can be disposed on different layers.

The first assembling wiring can be configured to extend from the first-fourth signal line toward the assembly hole. The second assembling wiring can be configured to extend from the second-fourth signal line toward the assembly hole. The first assembling wiring and the second assembling wiring can be disposed on the same layer.

The first assembling wiring can comprise a first-first assembling wiring, a first-second assembling wiring, and a first-third assembling wiring extending toward the assembly hole from the first-first signal line, the first-second signal line, and the first-third signal line. The second assembling wiring can comprise a second-first assembling wiring, a second-second assembling wiring, and a second-third assembling wiring extending toward the assembly hole from the second-first signal line, the second-second signal line, and the second-third signal line.

The first-first assembling wiring and the second-first assembling wiring can be configured to face each other and can be disposed on the same layer. The first-second assembling wiring and the second-second assembling wiring can be configured to face each other and can be disposed on the same layer. The first-third assembling wirings and the second-third assembling wirings can be configured to face each other and can be disposed on the same layer.

The first-first assembling wiring and the second-third assembling wiring can be configured to face each other and can be disposed on different layers. The first-second assembling wiring and the second-second assembling wiring can be configured to face each other and can be disposed on the same layer. The first-third assembling wirings and the second-first assembling wirings can be configured to face each other and can be disposed on different layers.

Two among the first electrode pad, the second electrode pad, and the third electrode pad can be configured to be connected to two among the first-first signal line, the first-second signal line, and the first-third signal line. One of the first electrode pad, the second electrode pad, and the third electrode pad can be configured to be connected to one of the second-first signal line, the second-second signal line, and the second-third signal line.

One of the first electrode pad, the second electrode pad, and the third electrode pad can be configured to be connected to one of the first-first signal line, the first-second signal line, and the first-third signal line. Two among the first electrode pad, the second electrode pad, and the third electrode pad can be configured to be connected to two among the second-first signal line, the second-second signal line, and the second-third signal line.

The first assembling wiring can comprise a first-fourth assembling wiring extending from the first-fourth signal line toward the assembly hole. The second assembling wiring can comprise a second-fourth assembling wiring extending from the second-fourth signal line toward the assembly hole.

Two among the first electrode pad, the second electrode pad, and the third electrode pad can be configured to be connected to two among the first-first assembling wiring, the first-second assembling wiring, and the first-third assembling wiring in the assembly hole. One of the first electrode pad, the second electrode pad, and the third electrode pad can be configured to be connected to one of the second-first assembling wiring, the second-second assembling wiring, and the second-third assembling wiring in the assembly hole. The common electrode pad can be configured to be connected to one of the first-fourth assembling wiring and the second-fourth assembling wiring.

One of the first electrode pad, the second electrode pad, and the third electrode pad can be configured to be connected to one of the first-first assembling wiring, the first-second assembling wiring, and the first-third assembling wiring in the assembly hole. Two among the first electrode pad, the second electrode pad, and the third electrode pad can be configured to be connected to two among the second-first assembling wiring, the second-second assembling wiring, and the second-third assembling wiring in the assembly hole. The common electrode pad can be configured to be connected to one of the first-fourth assembling wiring and the second-fourth assembling wiring.

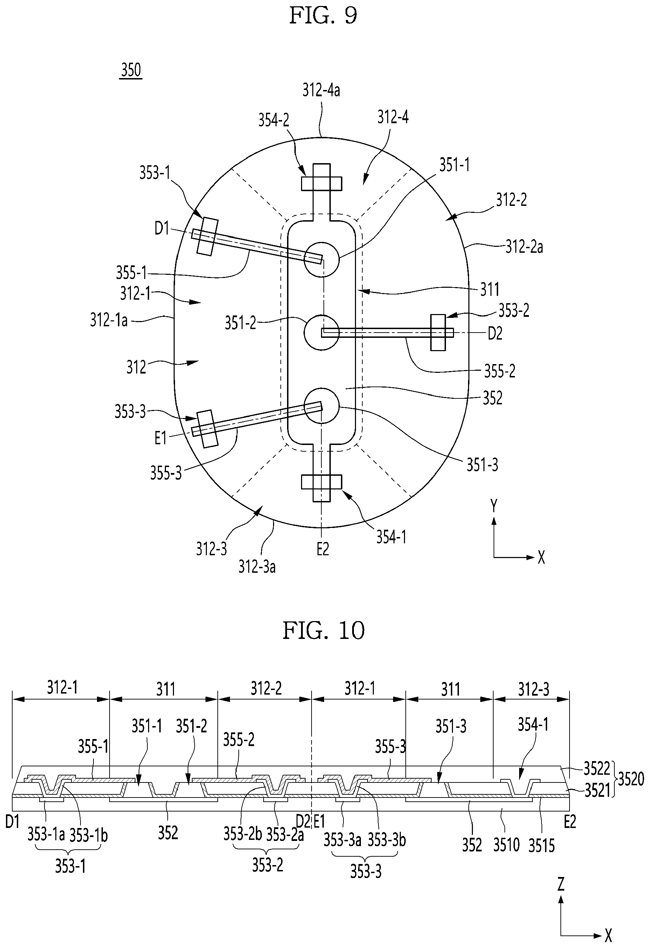

Technical effects by the embodiments are as follows. As shown in FIG. 9, a semiconductor light emitting device package 350 can be provided. The semiconductor light emitting device package 350 can comprise a plurality of semiconductor light emitting devices 351-1 to 351-3 for displaying an image and a plurality of electrode pads 353-1 to 353-3, 354-1, and 354-2 connected to the plurality of semiconductor light emitting devices 351-1 to 351-3. Accordingly, problems caused by individually assembling a plurality of semiconductor light emitting devices for displaying an image on a substrate during self-assembly can be solved. For example, problems such as long process time, poor color mixing due to unrecovered semiconductor light emitting devices, and low assembly rate due to small size can be solved.

In the semiconductor light emitting device package 350, the plurality of semiconductor light emitting devices 351-1 to 351-3 can be located in a central region, and the plurality of electrode pads 353-1 to 353-3, 354-1, and 354-2 can be located in the edge area. Thus, a very easy electrical connections can be implemented between the plurality of electrode pads 353-1 to 353-3, 354-1, and 354-2 and external lines, for example, signal lines.

The semiconductor light emitting device package 350 has an elliptical shape, and an assembly hole corresponding to the semiconductor light emitting device package 350 also has an elliptical shape so that during self-assembly, the semiconductor light emitting device package 350 can be assembled and fixed in the assembly hole in the normal position or rotated by 180° based on the normal position. Therefore, the fixing force of the semiconductor light emitting device package 350 can be strengthened.

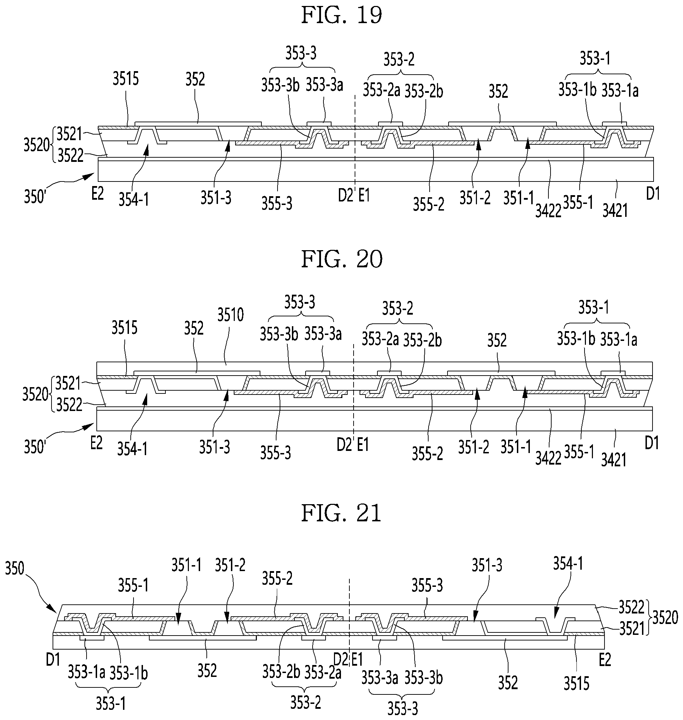

Meanwhile, as shown in FIG. 19, in an intermediate stage of manufacturing the semiconductor light emitting device package 350, since the plurality of electrode pads 353-1 to 353-3, 354-1 and 354-2 connected to each of the plurality of semiconductor light emitting devices 351-1 to 351-3 are exposed, lighting inspection can be possible using the plurality of electrode pads 353-1 to 353-3, 354-1, and 354-2 exposed in this way. Accordingly, since it is possible to determine whether or not the semiconductor light emitting device package 350 is defective before the self-assembly process, the self-assembly process is performed without knowing whether the semiconductor light emitting device package 350 is defective, and then the defect of the semiconductor light emitting device package 350 is confirmed later to produce a product such that huge time loss or economic loss are caused by discarding products right before shipment can occur. Embodiments can solve these problems.

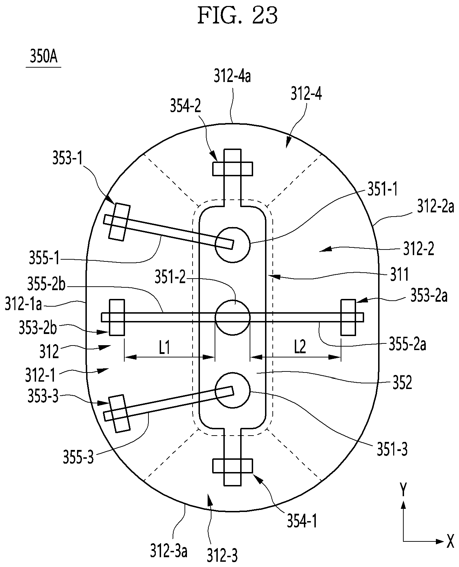

As shown in FIG. 23, the red semiconductor light emitting device 351-2 having low luminance is disposed in the center of the central region, and a 2-1 connection pad 353-2a and a 2-2 connection pad 353-2b connected to the red semiconductor light emitting device 351-2 can be provided on both sides of the red semiconductor light emitting device 351-2. In this case, a red data signal, for example, current is supplied through the 2-1 connection pad 353-2a and the 2-2 connection pad 353-2b, respectively so that the luminance of the red semiconductor light emitting device 351-2 can improve.

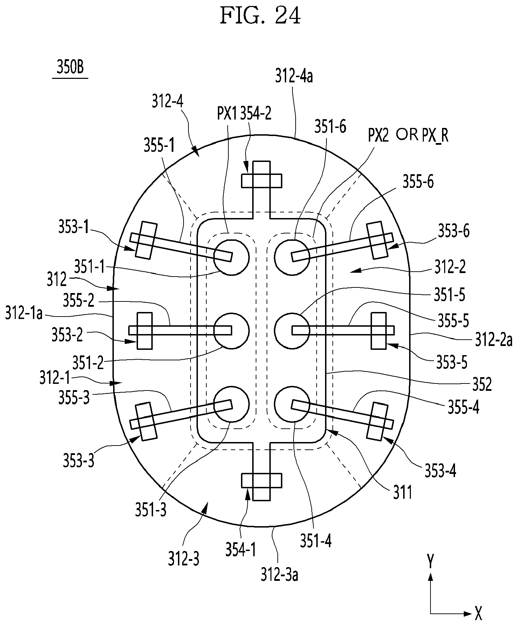

As shown in FIG. 24, the semiconductor light emitting device package 350B includes two pixels PX1 and PX2. During self-assembly, by assembling the semiconductor light emitting device packages 350B having the number of which is reduced by 1/2 compared to the semiconductor light emitting device package having one pixel, on a substrate having a predetermined number of pixels. Thus, the assembly speed is remarkably improved and the possibility of assembly defects can be drastically reduced.

Also, as shown in FIG. 24, the semiconductor light emitting device package 350B can comprise one pixel PX and one redundancy pixel PX_R. When implementing a display, even if one or more semiconductor light emitting devices among the plurality of semiconductor light emitting devices 351-1 to 351-3 included in the pixel PX fail, it can be replaced with a plurality of semiconductor light emitting devices 351-4 to 351-6 included in the redundancy pixels PX_R. Accordingly, image display defects can be prevented and product life can be extended.

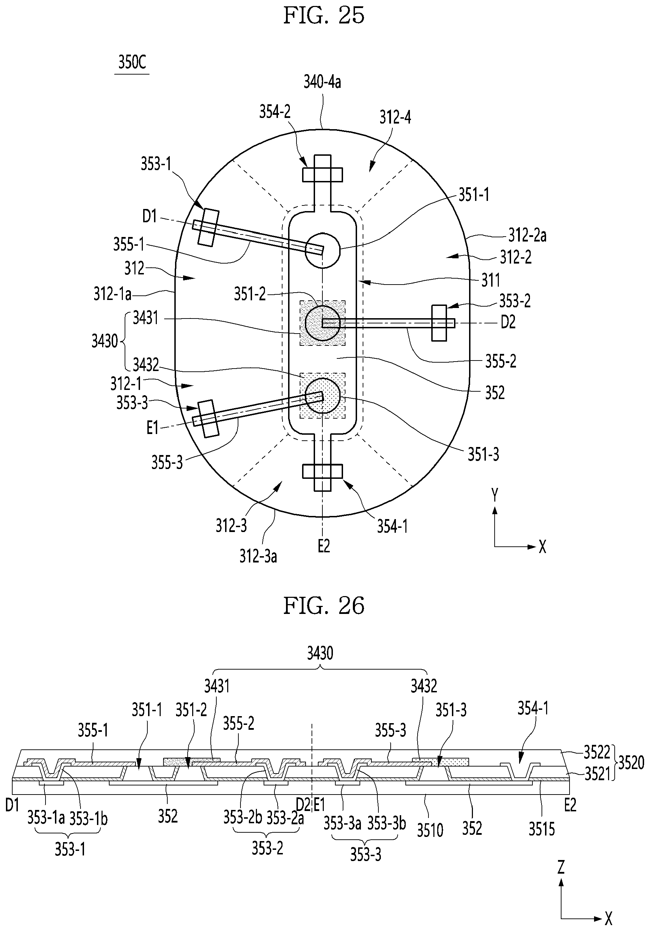

As shown in FIG. 25, the semiconductor light emitting device package 350C can comprise a color conversion layer 3430. The first light is converted into the second light and the third light, and an image can be displayed by the first light, the second light, and the third light. That is, a color conversion display can be implemented by assembling the semiconductor light emitting device package 350C comprising the color conversion layer 3430 on a substrate using a self-assembly process. Accordingly, it is possible to solve the difficulty of directly implementing the color conversion layer 3430 having high resolution on the substrate.

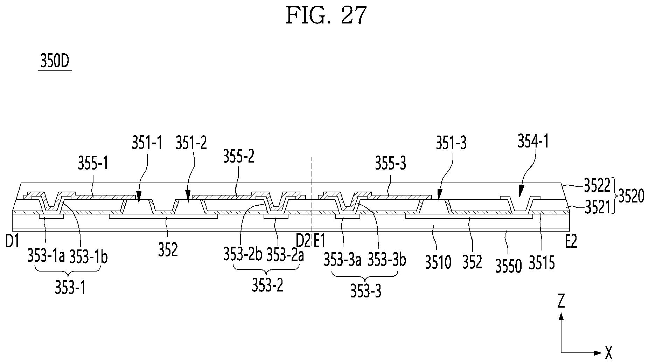

As shown in FIG. 27, a magnetic layer 3550 is formed on the entire area of a lower side of the semiconductor light emitting device package 350D so that the size of the magnetic layer 3550 can be maximized. Therefore, even if the size of the semiconductor light emitting device package 350D is larger than the size of individual semiconductor light emitting devices, by increasing the magnetization strength of the magnetic layer 3550 to the maximum, the semiconductor light emitting device package 350D can be immediately moved by the magnet during self-assembly, thereby dramatically increasing the assembly speed.

Meanwhile, in the embodiment, various semiconductor light emitting device packages described above can be efficiently connected to a plurality of signal lines using various methods.

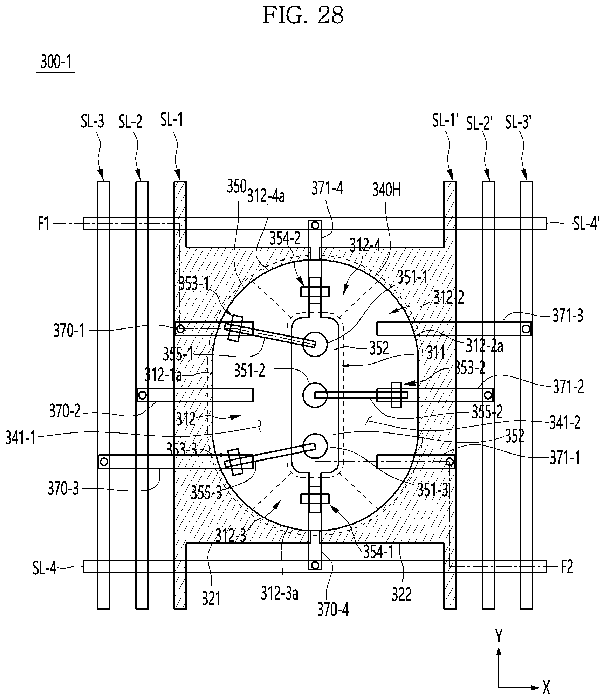

As shown in FIG. 28, a plurality of first signal lines SL-1 to SL-4 and a plurality of second signal lines SL-1' to SL-4' can be disposed around the semiconductor light emitting device package 350. Accordingly, regardless of whether the semiconductor light emitting device package 350 is assembled into the assembly hole 340H in the normal position or rotated by 180° based on the normal position, the plurality of electrode pads 353-1 to 353-3, 354-1, and 354-2 on the semiconductor light emitting device package 350 can electrically be connected to the plurality of first signal lines SL-1 to SL-4 or the plurality of second signal lines SL-1 to SL-4 so that the degree of freedom in assembly direction can be maximized.

In addition, the first-first signal line SL-1 among the plurality of first signal lines SL-1 to SL-4 is used as a first assembling wiring 321, and the second signal line SL-1' among the plurality of second signal lines SL-1' to SL-4' can be used as a second assembling wiring 322. Accordingly, there is no need to separately form the first assembling wiring 321 and the second assembling wiring 322 so the structure is simple and the process time can be reduced.

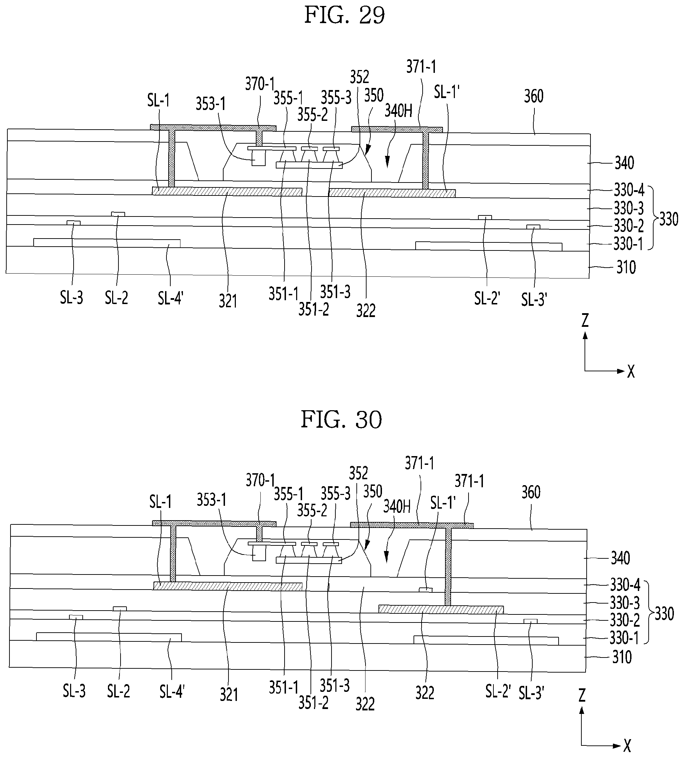

The first assembling wiring 321 and the second assembling wiring 322 can be disposed on the same layer (FIG. 29) or can be disposed on different layers (FIG. 30).

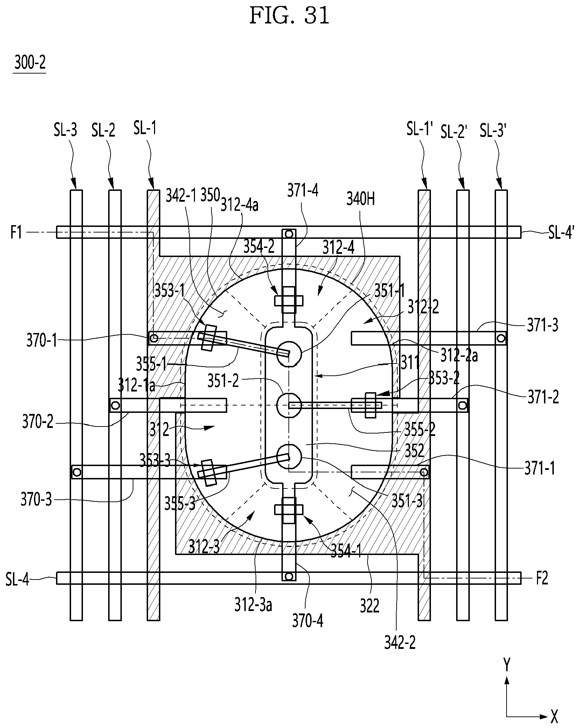

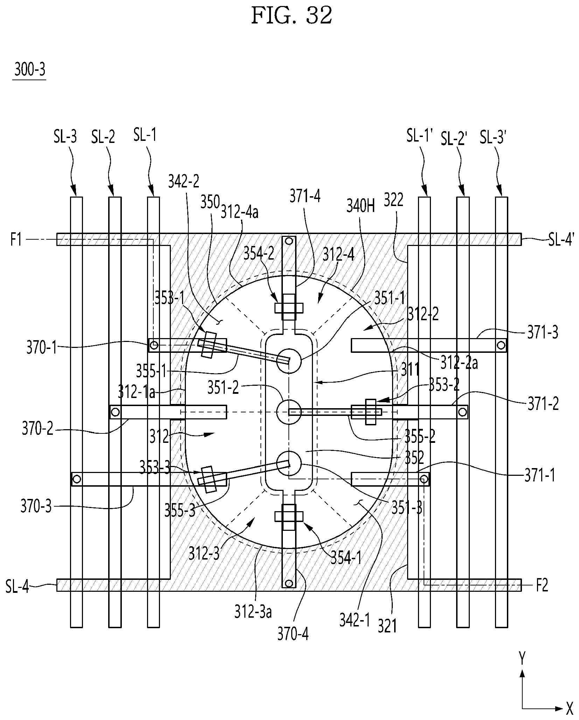

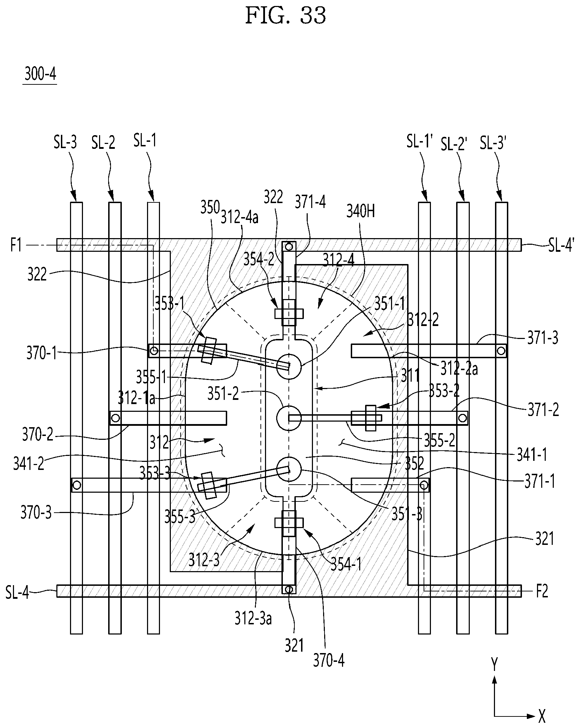

The first assembling wiring 321 and the second assembling wiring 322 can be disposed to face each other along the first direction X (FIG. 28 and FIG. 33) or to face each other along the second direction Y (FIG. 31 and FIG. 32).

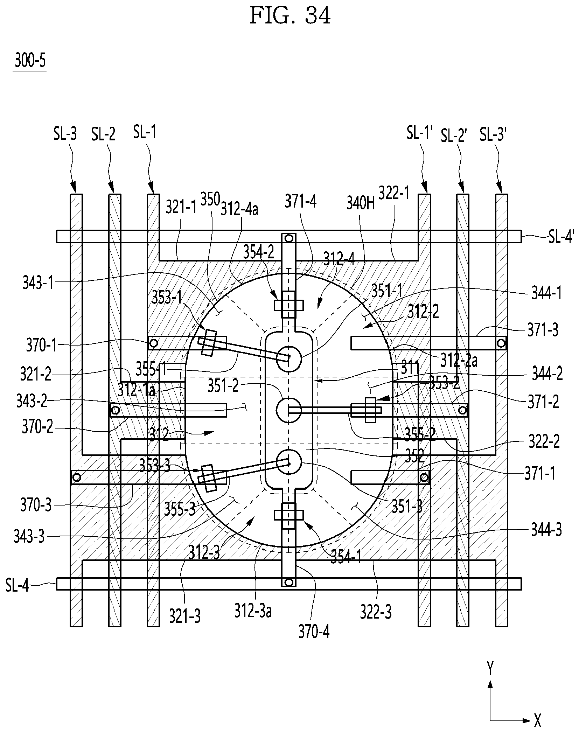

Meanwhile, as shown in FIG. 34, a plurality of first assembling wirings 321-1 to 321-3 and a plurality of second assembling wirings 322-1 to 322-3 can be provided. The plurality of first assembling wirings 321-1 to 321-3 are formed by extending from each of the plurality of first signal lines SL-1 to SL-3, and each of the plurality of first assembling wirings 321-1 to 321-3 321-3) can be formed to extend from the plurality of second signal lines SL-1' to SL-3', respectively.

In this case, a plurality of DEP forces can be formed between the first assembling wirings 321-1 to 321-3 and the plurality of second assembling wirings 322-1 to 322-3. Accordingly, a large and uniform DEP force is formed in the assembly hole so that even if the size of the semiconductor light emitting device package is larger than the size of individual semiconductor light emitting devices, it can be easily assembled into the assembly hole.

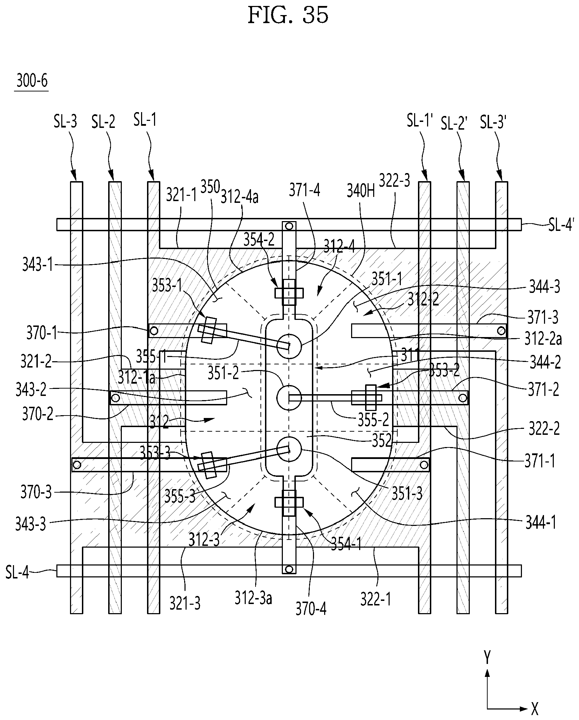

Meanwhile, the first assembling wirings 321-1 to 321-3 and the second assembling wirings 322-1 to 322-3 facing each other can be disposed on the same layer (FIG. 34) or can be disposed on different layers. (FIG. 35).

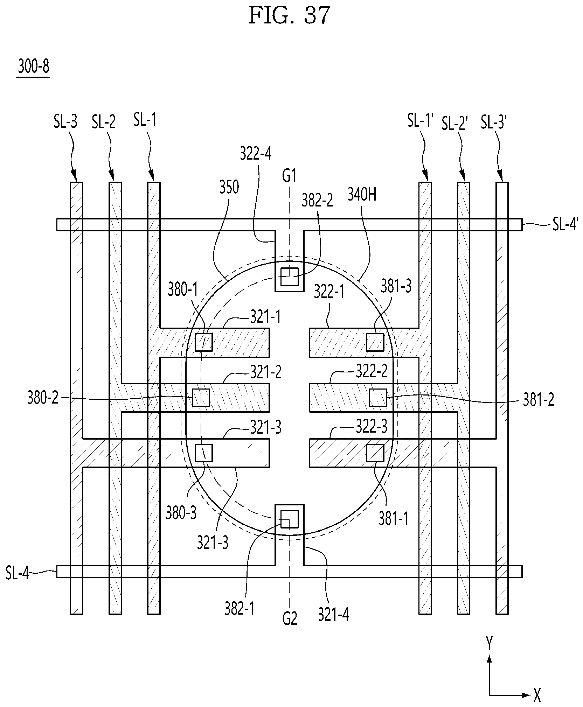

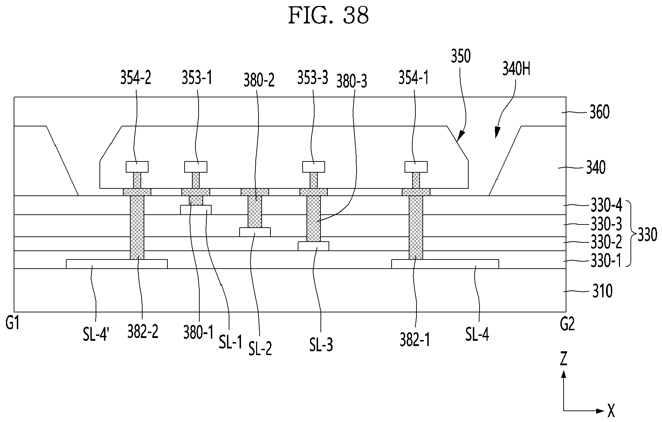

As shown in FIG. 37 and FIG. 38, the plurality of first assembling wirings 321-1 to 321-3 and the plurality of second assembling wirings 322-1 to 322-3 disposed in the assembly hole are not only used to assemble the semiconductor light emitting device package, but also used to emit light in the semiconductor light emitting device package.
During self-assembly, a semiconductor light emitting device package can be assembled into the assembly hole by using a plurality of DEP forces respectively formed between the plurality of first assembling wirings 321-1 to 321-3 and the plurality of second assembling wirings 322-1 to 322-3.

Before self-assembly is performed, the plurality of electrode pads 353-1 to 353-3, 354-1, and 4354-2 can be exposed through a lower side of the semiconductor light emitting device, and each of the plurality of first assembling wirings 321-1 to 321-3 and each of the plurality of second assembling wirings 322-1 to 322-3 can be exposed to the assembly hole through a contact hole. At this time, after the semiconductor light emitting device is self-assembled into a state in which a connection electrode made of solder material is disposed in the contact hole, a pressurization/heating process can be performed to melt a connection electrode made of solder material so that electrode pads 353-1 to 353-3, 354-1, and 4354-2 of the plurality of semiconductor light emitting device packages can be connected to the plurality of first assembling wirings 321-1 to 321-3 and/or the plurality of second assembling wirings 322-1 to 321-3 through the connection electrodes.

Accordingly, to connect the plurality of electrode pads 353-1 to 353-3, 354-1, and 354-2, the plurality of first signal lines SL-1 to SL-4, and/or the plurality of second signal lines SL-1' to SL-4', a plurality of connection lines (370-1 to 370-4 and 371-1 to 371-4 in FIG. 28) do not need to be formed on the semiconductor light emitting device package 350. In addition, the structure is simple and the process time can be reduced, and electrical short defects between the connection lines (370-1 to 370-4 and 371-1 to 371-4 in FIG. 28) can be prevented.
A further scope of applicability of the embodiment will become apparent from the detailed description that follows. However, since various changes and modifications within the spirit and scope of the embodiment can be clearly understood by those skilled in the art, it should be understood that the detailed description and specific embodiment, such as preferred embodiment, are given by way of example only.

### Brief description of the drawings

FIG. 1 illustrates a living room of a house in which a display device according to an embodiment is disposed.
FIG. 2 is a block diagram schematically illustrating a display device according to an embodiment.
FIG. 3 is a circuit diagram showing an example of a pixel of FIG. 3.
FIG. 4 is an enlarged view of a first panel region in the display device of FIG. 1.
FIG. 5 is an enlarged view of the area A2 of FIG. 4.
FIG. 6 is a view showing an example in which a light emitting device according to an embodiment is assembled to a substrate by a self-assembly method.
FIG. 7 is a circuit diagram illustrating a display device according to an embodiment.
FIG. 8 is a cross-sectional view taken along the line C1-C2 in the display device according to the embodiment of FIG. 7.
FIG. 9 is a plan view illustrating a semiconductor light emitting device package according to a first embodiment.
FIG. 10 is a cross-sectional view taken along the lines D1-D2 and E1-E2 in the semiconductor light emitting device package according to the first embodiment of FIG. 9.
FIG. 11 illustrates a state in which the semiconductor light emitting device package according to the first embodiment is connected to a plurality of connection lines after being assembled into an assembly hole in the normal position.
FIG. 12 illustrates a state in which the semiconductor light emitting device package according to the first embodiment is rotated by 180° based on the normal position and assembled into an assembly hole, and then connected to a plurality of connection lines.
FIG. 13 illustrates a state in which the semiconductor light emitting device package according to the first embodiment is assembled into an assembly hole in a distorted state and then connected to a plurality of connection lines.
FIG. 14 to FIG. 21 are cross-sectional views illustrating manufacturing processes of the semiconductor light emitting device package according to the first embodiment.
FIG. 22 illustrates a state in which lighting inspection is performed on a preliminary semiconductor light emitting device package during a manufacturing process of a semiconductor light emitting device package according to the first embodiment.
FIG. 23 is a plan view illustrating a semiconductor light emitting device package according to a second embodiment.
FIG. 24 is a plan view illustrating a semiconductor light emitting device package according to a third embodiment.
FIG. 25 is a plan view illustrating a semiconductor light emitting device package according to a fourth embodiment.
FIG. 26 is a cross-sectional view taken along the lines D1-D2 and E1-E2 in the semiconductor light emitting device package according to the fourth embodiment of FIG. 25.
FIG. 27 is a plan view illustrating a semiconductor light emitting device package according to a fifth embodiment.
FIG. 28 is a plan view illustrating a display device according to a first embodiment.
FIG. 29 is a cross-sectional view taken along the line F1-F2 in the display device according to the first embodiment of FIG. 28.
FIG. 30 is another cross-sectional view taken along the line F1-F2 in the display device according to the first embodiment of FIG. 28.
FIG. 31 is a plan view illustrating a display device according to a second embodiment.
FIG. 32 is a plan view illustrating a display device according to a third embodiment.
FIG. 33 is a plan view illustrating a display device according to a fourth embodiment.
FIG. 34 is a plan view illustrating a display device according to a fifth embodiment.
FIG. 35 is a plan view illustrating a display device according to a sixth embodiment.
FIG. 36 is a plan view illustrating a display device according to a seventh embodiment.
FIG. 37 is a plan view illustrating a display device according to an eighth embodiment.
FIG. 38 is a cross-sectional view taken along the line G1-G2 in the display device according to the eighth embodiment of FIG. 37.

The sizes, shapes, dimensions, etc. of elements shown in the drawings can differ from actual ones. In addition, even if the same elements are shown in different sizes, shapes, dimensions, etc. between the drawings, this is only an example on the drawing, and the same elements have the same sizes, shapes, dimensions, etc. between the drawings.

### The Detailed description

Hereinafter, the embodiment disclosed in this specification will be described in detail with reference to the accompanying drawings, but the same or similar elements are given the same reference numerals regardless of reference numerals, and redundant descriptions thereof will be omitted. The suffixes 'module' and 'unit' for the elements used in the following descriptions are given or used interchangeably in consideration of ease of writing the specification, and do not themselves have a meaning or role that is distinct from each other. In addition, the accompanying drawings are for easy understanding of the embodiment disclosed in this specification, and the technical idea disclosed in this specification is not limited by the accompanying drawings. Also, when an element such as a layer, region or substrate is referred to as being 'on' another element, this means that there can be directly on the other element or be other intermediate elements therebetween.

The display device described in this specification can comprise TV, the signage, a mobile phone, a smart phone, a head-up display (HUD) for a vehicle, a backlight unit for a laptop computer, a display for VR, AR, MR, XR or the like. However, the configuration according to the embodiment described in this specification can be applied to a display-capable device even if it is a new product type to be developed in the future.

Hereinafter, a light emitting device according to an embodiment and a display device comprising the light emitting device will be described.

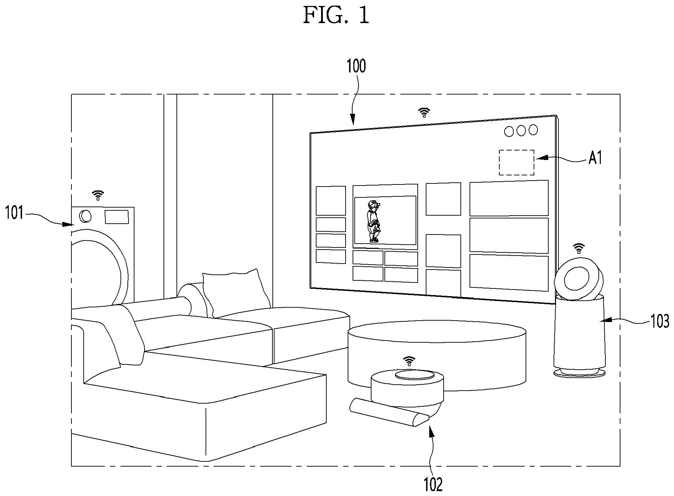

FIG. 1 illustrates a living room of a house in which a display device according to an embodiment is disposed.

Referring to FIG. 1, the display device 100 of the embodiment can display the status of various electronic products such as a washing machine 101, a robot cleaner 102, and an air purifier 103, communicate with each electronic product based on IOT and control each electronic product based on user's setting data.

The display device 100 according to the embodiment can include a flexible display manufactured on a thin and flexible substrate. The flexible display can be bent or rolled like paper while maintaining the characteristics of an existing flat panel display.

In the flexible display, visual information can be implemented by independently controlling light emission of a unit pixel arranged in a matrix form. The unit pixel means a minimum unit for implementing one color. The unit pixel of the flexible display can be implemented by a light emitting device. In the embodiment, the light emitting device can be Micro-LED or Nano-LED, but is not limited thereto.

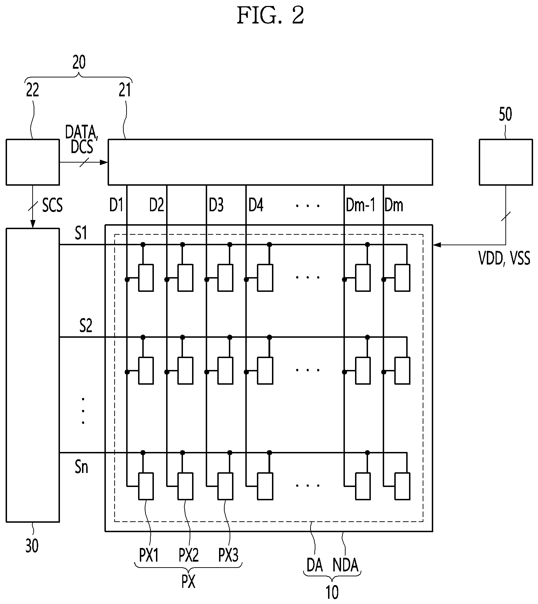

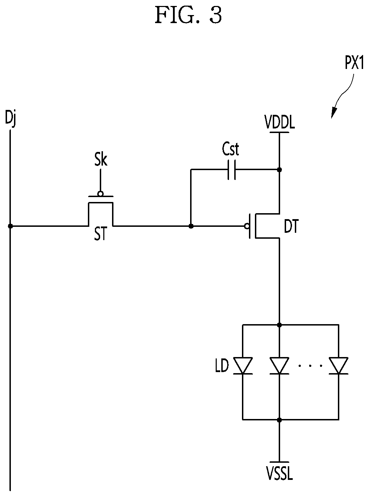

FIG. 2 is a block diagram schematically illustrating a display device according to an embodiment. FIG. 3 is a circuit diagram showing an example of a pixel of FIG. 2.

Referring to FIG. 2 and FIG. 3, a display device according to an embodiment can comprise a display panel 10, a driving circuit 20, a scan driving circuit 30 and a power supply circuit 50.

The display device 100 of the embodiment can drive a light emitting device in an active matrix (AM) scheme or a passive matrix (PM) scheme.

The driving circuit 20 can comprise a data driving circuit 21 and a timing controller 22.

The display panel 10 can have a rectangular shape, but is not limited thereto. That is, the display panel 10 can be formed in a circular or elliptical shape. At least one side of the display panel 10 can be formed to be bent with a predetermined curvature.

The display panel 10 can be divided into a display area DA and a non-display area NDA disposed around the display area DA. The display area DA is an area where the pixels PX are formed to display an image. The display panel 10 can comprise data lines CD1 to Dm, where m is an integer greater than or equal to 2), scan lines (S1 to Sn, where n is an integer greater than or equal to 2) crossing the data lines (D1 to Dm), a high potential voltage line VDDL supplied with a high potential voltage, a low potential voltage line VSSL supplied with a low potential voltage, and pixels PX connected to the data lines D1 to Dm and the scan lines S1 to Sn.

Each of the pixels PX can comprise a first sub-pixel PX1, a second sub-pixel PX2, and a third sub-pixel PX3. The first sub-pixel PX1 can emit a first color light with a first main wavelength, the second sub-pixel PX2 can emit of a second color light with a second main wavelength, and the third sub-pixel PX3 can emit a third color light with a third main wavelength. The first color light can be red light, the second color light can be green light, and the third color light can be blue light, but are not limited thereto. In addition, in FIG. 3, it is illustrated that each of the pixels PX comprise three sub-pixels, but are not limited thereto. That is, each of the pixels PX can comprise four or more sub-pixels.

Each of the first sub-pixel PX1, the second sub-pixel PX2, and the third sub-pixel PX3 can be connected to at least one of the data lines D1 to Dm, at least one of the scan lines S1 to Sn, and a high potential voltage line VDDL. As shown in FIG. 3, the first sub-pixel PX1 can include light emitting devices LDs, a plurality of transistors for supplying current to the light emitting devices LDs, and at least one capacitor Cst.

Although not shown in the drawing, each of the first sub-pixel PX1, the second sub-pixel PX2, and the third sub-pixel PX3 can include only one light emitting device LD and at least one capacitor Cst.

Each of the light emitting devices LD can be a semiconductor light emitting diode comprising a first electrode, a plurality of conductive semiconductor layers, and a second electrode. Here, the first electrode can be an anode electrode, and the second electrode can be a cathode electrode, but is not limited thereto.

The light emitting device LD can be one of a lateral type light emitting device, a flip- chip type light emitting device, and a vertical type light emitting device.

The plurality of transistors can include a driving transistor DT supplying current to the light emitting devices LD and a scan transistor ST supplying a data voltage to a gate electrode of the driving transistor DT, as shown in FIG. 3. The driving transistor DT has a gate electrode connected to the source electrode of the scan transistor ST, a source electrode connected to the high potential voltage line VDDL to which a high potential voltage is applied, and a drain electrode connected to the first electrodes of the light emitting devices LD. The scan transistor ST has a gate electrode connected to the scan line (Sk, k is an integer that satisfies 1≤k≤n), a source electrode connected to the gate electrode of the driving transistor DT, and a drain electrode connected to the data lines (Dj, j an integer that satisfies 1≤j≤m).

The capacitor Cst is formed between the gate electrode and the source electrode of the driving transistor DT. The storage capacitor Cst stores a difference voltage between a gate voltage and a source voltage of the driving transistor DT.

The driving transistor DT and the scan transistor ST can be formed of a thin film transistor. In addition, in FIG. 3, the driving transistor DT and the scan transistor ST have been mainly described as being formed of P-type MOSFETs (Metal Oxide Semiconductor Field Effect Transistors), but are not limited thereto. The driving transistor DT and the scan transistor ST can be formed of N-type MOSFETs. In this case, positions of the source electrode and the drain electrode of each of the driving transistor DT and the scan transistor ST can be changed.

In addition, in FIG. 3, it is illustrated that each of the first sub-pixel PX1, the second sub-pixel PX2, and the third sub-pixel PX3 includes 2T1C (2 Transistor -1 capacitor) having one driving transistor DT, one scan transistor ST, and one capacitor Cst, but is not limited thereto. Each of the first sub-pixel PX1, the second sub-pixel PX2, and the third sub-pixel PX3 can include a plurality of scan transistors ST and a plurality of capacitors Cst.

Since the second sub-pixel PX2 and the third sub-pixel PX3 can be expressed with substantially the same circuit diagram as the first sub-pixel PX1, detailed descriptions will be omitted.

The driving circuit 20 outputs signals and voltages for driving the display panel 10.

To this end, the driving circuit 20 can include a data driving circuit 21 and a timing controller 22.

The data driving circuit 21 receives digital video data DATA and a source control signal DCS from the timing controller 22. The data driving circuit 21 converts the digital video data DATA into analog data voltages according to the source control signal DCS and supplies them to the data lines D1 to Dm of the display panel 10.

The timing controller 22 receives digital video data DATA and timing signals from a host system. The timing signals can include a vertical synchronization signal, a horizontal synchronization signal, a data enable signal, and a dot clock. The host system can be an application processor of a smart phone or tablet PC, a system on chip of a monitor or TV, or the like.

The timing controller 22 generates control signals for controlling operation timings of the data driving circuit 21 and the scan driving circuit 30. The control signals can include a source control signal DCS for controlling the operation timing of the data driving circuit 21 and a scan control signal SCS for controlling the operation timing of the scan driving circuit 30.

The driving circuit 20 can be disposed in the non-display area NDA provided on one side of the display panel 10. The driving circuit 20 can be formed of an integrated circuit (IC) and mounted on the display panel 10 using a chip on glass (COG) scheme, a chip on plastic (COP) scheme, or an ultrasonic bonding scheme, but is not limited thereto. For example, the driving circuit 20 can be mounted on a circuit board (not shown) instead of the display panel 10.

The data driving circuit 21 can be mounted on the display panel 10 using a chip on glass (COG) scheme, a chip on plastic (COP) scheme, or an ultrasonic bonding scheme, and the timing controller 22 can be mounted on a circuit board.

The scan driving circuit 30 receives the scan control signal SCS from the timing controller 22. The scan driving circuit 30 generates scan signals according to the scan control signal SCS and supplies them to the scan lines S1 to Sn of the display panel 10. The scan driving circuit 30 can include a plurality of transistors and be formed in the non-display area NDA of the display panel 10. Alternatively, the scan driving circuit 30 can be formed as an integrated circuit, and in this case, it can be mounted on a gate flexible film attached to the other side of the display panel 10.

The circuit board can be attached to pads provided on one edge of the display panel 10 using an anisotropic conductive film. For this reason, the lead lines of the circuit board can be electrically connected to the pads. The circuit board can be a flexible printed circuit board, a printed circuit board, or a flexible film such as a chip on film. The circuit board can be bent to a lower side of the display panel 10. Accordingly, one side of the circuit board can be attached to one edge of the display panel 10 and the other side can be disposed below the display panel 10 and can be connected to a system board on which a host system is mounted.

The power supply circuit 50 can generate voltages necessary for driving the display panel 10 from the main power supplied from the system board and supply the voltages to the display panel 10. For example, the power supply circuit 50 generates a high potential voltage VDD and a low potential voltage VSS for driving the light emitting devices LD of the display panel 10 from the main power supply to supply them to the high potential voltage line VDDL and the low potential voltage line VSSL. Also, the power supply circuit 50 can generate and supply driving voltages for driving the driving circuit 20 and the scan driving circuit 30 from the main power.

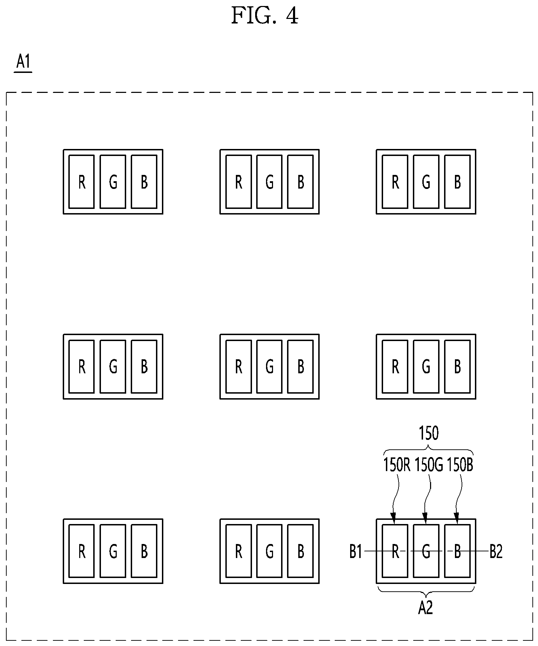

FIG. 4 is an enlarged view of a first panel region in the display device of FIG. 3.

Referring to FIG. 4, a display device 100 of the embodiment can be manufactured by mechanically and electrically connecting a plurality of panel regions such as the first panel region A1 by tiling.

The first panel region A1 can include a plurality of light emitting devices 150 disposed for each unit pixel (PX in FIG. 2).

For example, the unit pixel PX can include a first sub-pixel PX1, a second sub-pixel PX2, and a third sub-pixel PX3. For example, a plurality of red light emitting devices 150R can be disposed on the first sub-pixel PX1, a plurality of green light emitting devices 150G can be disposed on the second sub-pixel PX2, and a plurality of blue light emitting devices 150B can be disposed on the third sub-pixel PX3. The unit pixel PX can further include a fourth sub-pixel in which no light emitting device is disposed, but is not limited thereto.

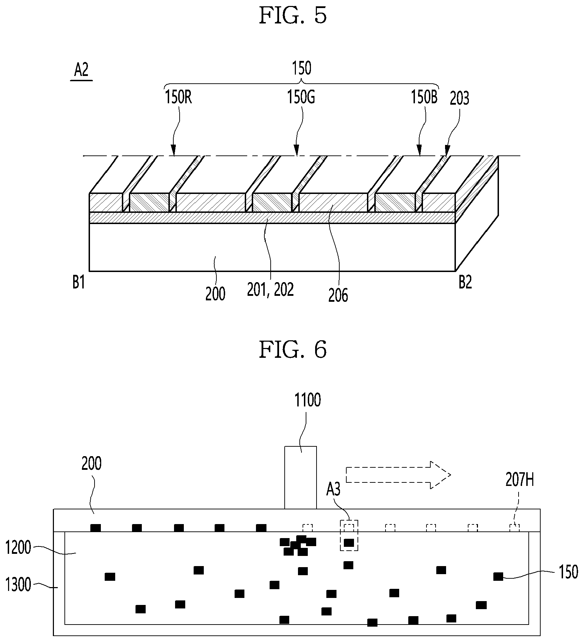

FIG. 5 is an enlarged view of the area A2 of FIG. 4.

Referring to FIG. 5, a display device 100 according to an embodiment can comprise a substrate 200, assembling wirings 201 and 202, an insulating layer 206, and a plurality of semiconductor light emitting devices 150. More components can be included in the display device 100.

The assembling wiring can comprise a first assembling wiring 201 and a second assembling wiring 202 spaced apart from each other. The first assembling wiring 201 and the second assembling wiring 202 can be provided to generate a dielectrophoretic (DEP) force so that the semiconductor light emitting device 150 can be assembled. For example, the semiconductor light emitting device 150 can be one of a lateral type semiconductor light emitting device, a flip-chip type semiconductor light emitting device, and a vertical type semiconductor light emitting device.

The semiconductor light emitting device 150 can comprise a red semiconductor light emitting device 150R, a green semiconductor light emitting device 150G, and a blue semiconductor light emitting device 150B to form a sub-pixel, but is not limited thereto. In other words, red and green can be implemented by providing a red phosphor and a green phosphor.

The substrate 200 can be a support member for supporting components disposed on the substrate 200 or a protective member for protecting the components.

The substrate 200 can be a rigid substrate or a flexible substrate. The substrate 200 can be formed of sapphire, glass, silicon or polyimide. In addition, the substrate 200 can comprise a flexible material such as polyethylene naphthalate (PEN) or polyethylene terephthalate (PET). In addition, the substrate 200 can be a transparent material, but is not limited thereto. The substrate 200 can function as a support substrate in a display panel, and can also function as a substrate for assembly when self-assembling a light emitting device.

The substrate 200 can be a backplane provided with circuits in the sub-pixels PX1, PX2, and PX3 shown in FIGS. 2 and 3, for example, transistors ST and DT, a capacitor Cst, signal wirings, etc., but not limited thereto.

The insulating layer 206 can comprise an insulating and flexible organic material such as polyimide, PAC, PEN, PET, polymer, etc. The insulating layer 206 can comprise an inorganic material such as silicon oxide SiO₂ or silicon nitride series SiNx. The insulating layer 206 can be integrally formed with the substrate 200 to form one substrate.

The insulating layer 206 can be a conductive adhesive layer having adhesiveness and conductivity. The conductive adhesive layer can have ductility to enable a flexible function of the display device. For example, the insulating layer 206 can be an anisotropic conductive film (ACF). For example, the insulating layer 206 can a conductive adhesive layer such as an anisotropic conductive medium or a solution containing conductive particles. The conductive adhesive layer can be a layer that is electrically conductive in a direction perpendicular to the thickness but electrically insulating in a direction horizontal to the thickness.

The insulating layer 206 can comprise an assembly hole 203 into which the semiconductor light emitting device 150 is inserted. Therefore, during self-assembly, the semiconductor light emitting device 150 can be easily inserted into the assembly hole 203 of the insulating layer 206. The assembly hole 203 can be called an insertion hole, a fixing hole, an alignment hole, or the like.

The assembly hole 203 can be called a hole, dent, groove, recess, pocket, etc.

The assembly hole 203 can be different according to the shape of the semiconductor light emitting device 150. For example, each of a red semiconductor light emitting device, a green semiconductor light emitting device, and a blue semiconductor light emitting device can have a different shape, and the assembly hole 203 having a shape corresponding to the shape of each of these semiconductor light emitting devices can be provided. For example, the assembly hole 203 can comprise a first assembly hole for assembling the red semiconductor light emitting device, a second assembly hole for assembling the green semiconductor light emitting device, and a third assembly hole for assembling the blue semiconductor light emitting device. For example, the red semiconductor light emitting device has a circular shape, the green semiconductor light emitting device has a first elliptical shape having a first minor axis and a second major axis, and the blue semiconductor light emitting device has a second elliptical shape having a second minor axis and a second major axis, but is not limited thereto. The second major axis of the elliptical shape of the blue semiconductor light emitting device can be larger than the second major axis of the elliptical shape of the green semiconductor light emitting device, and the second minor axis of the elliptical shape of the blue semiconductor light emitting device can be smaller than the first minor axis of the elliptical shape of the green semiconductor light emitting device.

Meanwhile, a method of mounting the semiconductor light emitting device 150 on the substrate 200 can comprise, for example, a self-assembly method (FIG. 6) and a transfer method.

FIG. 6 is a view showing an example in which a light emitting device according to an embodiment is assembled to a substrate by a self-assembly method.

An example of assembling a semiconductor light emitting device according to the embodiment to a display panel by a self-assembly method using an electromagnetic field will be described based on FIG. 6.

The assembling substrate 200 described below can also function as a panel substrate 200a in the display device after assembling the light emitting device, but the embodiment is not limited thereto.

Referring to FIG. 6, the semiconductor light emitting device 150 can be put into a chamber 1300 filled with a fluid 1200, and the semiconductor light emitting device 150 can move to the assembling substrate 200 by the magnetic field generated from an assembly device 1100. At this time, the light emitting device 150 adjacent to the assembly hole 207H of the assembling substrate 200 can be assembled into the assembly hole 207H by a DEP force generated by the electric field of the assembling wirings. The fluid 1200 can be water such as a deionized water, but is not limited thereto. The chamber 1300 can also be called a water bath, container, vessel, etc.

After the semiconductor light emitting device 150 is put into the chamber 1300, the assembling substrate 200 can be disposed on the chamber 1300. According to the embodiment, the assembling substrate 200 can be put into the chamber 1300.

The semiconductor light emitting device 150 can comprise a magnetic layer (not shown) having a magnetic material. The magnetic layer can comprise a metal having magnetism, such as nickel (Ni). Since the semiconductor light emitting device 150 injected into the fluid can comprise a magnetic layer, it can move to the assembling substrate 200 by a magnetic field generated from the assembly device 1100. The magnetic layer can be disposed on an upper side, an lower side or both sides of the light emitting device.

The semiconductor light emitting device 150 can comprise a passivation layer surrounding an upper surface and side surfaces thereof. The passivation layer can be formed of an inorganic insulator such as silica or alumina through PECVD, LPCVD, sputtering deposition, or the like. In addition, the passivation layer can be formed of an organic material such as photoresist or a polymer material through spin-coating.

The semiconductor light emitting device 150 can comprise a first conductivity type semiconductor layer, a second conductivity type semiconductor layer, and an active layer disposed therebetween. The first conductivity type semiconductor layer can be an n-type semiconductor layer, and the second conductivity type semiconductor layer can be a p-type semiconductor layer, but are not limited thereto. The first conductivity type semiconductor layer, the second conductivity type semiconductor layer, and the active layer disposed therebetween can constitute a light emitting structure 152. The light emitting structure 152 can be called a light emitting layer, a light emitting portion, or the like.

A first electrode (layer) can be disposed below the first conductivity type semiconductor layer, and a second electrode (layer) can be disposed on the second conductivity type semiconductor layer. To this end, a portion of the first conductivity type semiconductor layer or the second conductivity type semiconductor layer can be exposed to the outside. Accordingly, in the manufacturing process of the display device after the semiconductor light emitting device 150 is assembled to the assembling substrate 200, a portion of the passivation layer can be etched.

The first electrode can comprise at least one or more layers. For example, the first electrode can comprise an ohmic layer, a reflective layer, a magnetic layer, a conductive layer, an anti-oxidation layer, an adhesive layer, etc. The ohmic layer can comprise Au, AuBe, etc. The reflective layer can comprise Al, Ag, etc. The magnetic layer can comprise Ni, Co, etc. The conductive layer can comprise Cu, etc. The anti-oxidation layer can comprise Mo, etc. The adhesive layer can comprise Cr, Ti, etc.

The second electrode can comprise a transparent conductive layer. For example, the second electrode can comprise ITO, IZO, etc.

The assembling substrate 200 can comprise a pair of first and second assembling wirings 201 and 202 corresponding to each of the semiconductor light emitting devices 150 to be assembled. Each of the first assembling wiring 201 and the second assembling wiring 202 can be formed by multiple stacking of a single metal or metal alloy, metal oxide, etc. For example, each of the first assembling wiring 201 and the second assembling wiring 202 can be formed of at least one or more of Cu, Ag, Ni, Cr, Ti, Al, Rh, Pd, Ir, Ru, Mg, Zn, Pt, Au, Hf, etc., but is not limited thereto.

An electric field can form an electric field in response to the application of an AC voltage, and the semiconductor light emitting device 150 injected into the assembly hole 207H can be fixed by the DEP force caused by the electric field. The distance between the first assembling wiring 201 and the second assembling wiring 202 can be smaller than the width of the semiconductor light emitting device 150 or the width of the assembly hole 207H. Accordingly, the assembly position of the semiconductor light emitting device 150 using the electric field can be more accurately fixed.

An insulating layer can be formed on the first assembling wiring 201 and the second assembling wiring 202. Accordingly, the first assembling wiring 201 and the second assembling wiring 202 are protected from the fluid 1200, and leakage of current flowing through the first assembling wiring 201 and the second assembling wiring 202 can be prevented. For example, the insulating layer can be formed of a single layer or multiple layers of an inorganic insulator such as silica or alumina or an organic insulator. The insulating layer can have a minimum thickness to prevent damage to the first assembling wiring 201 and the second assembling wiring 202 when the semiconductor light emitting device 150 is assembled. The insulating layer can have a maximum thickness for stably assembling the semiconductor light emitting device 150.

A barrier rib can be formed on an upper side of the insulating layer. The barrier rib can be the insulating layer 206 shown in FIG. 5, but is not limited thereto. A portion of the barrier rib can be positioned on an upper side of the first assembling wiring 201 and the second assembling wiring 202, and the remaining portion can be positioned on an upper side of the assembling substrate 200.

Meanwhile, when the assembling substrate 200 is manufactured, a part of the barrier ribs formed on an upper side of the insulating layer can be removed. Thus, the assembly hole 207H through which each of the semiconductor light emitting devices 150 is coupled and assembled to the assembling substrate 200 can be formed.

The assembly hole 207H to which the semiconductor light emitting devices 150 are coupled is formed in the assembling substrate 200, and a surface on which the assembly hole 207H is formed can contact the fluid 1200. The assembly hole 207H can guide an accurate assembly position of the semiconductor light emitting device 150.

Meanwhile, the assembly hole 207H can have a shape and size corresponding to the shape of the semiconductor light emitting device 150 to be assembled at a corresponding position. Accordingly, it is possible to prevent assembly of other semiconductor light emitting devices or assembly of a plurality of semiconductor light emitting devices into the assembly hole 207H.

Referring back to FIG. 6, after the assembling substrate 200 is disposed in the chamber, the assembly device 1100 applying a magnetic field can move along the assembling substrate 200. The assembly device 1100 can be a permanent magnet or an electromagnet.

The assembly device 1100 can move while in contact with the assembling substrate 200 in order to maximize a region of influence of the magnetic field into the fluid 1200. According to the embodiment, the assembly device 1100 can comprise a plurality of magnetic bodies or can comprise a magnetic body having a size corresponding to that of the assembling substrate 200. In this case, the moving distance of the assembling device 1100 can be limited within a predetermined range.

The semiconductor light emitting device 150 in the chamber 1300 can move toward the assembly device 1100 and the assembling substrate 200 by the magnetic field generated by the assembly device 1100.

The semiconductor light emitting device 150 can enter into the assembly hole 207H and be fixed by a DEP force while moving toward the assembly device 1100. The DEP force can be formed by an electric field between the assembling wirings 201 and 202.

Specifically, the first and second assembling wirings 201 and 202 can form an electric field by AC power, and a DEP force can be formed between the assembling wirings 201 and 202 by the electric field. The semiconductor light emitting device 150 can be fixed to the assembly hole 207H on the assembling substrate 200 by the DEP force.

At this time, a predetermined solder layer (not shown) can be formed between the light emitting device 150 assembled on the assembly hole 207H of the assembling substrate 200 and the assembling wirings 201 and 202 to improve the bonding strength of the light emitting device 150.

Also, after assembly, a molding layer (not shown) can be formed in the assembly hole 207H of the assembling substrate 200. The molding layer can be a transparent resin or a resin containing a reflective material or a scattering material.

Since the self-assembly method using the above-described electric/magnetic field can drastically reduce the time required to assemble each of the semiconductor light emitting devices to the substrate, a large-area high-pixel display can be implemented more quickly and economically.

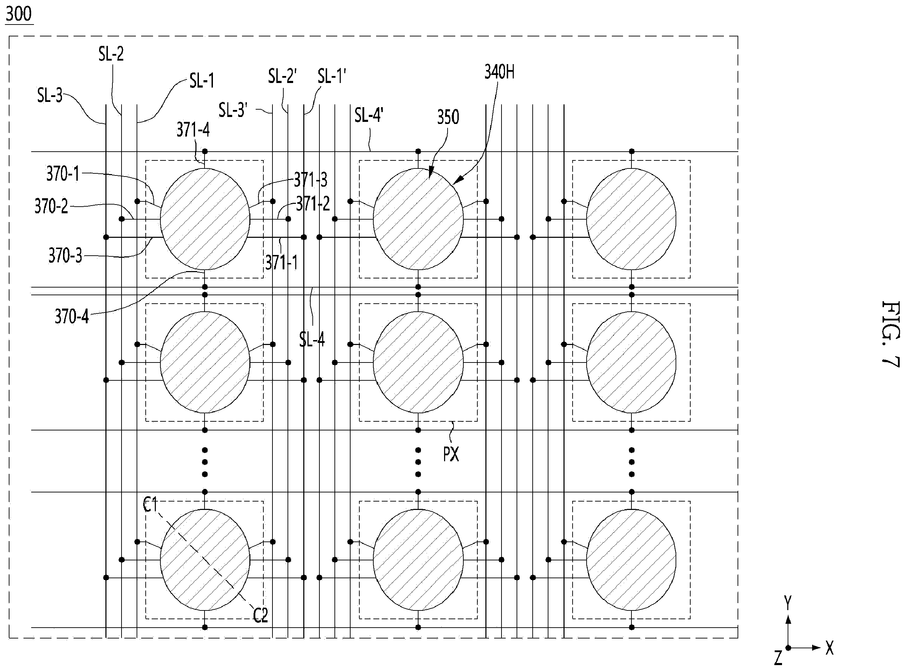

Hereinafter, various embodiments for solving the above problems will be described with reference to FIGS. 7 to 38. The missing descriptions below can be readily understood from the descriptions given above with respect to FIGS. 1 to 6 and the corresponding drawings.

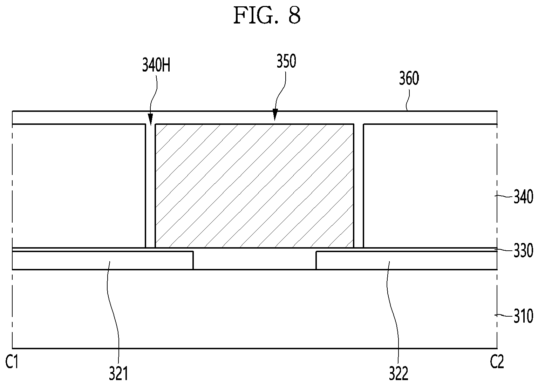

FIG. 7 is a circuit diagram illustrating a display device according to an embodiment. FIG. 8 is a cross-sectional view taken along the line C1-C2 in the display device according to the embodiment of FIG. 7.

Referring to FIGS. 7 and 8, the display device 300 according to an embodiment can comprise a plurality of semiconductor light emitting device packages 350. The plurality of semiconductor light emitting device packages 350 can be disposed in each of a plurality of pixels PX. As will be described later, the semiconductor light emitting device package 350 can comprise a plurality of semiconductor light emitting devices (351-1 to 351-3 in FIG. 9) for displaying an image. The semiconductor light emitting device package 350 can be obtained by packaging a plurality of semiconductor light emitting devices 351-1 to 351-3.

As shown in FIG. 8, each of the plurality of pixels PX can comprise a substrate 310, a first assembling wiring 321, a second assembling wiring 322, a first insulating layer 330, a barrier rib 340, a semiconductor light emitting device package 350 and a second insulating layer 360. According to the embodiment, at least one semiconductor light emitting device package 350 can be provided in one pixel PX.

In an embodiment, the plurality of semiconductor light emitting device packages 350 can be assembled into the plurality of assembly holes 340H of each of the plurality of pixels PX using a self-assembly method.

To this end, a first assembling wiring 321 and a second assembling wiring 322 can be provided. The semiconductor light emitting device package 350 can be assembled into the assembly hole 340H of each of the plurality of pixels PX by the DEP force formed by the first assembling wiring 321 and the second assembling wiring 322.

In the drawings, the first assembling wiring 321 and the second assembling wiring 322 are shown as being disposed on the same layer, but can be disposed on different layers.

The first insulating layer 330 can be disposed on the first assembling wiring 321 and the second assembling wiring 322. The first insulating layer 330 can insulate the first assembling wiring 321 and the second assembling wiring 322. The first insulating layer 330 can prevent the first assembling wiring 321 and the second assembling wiring 322 from being corroded by fluid during self-assembly.

The barrier rib 340 can be disposed on the first insulating layer 330. The barrier rib 340 can be provided to form the plurality of assembly holes 340H. That is, by removing the barrier rib 340 corresponding to each of the plurality of pixels PX in the barrier rib 340, the assembly hole 340H can be formed in each of the plurality of pixels PX. The bottom portion of the assembly hole 340H can be a part of an upper surface of the first insulating layer 330. That is, A part of the upper surface of the first insulating layer 330 can be exposed through the assembly hole 340H.

For example, the shape of the assembly hole 340H can correspond to the shape of the light emitting device package 350. When the semiconductor light emitting device package 350 has an elliptical shape, the assembly hole 340H can also have an elliptical shape. In the embodiment, since the light emitting device package 350 has an elliptical shape when viewed from the top, the assembly hole 340H can also have an elliptical shape. For example, the size of the assembly hole 340H can be larger than the size of the light emitting device package 350. That is, when the light emitting device package 350 is inserted into the assembly hole 340H, an outer surface of the light emitting device package 350 is spaced apart from an inner surface of the assembly hole 340H so that the semiconductor light emitting device package 350 can be easily inserted into the assembly hole 340H.

According to the embodiment, since the light emitting device package 350 and the assembly hole 340H have an elliptical shape, when the light emitting device package 350 is assembled into the assembly hole 340H, the light emitting device package 350 can be not rotated by the elliptical shape of the assembly hole 340H and can maintain the current-assembled state so that the fixing force of the light emitting device package 350 can be strengthened.

The second insulating layer 360 can be disposed on the barrier rib 340. The second insulating layer 360 can be disposed on the semiconductor light emitting device package 350. That is, the second insulating layer 360 can cover the semiconductor light emitting device package 350. The second insulating layer 360 can be a planarization layer having a horizontal top surface.

Although not shown, a black matrix can be disposed between the pixels PX to distinguish between them. The black matrix can be disposed on the barrier rib 340 except for the assembly hole 340H between the barrier rib 340 and the second insulating layer 360, but is not limited thereto.

Referring back to FIG. 7, the display device 300 according to the embodiment can comprise a plurality of first signal lines SL-1 to SL-4 and a plurality of second signal lines SL-1' to SL-4'.

The plurality of first signal lines SL-1 to SL-4 and the plurality of second signal lines SL-1' to SL-4' can be disposed around the assembly hole 340H or the semiconductor light emitting device package 350.

The plurality of first signal lines can comprise a first-first signal line SL-1, a first-second signal line SL-2, a first-third signal line SL-3 and a first-fourth signal line SL-4. The plurality of second signal lines can comprise a second-first signal line SL-1', a second-second signal line SL-2', a second-third signal line SL-3', and a second-fourth signal line SL-4'.

For example, the first-first signal line SL-1, the first-second signal line SL-2, and the first-third signal line SL-3 are disposed along a second direction Y, and the first-fourth signal line SL-4 can be disposed along a first direction X. Therefore, each of the first-first signal line SL-1, the first-second signal line SL-2, and the first-third signal line SL-3 can intersect with the first-fourth signal line SL-4. Since each of the first-first signal line SL-1, the first-second signal line SL-2, and the first-third signal line SL-3 can be different from the first-fourth signal line SL-4, they can prevent an electrical short with the first-fourth signal line SL-4.

For example, the second-first signal line SL-1', the second-second signal line SL-2', and the second-third signal line SL-3' can be disposed along the second direction Y, and the second-fourth signal line SL-4' can be disposed along the first direction X. Therefore, each of the second-first signal line SL-1', the second-second signal line SL-2', and the second-third signal line SL-3' can intersect with the second-fourth signal line SL-4'. Since each of the second-first signal line SL-1', the second-second signal line SL-2', and the second-third signal line SL-3' can be different from the first-fourth signal line SL-4', they can prevent an electrical short with the first-fourth signal line SL-4'.

Although not shown in the drawing, some signal lines among the plurality of first signal lines SL-1 to SL-4 and some signal lines among the plurality of second signal lines SL-1' to SL-4' can be electrically connected to each of the plurality of semiconductor light emitting devices 351-1 to 351-3 of the semiconductor light emitting device package 350. Other signal lines among the plurality of first signal lines SL-1 to SL-4 and other signal lines among the plurality of second signal lines SL-1' to SL-4' cannot be electrically connected to each of the plurality of semiconductor light emitting devices 351-1 to 351-3 of the semiconductor light emitting device package 350.

Among the plurality of first signal lines SL-1 to SL-4, the first-first signal line SL-1, the first-second signal line SL-2 and the first-third signal line SL-3 can be connected to the first data line D1, the second data line D2, and the third data line D3 via the scan transistor ST and the driving transistor DT shown in FIGS. 2 and 3, respectively.

For example, each of the first data line D1, the second data line D2, and the third data line D3 can be connected to a gate terminal of the driving transistor DT through the scan transistor ST. For example, one side of each of the first-first signal line SL-1, the first-second signal line SL-2 and the first-third signal line SL-3 can be connected to a source terminal of the driving transistor DT. For example, the high potential voltage line VDDL supplying the high potential voltage VDD can be connected to a drain terminal of the driving transistor DT. Meanwhile, the other side of each of the first-first signal line SL-1, the first-second signal line SL-2 and the first-third signal line SL-3 can be connected to each of the plurality of semiconductor light emitting devices 351-1 to 351-3 the semiconductor light emitting device packages 350.

In this case, a current corresponding to each of the first data line D1, the second data line D2, and the third data line D3 can flow in the driving transistor DT, and the current can flow into the plurality of semiconductor light emitting devices 351-1 to 351 of the semiconductor light emitting device package 350 through each of the first-second signal line SL-2 and first-third signal line SL-3 through each of the first-first signal line SL-1, the first-second signal line SL-2 and the first-third signal line SL-3 to emit light corresponding to the current.

The fourth signal lines SL-4 and SL-4' can be connected to the common electrode wiring 352 disposed on an lower side of each of the first semiconductor light emitting device 351-1, the second semiconductor light emitting device 351-2, and the third semiconductor light emitting device 351-3. In addition, the fourth signal lines SL-4 and SL-4' can be connected to the low potential voltage line VSSL. Accordingly, the low potential voltage (VSS in FIG. 6) can be supplied to each of the light emitting device 351-1, the second semiconductor light emitting device 351-2, and the third semiconductor light emitting device 351-1 via the low potential voltage line VSSL, the fourth signal lines SL-4 and SL-4', and the common electrode wiring 352.

For example, each of the first-first signal line SL-1, the first-second signal line SL-2, the first-third signal line SL-3 or each of the second-first signal line SL-1', the second-second signal line SL-2', and the second-third signal line SL-3' can be individually connected to each of the plurality of semiconductor light emitting devices 351-1 to 351-3 of the semiconductor light emitting device package 350. For example, the first-fourth signal line SL-4 or the second-fourth signal line SL-4' can be commonly connected to the plurality of semiconductor light emitting devices 351-1 to 351-3 of the semiconductor light emitting device package 350.

Meanwhile, the display device 300 according to the embodiment can comprise a plurality of first connection lines 370-1 to 370-4 and a plurality of second connection lines 371-1 to 371-4. The plurality of first connection lines 370-1 to 370-4 can connect the plurality of first signal lines SL-1 to SL-4 to the plurality of semiconductor light emitting devices 351-1 to 351-3 of the semiconductor light emitting device packages 350 of each of the plurality of pixels PX. The plurality of second connection lines 371-1 to 371-4 can connect the plurality of second signal lines SL-1' to SL-4' to the plurality of semiconductor light emitting devices 351-1 to 351-3 of the semiconductor light emitting device package 350 each of the plurality of pixels PX.

The plurality of first connection lines can include a 1-1 connection line 370-1, a 1-2 connection line 370-2, a 1-3 connection line 370-3 and a 1-4 connection line 370-4. The plurality of second connection lines can include a 2-1 connection line 371-1, a 2-2 connection line 371-2, a 2-3 connection line 371-3 and a 2-4 connection line 371-4.

The plurality of connection lines 370-1, 370-2, 370-3, and 370-4 can be formed after the plurality of semiconductor light emitting device packages 350 are assembled into the assembly holes 340H of the plurality of pixels PX on the substrate 310.

Meanwhile, the light emitting device package 350 can comprise a plurality of semiconductor light emitting devices 351-1 to 351-3 capable of generating a plurality of different color lights. A color image can be displayed by the plurality of color lights. A plurality of semiconductor light emitting device packages 350 can be respectively disposed on a plurality of pixels PX.

Hereinafter, the semiconductor light emitting device package 350 according to various embodiments will be described.

### [Semiconductor light emitting device package]

### <First embodiment>

FIG. 9 is a plan view illustrating a semiconductor light emitting device package according to a first embodiment. FIG. 10 is a cross-sectional view taken along the lines D1-D2 and E1-E2 in the semiconductor light emitting device package according to the first embodiment of FIG. 9.

FIGS. 9 and 10, the semiconductor light emitting device package 350 according to the first embodiment can comprise a first layer 3510, a common electrode wiring 352, and a plurality of semiconductor light emitting devices 351-1 to 351-3, a plurality of electrode pads 353-1 to 353-3, 354-1, and 354-2, a plurality of electrode wirings 355-1 to 355-3, and a second layer 3520. The semiconductor light emitting device package 350 according to the first embodiment can comprise more components than these.

The first layer 3510 can be a support member supporting components disposed thereon. The first layer 3510 can be an insulating member. The first layer 3510 can be a rigid member or a flexible member.

The first layer 3510 can have an elliptical shape. The elliptical shape of the first layer 3510 can have a minor axis and a major axis. The length of the major axis can be greater than the length of the minor axis. The length of the major axis can be the largest and the length of the minor axis can be the smallest.

The first layer 3510 can have a first region 311 and a second region 312.

The first region 311 can be located at the center of the first layer 3510. The first region 311 can be located long along the major axis direction. The size of the first region 311 can be greater than that of the common electrode wiring 352 to be described later.

The second region 312 can surround the first region 311. The second region 312 can have the same width along the circumference of the first region 311 from the side of the first layer 3510 to the first region 311, but is not limited thereto.

The second region 312 can comprise a second-first region 312-1, a second-second region 312-2, a second-third region 312-3 and a second-fourth region 312-4.

The second-first region 312 -1 and the second-second region 312 - 2 can be located on both sides of the first region 311 along the minor axis direction of the elliptical shape of the first layer 3510. The second-third region 312 - 3 and the second-fourth region 312 - 4 can be located on both sides of the first region 311 along the major axis direction of the elliptical shape of the first layer 3510. For example, the second-first region 312-1 can be located on a first side of the first region 311 along the minor axis direction of the elliptical shape of the first layer 3510. For example, the second-second region 312-2 can be located on a second side of the first region 311 along the minor axis direction of the elliptical shape of the first layer 3510. For example, the second-third region 312-3 is located on a third side of the first region 311 along the major axis direction of the elliptical shape of the first layer 3510, and the second-fourth region 312-4 can be located on a fourth side of the first region 311 along the major axis direction of the elliptical shape of the first layer 3510.

The second-first region 312-1 has a first round-shape side surface 312-1a on its outer side, and the second-second region 312-2 has a second round-shape side surface 312-2a on its outer side. The second-third region 312-3 has a third round-shape side surface 313-3a on its outer side, and the second-fourth region 312-4 has a fourth round-shape side surface 312-4a on its outer side.

The curvature of the first round-shape side surface 312-1a and the curvature of the second round-shape side surface 312-2a can be the same, but are not limited thereto. The curvature of the third round-shape side surface 313-3a and the curvature of the fourth round-shape side surface 312-4a can be the same, but are not limited thereto. The curvature of the third round-shape side surface 313-3a can be greater than the curvature of the first round-shape side surface 312-1a or the curvature of the second round-shape side surface 312-2a, but is not limited thereto. The curvature of the fourth round-shape side surface 313-4a can be greater than the curvature of the first round-shape side surface 312-1a or the curvature of the second round-shape side surface 312-2a, but is not limited thereto.

The common electrode wiring 352 can be disposed on the first layer 3510. The common electrode wiring 352 can be disposed on the first region 311 of the first layer 3510. The common electrode wiring 352 can disposed long along one direction, that is, the second direction Y.

The common electrode wiring 352 can comprise an electrode layer having excellent electrical conductivity. Accordingly, current loss of each of the plurality of semiconductor light emitting devices 351-1 to 351-3 can be minimized.

The common electrode wiring 352 can comprise a magnetic layer having a high magnetic susceptibility. Accordingly, since the magnetic layer of the common electrode wiring 352 is easily and greatly magnetized by the magnet during self-assembly, the semiconductor light emitting device package 350 can be easily moved along the movement or movement direction of the magnet so that the assembly speed can be high and the assembly rate can be improved.

The common electrode wiring 352 can comprise a reflective layer having excellent reflectivity. For example, the reflective layer can contact a lower side of each of the plurality of semiconductor light emitting devices 351-1 to 351-3. Accordingly, the light luminance can be improved by reflecting light from each of the plurality of semiconductor light emitting devices 351-1 to 351-3 in a specific direction.

The plurality of semiconductor light emitting devices 351-1 to 351-3 can be disposed on the first layer 3510. The plurality of semiconductor light emitting devices 3251 - 1 to 351-3 can be positioned on the first region 311 of the first layer 3510. The plurality of semiconductor light emitting devices 351-1 to 351-3 can be disposed on the common electrode wiring 352.

The plurality of semiconductor light emitting devices 351-1 to 351-3 can be commonly connected to the common electrode wiring 352. The lower side of each of the plurality of semiconductor light emitting devices 351-1 to 351-3 can be commonly connected to the common electrode wiring 352.

The plurality of semiconductor light emitting devices can comprise a first semiconductor light emitting device 351-1, a second semiconductor light emitting device 351-2, and a third semiconductor light emitting device 351-3 to display a color image. The first semiconductor light emitting device 351-1, the second semiconductor light emitting device 351-2, and the third semiconductor light emitting device 351-3 are arranged in a line along the major axis direction of an elliptical shape of the first layer 3510, but is not limited thereto.

For example, the first semiconductor light emitting device 351-1 can be a blue semiconductor light emitting device emitting blue light, the second semiconductor light emitting device 351-2 can be a red semiconductor light emitting device emitting red light, and the third semiconductor light emitting device 351-3 can be a green semiconductor light emitting device emitting green light, but are not limited thereto.

The plurality of electrode pads 353 - 1 to 353 - 3, 354 - 1, and 354 - 2 can be disposed on the first layer 3510. The plurality of electrode pads 353-1 to 353-3, 354-1, and 354-2 can be disposed on the second region 312 of the first layer 3510.

The plurality of electrode pads can comprise a first electrode pad 353-1, a second electrode pad 353-2, a third electrode pad 353-3, and at least one or more common electrode pads 354-1 and 354-2.

For example, each of the first electrode pad 353-1, the second electrode pad 353-2, and the third electrode pad 353-3 are positioned on the minor axis of the elliptical shape of the first layer 3510, and the at least one or more common electrode pads 354-1 and 354-2 can be positioned on the major axis of the elliptical shape of the first layer 3510.

For example, two electrode pads among the first electrode pad 353-1, the second electrode pad 353-2, and the third electrode pad 353-3 can be disposed on one region of the second-first region 312-1 and the second-second region 312-2. For example, one electrode pad among the first electrode pad 353-1, the second electrode pad 353-2, and the third electrode pad 353-3 can be disposed on another region of the second-first region 312-1 and the second-second region 312-2. For example, as shown in FIG. 9, the first electrode pad 353-1 and the third electrode pad 353-3 can be disposed on the second-first region 312-1. For example, the second electrode pad 353-2 can be disposed on the second-second region 312-2. Although not shown, the first electrode pad 353-1 and the third electrode pad 353-3 can be disposed on the second-second region 312-2, and the second electrode pad 353-2 can be disposed on the second-first region 312-1.

For example, the first electrode pad 353-1 can be connected to the upper side of the first semiconductor light emitting device 351-1, the second electrode pad 353-2 can be connected to the upper side of the second semiconductor light emitting device 351-2, and the third electrode pad 353-3 can be connected to the upper side of the third semiconductor light emitting device 351-3.

As described above, the lower side of the first semiconductor light emitting device 351-1, the lower side of the second semiconductor light emitting device 351-2, and the lower side of the third semiconductor light emitting device 351-3 can be commonly connected to the common electrode wiring 352. The common electrode wiring 352 can be connected to at least one or more common electrode pads 354-1 and 354-2. Accordingly, the at least one or more common electrode pads 354-1 and 354-2 can be connected to the lower side of the first semiconductor light emitting device 351-1, the lower side of the second semiconductor light emitting device 351-2, and the lower side of the third semiconductor light emitting device 351-3 through the common electrode wiring 352.

A portion of the at least one or more common electrode wiring 352 can extend from the first region 311 of the first layer 3510 to the second-third region 312-3 and/or the second-fourth region 312-4 of the second region 312. Since the at least one or more common electrode pads 354-1 and 354-2 can be disposed on the second-third region 312-3 and/or the second-fourth region of the second region 312, the at least one or more common electrode pads 354-1 and 354-2 in the second-third region 312-3 and/or the second-fourth region 312-4 of the second region 312 can vertically overlap the common electrode wiring 352.

Meanwhile, each of the first electrode pad 353-1, the second electrode pad 353-2, and the third electrode pad 353-3 can comprise lower contact electrodes 353-1a, 353-2a, and 353-3a, and upper contact electrodes 353-1b, 353-2b, and 353-3b.

The upper contact electrodes 353-1b, 353-2b, and 353-3b can vertically overlap the lower contact electrodes 353-1a, 353-2a, and 353-3a, respectively. For example, the upper contact electrodes 353-1b, 353-2b, and 353-3b can be connected to the lower contact electrodes 353-1a, 353-2a, and 353-3a through contact holes, respectively. For example, the lower contact electrodes 353-1a, 353-2a, and 353-3a can be disposed on the same layer as the common electrode pads 354-1 and 354-2.

The plurality of electrode wirings 355-1 to 355-3 can be disposed on the plurality of semiconductor light emitting devices 351-1 to 351-3, respectively. Each of the plurality of electrode wirings 355-1 to 355-3 can be connected to the upper side of each of the plurality of semiconductor light emitting devices 351-1 to 351-3.

The plurality of electrode wirings can comprise a first electrode wiring 355-1, a second electrode wiring 355-2, and a third electrode wiring 355-3. The first electrode wiring 355-1 can connect an upper side of the first electrode pad 353-1 and an upper side of the first semiconductor light emitting device 351-1. The second electrode wiring 355-2 can connect an upper side of the second electrode pad 353-2 and an upper side of the second semiconductor light emitting device 351-2. The third electrode wiring 355-3 can connect an upper side of the third electrode pad 353-3 and an upper side of the third semiconductor light emitting device 351-3.

One side of the first electrode wiring 355-1 can vertically overlap the first semiconductor light emitting device 351-1, and the other side of the first electrode wiring 355-1 can vertically overlap the first electrode pad 353-1. One side of the second electrode wiring 355-2 can vertically overlap the second semiconductor light emitting device 351-2, and the other side of the second electrode wiring 355-2 can vertically overlap the second electrode pad 353-2. One side of the third electrode wiring 355-3 can vertically overlap the third semiconductor light emitting device 351-3, and the other side of the third electrode wiring 355-3 vertically overlap the third electrode pad 353-3.

Each of the first electrode wiring 355-1, the second electrode wiring 355-2, and the third electrode wiring 355-3 can be a transparent electrode. Each of the first electrode wiring 355-1, the second electrode wiring 355-2, and the third electrode wiring 355-3 can be made of a transparent conductive material such as ITO. Accordingly, light emitted from each of the plurality of semiconductor light emitting devices 351-1 to 351-3 can pass through the first electrode wiring 355-1, the second electrode wiring 355-2, and the third electrode wiring 355-3 and travel forward. Therefore, since the first electrode wiring 355-1, the second electrode wiring 355-2, and the third electrode wiring 355-3 do not interfere with the propagation of light, light loss can be reduced and luminance degradation can be prevented.

For example, each of the first electrode wiring 355-1, the second electrode wiring 355-2, and the third electrode wiring 355-3 can be an anode electrode, and the common electrode wiring 352 can be a cathode electrode, but are not limited thereto.

Accordingly, a first current can flow in the order of the first electrode wiring 355-1 → the first semiconductor light emitting device 351-1 → the common electrode wiring 352 so that the first semiconductor light emitting device 351 -1 can emit a first light having a first luminance corresponding to the first current. The first luminance can be changed according to the first current, and the first current can be changed according to a first data voltage supplied through a first data line (not shown).

A second current can flow in the order of the second electrode wiring 355-2 → the second semiconductor light emitting device 351-2 → the common electrode wiring 352, and the second semiconductor light emitting device 351-2 can emit a second light having a second luminance corresponding to the second current. The second luminance can be changed according to the second current, and the second current can be changed according to a second data voltage supplied through a second data line (not shown).

A third current can flow in the order of the third electrode wiring 355-3 → the third semiconductor light emitting device 351-3 → the common electrode wiring 352, and the third semiconductor light emitting device 351-3 can emit a third light having a third luminance corresponding to the third current. The third luminance can be changed according to the third current, and the third current can be changed according to a third data voltage supplied through a third data line (not shown).

Accordingly, a color image can be displayed by the first light, the second light, and the third light, and a gradation can be implemented by the first luminance, the second luminance, and/or the third luminance.

Meanwhile, the second layer 3520 can be disposed on the first layer 3510. The second layer 3520 can be disposed on the plurality of semiconductor light emitting devices 351-1 to 351-3. The second layer 3520 can be disposed on the plurality of electrode wirings 355-1 to 355-3. The second layer 3520 can be disposed on the plurality of electrode pads 353-1 to 353-3, 354-1, and 354-2.

The second layer 3520 can have a shape corresponding to a shape of the first layer 3510. The second layer 3520 can have the same shape as a shape of the first layer 3510. For example, the second layer 3520 can have an elliptical shape. A side surface of the second layer 3520 can have an inclined surface whose width decreases from the lower side to the upper side, but is not limited thereto.

The second layer 3520 can be a protective layer for protecting components disposed below the second layer 3520. The second layer 3520 can be an insulating member. The second layer 3520 can be a rigid member or a flexible member.

The second layer 3520 can comprise a second-first layer 3521 and a second-second layer 3522. For example, the second-first layer 3521 is disposed below the plurality of electrode wirings 355-1 to 355-3, and the second-second layer 3522 is disposed on the plurality of electrode wirings 355-1 to 355-3. In this case, the upper contact electrodes 353-1b, 353-2b, and 353-3b of each of the plurality of electrode pads 351-3-1 to 353-3 can be electrically connected to the lower contact electrodes via the second-first layer 3521. That is, a plurality of contact holes can be formed in the second-first layer 3521, and the upper contact electrodes 353-1b, 353-2b, and 353-3b of each of the plurality of electrode pads 351-3-1 to 353-3 through the contact holes and the lower contact electrodes 353-1a, 353-2a, and 353-3a through the second-first layer 3521 can be electrically connected to each other.

Meanwhile, unexplained reference numeral 3515 denotes an etch stop layer, and only the second-first layer 3521 can be etched to form a contact hole. The etch stop layer 3515 can be omitted.

Meanwhile, as shown in FIGS. 7 and 8, the semiconductor light emitting device package 350 according to the first embodiment can be assembled into the assembly holes 340H of the plurality of pixels PX on the substrate 310 by a self-assembly process. The plurality of first connection lines 370-1 to 370-4 and the plurality of second connection lines 371-1 to 371-4 can be formed by performing a post-process.

Before the plurality of first connection lines 370-1 to 370-4 and the plurality of second connection lines 371-1 to 371-4 are formed, a process of opening the plurality of electrode pads 353-1 to 353-3, 354-1, and 354-2 2 of the semiconductor light emitting device package 350can be performed. Alternatively, a process of opening the plurality of electrode pads 353-1 to 353-3, 354-1, and 354-2 of the semiconductor light emitting device package 350 can be performed before self-assembly.

The plurality of first connection lines can include a 1-1 connection line 370-1, a 1-2 connection line 370-2, a 1-3 connection line 370-3 and a 1-4 connection line 370-4. The plurality of second connection lines can include a 2-1 connection line 371-1, a 2-2 connection line 371-2, a 2-3 connection line 371-3 and a 2-4 connection line 371-4.

For example, the 1-1 connection line 370-1, the 1-2 connection line 370-2, the 1-3 connection line 370-3 and the 1-4 connection line 370-4 can extend onto the plurality of pixel PX of from the first-first signal line SL-1, the first-second signal line SL-2, the first-third signal line SL-3 and the first-fourth signal line SL-4, respectively. That is, each of the 1-1 connection line 370-1, the 1-2 connection line 370-2, the 1-3 connection line 370-3 and the 1-4 connection line 370-4 can be disposed on the semiconductor light emitting device package 350 of each of the plurality of pixel PX. For example, the 1-1 connection line 370-1, the 1-2 connection line 370-2, the 1-3 connection line 370-3 and the 1-4 connection line 370-4 can be disposed on the plurality of electrode pads 353-1 to 353-3, 354-1, and 354-2 of the semiconductor light emitting device package 350, respectively.

For example, the 2-1 connection line 371-1, the 2-2 connection line 371-2, the 2-3 connection line 371-3, and the 2-4 connection line 371-4 can extend onto the plurality of pixels PX from the second-first signal line SL-1', the second-second signal line SL-2', the second-third signal line SL-3' and the second-fourth signal line SL-4, respectively. That is, each of the 2-1 connection line 371-1, the 2-2 connection line 371-2, the 2-3 connection line 371-3 and the 2-4 connection line 371-4 can be disposed on each semiconductor light emitting device package 350 of the plurality of pixels PX. For example, the 2-1 connection line 371-1, the 2-2 connection line 371-2, the 2-3 connection line 371-3, and the 2-4 connection line 371-4 can be disposed on the plurality of electrode pads 353-1 to 353-3, 354-1, and 354-2 of the semiconductor light emitting device package 350, respectively.

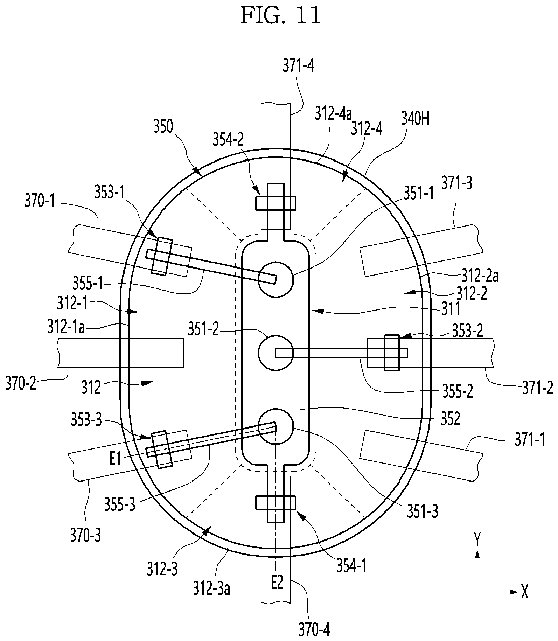

As shown in FIG. 11, the semiconductor light emitting device package 350 can be assembled into the assembly hole 340H in the normal position. In this case, in the semiconductor light emitting device package 350, the first electrode pad 353-1 can be electrically connected to the 1-1 connection line 370-1, and the second electrode pad 353-2 can be electrically connected to the 2-2 connection line 371-2, and the third electrode pad 353-3 can be electrically connected to the 1-3 connection line 370-3. In the semiconductor light emitting device package 350, the common electrode pads 354-1 and 354-2 can be electrically connected to the first-fourth connection line 370-4 and/or the second-fourth connection line 371-4.

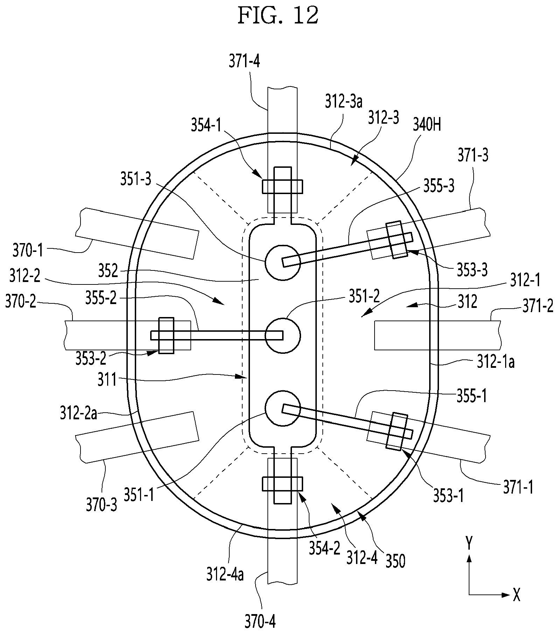

As shown in FIG. 12, the semiconductor light emitting device package 350 can be assembled into the assembly hole 340H while being rotated by 180° relative to the normal position. In this case, in the semiconductor light emitting device package 350, the first electrode pad 353-1 can be electrically connected to the 2-1 connection line 371-1, and the second electrode pad 353-2 can be electrically connected to the 1-2 connection line 370-2, and the third electrode pad 353-3 can be electrically connected to the 2-3 connection line 371-3. In the semiconductor light emitting device package 350, the common electrode pads 354-1 and 354-2 can be electrically connected to the first-fourth connection line 370-4 and/or the second-fourth connection line 371-4.

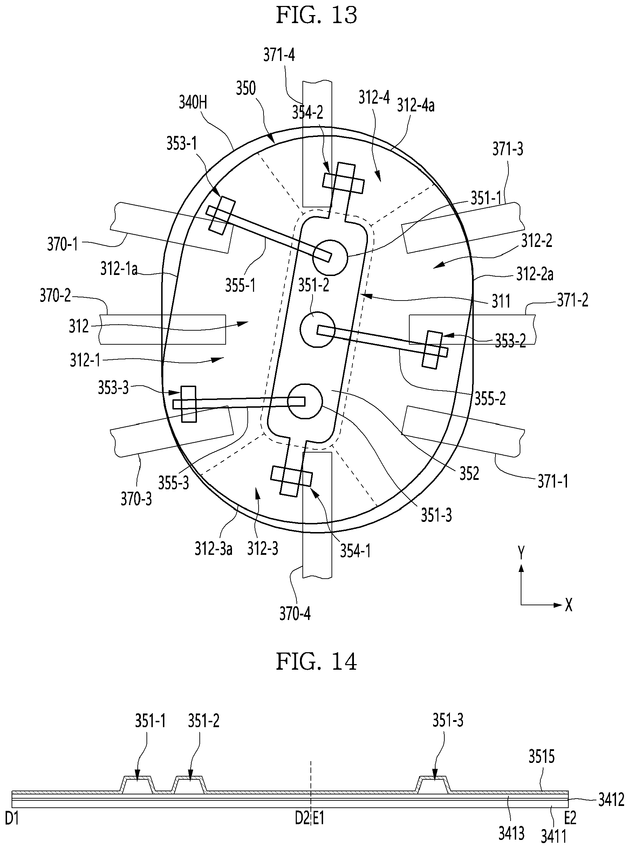

As shown in FIG. 13, the semiconductor light emitting devices 351-1 to 351-3 can be distorted out of position within the assembly hole 340H. In this case, the first to third electrode pads 353-1 to 353-3 can be electrically connected to the plurality of first connection lines 370-1 to 370-4 and/or the plurality of second connection lines 371-1 to 371-4. To this end, the first to third electrode pads 353-1 to 353-3 can be disposed long in a direction crossing the longitudinal direction of each of the first to third electrode wirings 355-1 to 355-3. The first to third electrode pads 353-1 to 353-3 can be arranged elongated in a direction crossing the longitudinal direction of the plurality of first connection lines 370-1 to 370-4 or the plurality of second connection lines 371-1 to 371-4.

Accordingly, during self-assembly, the semiconductor light emitting device package 350 can be assembled into the assembly hole 340H in the normal position or rotated 180 °. Nevertheless, the plurality of electrode pads 353-1 to 353-3, 354-1, and 354-2 on the semiconductor light emitting device package 350 can be electrically connected to the plurality of first signal lines SL-1 to SL-4 through the plurality of first connection lines 370-1 to 370-4 or the plurality of second signal lines SL-1' to SL-4' through the plurality of second connection lines 371-1 to 371-4. That is, during self-assembly, no lighting failure occurs regardless of the assembly direction of the semiconductor light emitting devices 351-1 to 351-3, and thus the lighting yield can be improved.

According to the first embodiment, the plurality of semiconductor light emitting devices 351-1 to 351-3 for displaying a color image can be provided in the semiconductor light emitting device package 350 so that the semiconductor light emitting device package 350 can be assembled into the assembly hole 340H of each of the plurality of pixels PX. Accordingly, the process time for assembly can be drastically reduced. In addition, since the semiconductor light emitting devices remaining after self-assembly do not need to be recovered, secondary defects due to poor recovery of the semiconductor light emitting devices, such as color mixture defects, can be prevented.

According to the first embodiment, since the light emitting device package and the assembly hole 340H of the barrier rib 340 each has an elliptical shape, the semiconductor light emitting device package 350 assembled into the assembly hole 340H of the barrier rib 340 cannot be rotated clockwise or counterclockwise within the assembly hole 340H of the barrier rib 340. Accordingly, separation of the semiconductor light emitting device package 350 can be prevented, and the fixation of the light emitting device package can be enhanced.

According to the first embodiment, the display device can be implemented by manufacturing a light emitting device package and assembling the manufactured light emitting device package in a self-assembly method. In this case, the light emitting device package can be manufactured to include a plurality of semiconductor light emitting devices 351-1 to 351-3 constituting one pixel PX. As a result, the assembly speed is dramatically improved and mass production can be possible.

According to the first embodiment, it is not necessary to individually assemble a plurality of semiconductor light emitting devices that emit light of different colors from each other in a self-assembly method. Accordingly, a decrease in color gamut can be prevented, and a full color image can be implemented by preventing color mixing.

According to the first embodiment, the semiconductor light emitting device package can be disposed in one pixel PX. In this case, the semiconductor light emitting device package can comprise the plurality of semiconductor light emitting devices 351-1 to 351-3. Accordingly, since the size of the pixel PX can be reduced, ultra-high resolution can be implemented.

According to the first embodiment, the arrangement layout of the plurality of semiconductor light emitting devices 351-1 to 351-3 and the plurality of electrode pads 353-1 to 353-3, 354-1, and 354-2 can be optimized. Accordingly, the size of each of the plurality of semiconductor light emitting devices 351-1 to 351-3 can be maximally expanded within a predetermined pixel size PX so that high-quality images can be implemented according to the increase in luminance.

### <Manufacturing Process of Semiconductor Light Emitting Device Package>

FIG. 14 to FIG. 21 are cross-sectional views illustrating manufacturing processes of the semiconductor light emitting device package according to the first embodiment.

As shown in FIG. 14, a first sacrificial layer 3412 and a first adhesive layer 3413 can be formed on a first temporary substrate 3411. The first sacrificial layer 3412 can be made of a transparent conductive material such as ITO, but is not limited thereto.

The first semiconductor light emitting device 351-1, the second semiconductor light emitting device 351-2, and the third semiconductor light emitting device 351-3 constituting the pixel PX can be formed on the first adhesive layer 3413. As an example, after each of the first semiconductor light emitting device 351-1, the second semiconductor light emitting device 351-2, and the third semiconductor light emitting device 351-3 is manufactured on a separate wafer, it can be transferred onto the first temporary substrate (3411). As another example, each of the first semiconductor light emitting device 351-1, the second semiconductor light emitting device 351-2, and the third semiconductor light emitting device 351-3 can be manufactured on the first adhesive layer 3413 using a semiconductor process.

Meanwhile, an etch stop layer 3515 can be formed on the first temporary substrate 3411. The etch stop layer 3515 can be formed on the first semiconductor light emitting device 351-1, the second semiconductor light emitting device 351-2, and the third semiconductor light emitting device 351-3. The etch stop layer 3515 can cover the first semiconductor light emitting device 351-1, the second semiconductor light emitting device 351-2, and the third semiconductor light emitting device 351-3. The etch stop layer 3515 can be made of an inorganic material such as SiO₂, but is not limited thereto.

The etch stop layer 3515 can have a thickness smaller than thickness of each of the first semiconductor light emitting device 351-1, the second semiconductor light emitting device 351-2, and the third semiconductor light emitting device 351-3. Accordingly, a step can be formed by the etch stop layer 3515. The step can be formed between a place where each of the first semiconductor light emitting device 351-1, the second semiconductor light emitting device 351-2, and the third semiconductor light emitting device 351-3 are located and a place where they are not.

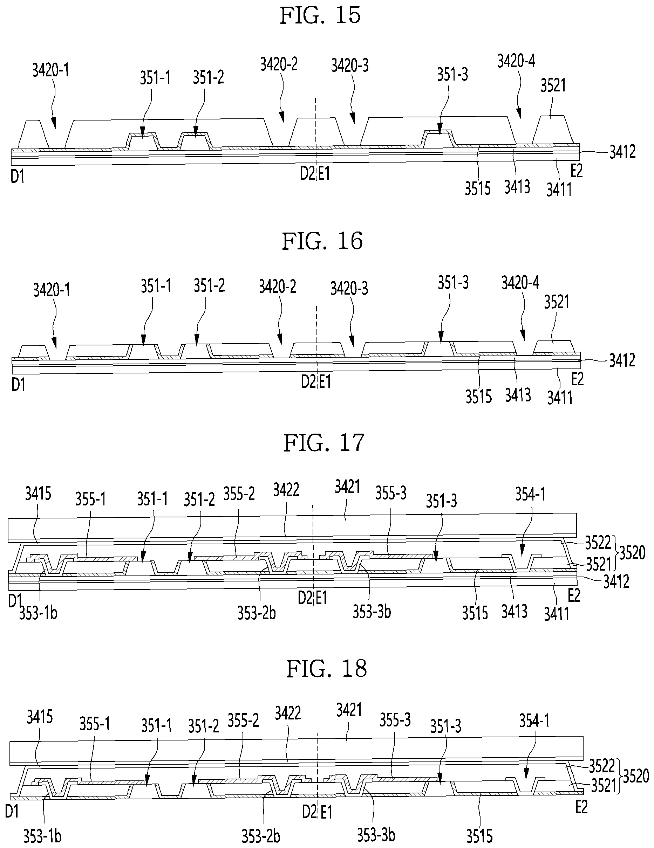

As shown in FIG. 15, a second-first layer 3521 can be formed on the etch stop layer 3515. The second-first layer 3521 can be formed on the first semiconductor light emitting device 351-1, the second semiconductor light emitting device 351-2, and the third semiconductor light emitting device 351-3.

The second-first layer 3521 can be a planarization layer. To this end, the thickness of the second-first layer 3521 is greater than that of each of the first semiconductor light emitting device 351-1, the second semiconductor light emitting device 351-2, and the third semiconductor light emitting device 351-3. Accordingly, the second-first layer 3521 can be formed on the first semiconductor light emitting device 351-1, the second semiconductor light emitting device 351-2, and the third semiconductor light emitting device 351-3. In this case, regardless of where the first semiconductor light emitting device 351-1, the second semiconductor light emitting device 351-2, and the third semiconductor light emitting device 351-3 are located or not, an upper surface of the second-first layer 3521 can have a horizontal surface.

The second-first layer 3521 can be etched to form a plurality of contact holes 3420-1 to 3420-4. Also, the second-first layer 3521 can be etched to separate a plurality of semiconductor light emitting device package formation regions. The semiconductor light emitting device package forming region can be a region for forming a semiconductor light emitting device package. A semiconductor light emitting device package can be manufactured from each of the plurality of semiconductor light emitting device package forming regions.

As shown in FIG. 16, the entire area of the second-first layer 3521 can be etched so that an upper surface of the second-first layer 3521 and a lower surface of the etch stop layer 3515 can be positioned on the same horizontal line. The etch stop layer 3515 can be disposed on the first semiconductor light emitting device 351-1, the second semiconductor light emitting device 351-2, and the third semiconductor light emitting device 351-3.

Thereafter, the entire area of the etch stop layer 3515 can be etched. Accordingly, the etch stop layer 3515 in the plurality of contact holes 3420-1 to 3420-4 and the etch stop layer 3515 on the first semiconductor light emitting device 351-1, the second semiconductor light emitting device 351-2, and the third semiconductor light emitting device 351 - 3 can be removed. The etch stop layer 3515 in the plurality of contact holes 3420-1 to 3420-4 can be removed to expose the first adhesive layer 3413. The etch stop layer 3515 on the first semiconductor light emitting device 351-1, the second semiconductor light emitting device 351-2, and the third semiconductor light emitting device 351-3 can be removed so that an upper surface of each of the first semiconductor light emitting device 351-1, the second semiconductor light emitting device 351-2 and the third semiconductor light emitting device 351-3 can be exposed. Accordingly, the upper surface of the second-first layer 3521 and the upper surface of each of the first semiconductor light emitting device 351-1, the second semiconductor light emitting device 351-2, and the third semiconductor light emitting device 351-3 can be located on the same horizontal line.

As shown in FIG. 17, upper contact electrodes 353-1b, 353-2b, and 353-3b and a first common electrode pad 354-1 can be formed in the plurality of contact holes 3420-1 to 3420-4.

Subsequently, a plurality of electrode wirings 355-1 to 355-3 can be formed on the second-first layer 3521. The plurality of electrode wirings 355-1 to 355-3 can be made of a transparent conductive material such as ITO. The plurality of electrode wirings 355-1 to 355-3 can connect the first semiconductor light emitting device 351-1, the second semiconductor light emitting device 351-2, and the third semiconductor light emitting device 351-3 to the upper contact electrodes 353-1b, 353-2b, and 353-3b, respectively.

Then, a second-second layer 3522 can be formed on the second-first layer 3521. The second-second layer 3522 can be formed on the plurality of electrode wirings 355-1 to 355-3. The second-second layer 3522 can be formed of the same material as a material of the second-first layer 3521, but is not limited thereto. For example, the second-first layer 3521 and the second-second layer 3522 can be formed of an organic material, but are not limited thereto. A second layer 3520 can be formed by the second-first layer 3521 and the second-second layer 3522.

A second sacrificial layer 3415 can be formed on the second layer 3520. The second sacrificial layer 3415 can be made of a metal such as Al, but is not limited thereto. A polymer-based material can be used instead of metal.

Subsequently, a second temporary substrate 3421 can be attached on the second sacrificial layer 3415. For example, the second temporary substrate 3421 can be attached to the second sacrificial layer 3415 via the second adhesive layer 3422.

As shown in FIG. 18, the first temporary substrate 3411 can be separated using a laser lift-off (LLO) process. That is, the first temporary substrate 3411 together with the first sacrificial layer 3412 can be separated by heat generated by irradiating the laser to an interface between the first sacrificial layer 3412 and the first adhesive layer 3413.

Subsequently, the first adhesive layer 3413 can be removed. Accordingly, the etch stop layer 3515, the first semiconductor light emitting device 351-1, the second semiconductor light emitting device 351-2, the third semiconductor light emitting device 351-3, and the plurality of upper contact electrodes 353-1b, 353-2b, 353-3b can be exposed.

As shown in FIG. 19, the common electrode wiring 352 and the plurality of lower contact electrodes 353-1a, 353-2a, and 353-3a can be formed on the exposed etch stop layer 3515, the exposed first semiconductor light emitting device 351-1, the exposed second semiconductor light emitting device 351-2, the t exposed third semiconductor light emitting device 351-3, and the plurality of exposed upper contact electrodes 353-1b, 353-2b, 353-3b.

The common electrode wiring 352 and the plurality of lower contact electrodes 353-1a, 353-2a, and 353-3a can each be composed of a plurality of layers. In this case, each of the common electrode wiring 352 and the plurality of lower contact electrodes 353-1a, 353-2a, and 353-3a can comprise an electrode layer, a magnetic layer, a reflective layer, an ohmic layer, etc.

The common electrode wiring 352 can be formed on the first semiconductor light emitting device 351-1, the second semiconductor light emitting device 351-2, and the third semiconductor light emitting device 351-3. The common electrode wiring 352 can vertically overlap each of the first semiconductor light emitting device 351-1, the second semiconductor light emitting device 351-2, and the third semiconductor light emitting device 351-3. For example, the size of the common electrode wiring 352 can be greater than the sum of an occupied area of each of the first semiconductor light emitting device 351-1, the second semiconductor light emitting device 351-2, and the third semiconductor light emitting device 351-3 disposed apart from each other.

The common electrode wiring 352 can be commonly connected to the first semiconductor light emitting device 351-1, the second semiconductor light emitting device 351-2, and the third semiconductor light emitting device 351-3. For example, the common electrode wiring 352 can be commonly connected to the lower side of each of the first semiconductor light emitting device 351-1, the second semiconductor light emitting device 351-2, and the third semiconductor light emitting device 351-3. The common electrode wiring 352 can be connected to the common electrode pads 354-1 and 354-2. Accordingly, current of each of the first semiconductor light emitting device 351-1, the second semiconductor light emitting device 351-2, and the third semiconductor light emitting device 351-3 can flow to the common electrode pad 354-1 and 354-2 by passing through the common electrode wiring 352.

The plurality of lower contact electrodes 353-1a, 353-2a, and 353-3a can vertically overlap the plurality of upper contact electrodes 353-1b, 353-2b, and 353-3b, respectively. The plurality of lower contact electrodes 353-1a, 353-2a, and 353-3a can be connected to the plurality of upper contact electrodes 353-1b, 353-2b, and 353-3b, respectively. The plurality of lower contact electrodes 353-1a, 353-2a, and 353-3a can contact lower surfaces of the plurality of upper contact electrodes 353-1b, 353-2b, and 353-3b, respectively.

A plurality of electrode pads 353-1 to 353-3 can be formed by the plurality of lower contact electrodes 353-1a, 353-2a, and 353-3a and the plurality of upper contact electrodes 353-1b, 353-2b, and 353-3b. 3. Accordingly, the plurality of electrode pads 353-1 to 353-3 can be connected to the plurality of electrode wirings 355-1 to 355-3, respectively. current supplied to each of the plurality of electrode pads 353-1 to 353-3 can flows to the first semiconductor light emitting device 351-1 and the second semiconductor light emitting device. (351-2) and the third semiconductor light emitting device 351-3 by passing through the plurality of electrode wirings 355-1 to 355-3.

The substrate manufactured in FIG. 19 is a preliminary semiconductor light emitting device package 350', and electrical connection to the plurality of semiconductor light emitting devices 351-1 to 351-3 can be completed. Such a substrate can be referred to as a preliminary semiconductor light emitting device package 350'.

A lighting inspection can be performed on the preliminary semiconductor light emitting device package 350' manufactured in FIG. 19.

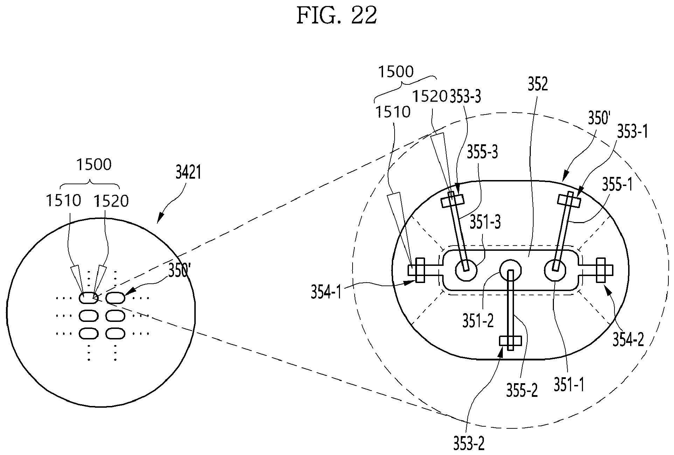

As shown in FIG. 22, a plurality of preliminary semiconductor light emitting device packages 350' can be manufactured on the second temporary substrate 3421.

A lighting inspection can be performed on each of the plurality of semiconductor light emitting devices 351-1 to 351-3 of each of the plurality of preliminary semiconductor light emitting device packages 350' using a lighting inspection device 1500 comprising a first probe terminal 1510 and a second probe terminal 1520.

For example, the first probe terminal 1510 can be a terminal to which a negative (-) voltage is applied, and the second probe terminal 1520 can be a terminal to which a positive (+) voltage is applied. In this case, the first probe terminal 1510 can contact the common electrode pads 354-1 and 354-2, and the second probe terminal 1520 can sequentially contact the first to third electrode pads 353-1 to 353-3 of the preliminary semiconductor light emitting device package 350' so that lighting inspection can be performed.

For example, after the second probe terminal 1520 can contact the first electrode pad 353-1 of the preliminary semiconductor light emitting device package 350', a positive (+) voltage is applied such that it can be checked whether or not the first semiconductor light emitting device 351-1 is emitted. Then, after the second probe terminal 1520 can contact the second electrode pad 353-2 of the preliminary semiconductor light emitting device package 350', a positive (+) voltage is applied such that it can be checked whether or not the second semiconductor light emitting device 351-2 is emitted. Then, after the second probe terminal 1520 can contact the third electrode pad 353-3 of the preliminary semiconductor light emitting device package 350', a positive (+) voltage is applied such that it can be checked whether or not the third semiconductor light emitting device 351-3 is emitted.

In the drawing, a pair of probe terminals 1510 and 1520 are shown, the lighting inspection for the plurality of preliminary semiconductor light emitting device packages 350' can be performed at the same time using a plurality of pairs of probe terminals.

As shown in FIG. 20, a first layer 3510 can be formed on the common electrode wiring 352 and the plurality of lower contact electrodes 353-1a, 353-2a, and 353-3a. The thickness of the first layer 3510 can be greater than the thickness of the common electrode wiring 352 or the thickness of each of the plurality of lower contact electrodes 353-1a, 353-2a, and 353-3a. Accordingly, the first layer 3510 can cover the common electrode wiring 352 and the plurality of lower contact electrodes 353-1a, 353-2a, and 353-3a. An upper surface of the first layer 3510 can have a horizontal surface, but is not limited thereto.

The common electrode wiring 352 and the plurality of lower contact electrodes 353-1a, 353-2a, and 353-3a can be protected from external impact or foreign substances by the first layer 3510. An electrical short between the common electrode wiring 352 and the lower contact electrodes 353-1a, 353-2a, and 353-3a or between the lower contact electrodes 353-1a, 353-2a, and 353-3a can be prevented by the first layer 3510.

As shown in FIG. 21, the second sacrificial layer 3415 can be removed using an etching process to separate the second temporary substrate 3421 so that the semiconductor light emitting device package 350 can be manufactured. For example, the second sacrificial layer 3415 can be removed by wet etching using an etchant.

### <Second embodiment>

FIG. 23 is a plan view illustrating a semiconductor light emitting device package according to a second embodiment.

The second embodiment is the same as the first embodiment (FIG. 9) except for the two second electrode pads 353-2a and 353-2b and the two second electrode wirings 355-2a and 355-2b. In the second embodiment, components having the same structure, shape and/or function as those in the first embodiment are given the same reference numerals, and detailed descriptions are omitted.

Although a cross-sectional view of the semiconductor light emitting device package 350A according to the second embodiment is not shown, since it is the same as the cross-sectional view (FIG. 10) of the semiconductor light emitting device package 350 according to the first embodiment, reference can be made to FIG. 10 in the following description.

Referring to FIGS. 10 and 23, the semiconductor light emitting device package 350A according to the second embodiment can comprise a first layer 3510, a common electrode wiring 352, and a plurality of semiconductor light emitting devices 351-1 to 351-3, a plurality of electrode pads 353-1 to 353-3, 354-1, and 354-2, a plurality of electrode wirings 355-1 to 355-3, and a second layer 3520. The semiconductor light emitting device package 350A according to the second embodiment can comprise more components than these.

The plurality of semiconductor light emitting devices can comprise a first semiconductor light emitting device 351-1, a second semiconductor light emitting device 351-2, and a third semiconductor light emitting device 351-3.

The first semiconductor light emitting device 351-1, the second semiconductor light emitting device 351-2, and the third semiconductor light emitting device 351-3 can be arranged in a line along the major axis direction of an elliptical shape of the first layer 3510 on the common electrode wiring 352. In this case, the second semiconductor light emitting device 351-2 can be disposed between the first semiconductor light emitting device 351-1 and the third semiconductor light emitting device 351-3.

The second semiconductor light emitting device 351-2 can be located in a central region of the semiconductor light emitting device package 350A according to the second embodiment. The second semiconductor light emitting device 351-2 can be located in a central region of the first layer 3510. The second semiconductor light emitting device 351-2 can be located in a central region of a first region 311 of the first layer 3510. The second semiconductor light emitting device 351-2 can be located in a central region of the common electrode wiring 352.

A second luminance of a second light emitted from the second semiconductor light emitting device 351-2 can be smaller than a first luminance of a first light emitted from the first semiconductor light emitting device 351-1 or a third luminance of a third light emitted from the third semiconductor light emitting device 351-3. For example, the second semiconductor light emitting device 351-2 can be a red semiconductor light emitting device emitting red light. One of the first semiconductor light emitting device 351-1 and the third semiconductor light emitting device 351-3 can be a blue semiconductor light emitting device, and the other can be a green semiconductor light emitting device. For example, the red semiconductor light emitting device 351-2 can be made of a GaAs-based compound semiconductor material, and the blue semiconductor light emitting device 351-1 or green semiconductor light emitting device 351-3 can be made of a GaN-based compound semiconductor material. Accordingly, the luminance of the red light emitted from the red semiconductor light emitting device 351-2 can be smaller than the luminance of the blue light emitted from the blue semiconductor light emitting device 351-1 or the luminance of the green light emitted from the green semiconductor light emitting device 351-3.

In the second embodiment, in order to improve the second luminance of the second light emitted from the second semiconductor light emitting device 351-2, each of the second electrode pads 353-2a and 353-2b and the second electrode wiring 355- 2a and 355-2b can be provided with two.

The plurality of electrode pads can comprise a first electrode pad 353-1, second electrode pads 353-2a and 353-2b, and a third electrode pad 353-3. The first electrode pad 353-1, the second electrode pads 353-2a and 353-2b, and the third electrode pad 353-3 are disposed on a second region 312 of the first layer 3510. The plurality of electrode wirings can comprise a first electrode wiring 355-1, second electrode wirings 355-2a and 355-2b, and a third electrode wiring 355-3. The first electrode wiring 355-1, the second electrode wiring 355-2a, 355-2b, and the third electrode wiring 355 - 3 can be disposed from a first region 311 to the second region 312 of the first layer 3510.

Meanwhile, the second electrode pad can comprise a second-first electrode pad 353-2a and a second-second electrode pad 353-2b. For example, the second-first electrode pad 353-2a can be disposed on a second-second region 312-2 of the first layer 3510, and the second-second electrode pad 353-2b can be disposed on a second-first region 312-1 of the first layer 3510.

The second-first electrode pad 353-2a and the second-second electrode pad 353-2b can have symmetrical structures with each other with respect to the reference line in the second direction Y that passes through the center of the first layer 3510. A first distance L1 between the second-first electrode pad 353-2a and the second semiconductor light emitting device 351-2 and a second distance L2 between the second-second electrode pad 353-2b and the second semiconductor light emitting device 351-2 can be the same, but is not limited thereto. The second-second electrode pad 353-2b can be located between the first electrode pad 353-1 and the third electrode pad 353-3 in the second-first region 312-1 of the first layer 3510.

The second electrode wiring can comprise a second-first electrode wiring 355-2a and a second-second electrode wiring 355-2b. For example, the second-first electrode wiring 355-2a can be disposed from the first region 311 to the second-second region 312-2 of the first layer 3510, and the second-second electrode wiring 355-2b can be disposed from the first region 311 to the second-first region 312-1 of the first layer 3510.

The second-first electrode wiring 355-2a can connect the upper side of the second semiconductor light emitting device 351-2 to the second-first electrode pad 353-2a. For example, the second-first electrode wiring 355-2a can extend from the upper side of the second semiconductor light emitting device 351-2 and be disposed on the second-first electrode pad 353-2a. The second-second electrode wiring 355-2b can connect the upper side of the second semiconductor light emitting device 351-2 to the second-second electrode pad 353-2b. For example, the second-second electrode wiring 355-2b can extend from the upper side of the second semiconductor light emitting device 351-2 and be disposed on the second-second electrode pad 353-2b.

For example, the second-first electrode wiring 355-2a and the second-second electrode wiring 355-2b can be integrally formed, but is not limited thereto. That is, the second-first electrode wiring 355-2a and the second-second electrode wiring 355-2b can be simultaneously formed by the same process using the same metal.

Meanwhile, the second-first electrode pad 353-2a can be connected to the second-second signal line SL-2' through the 2-2 connection line 371-2. The second-second electrode pad 353-2b can be connected to the first-second signal line SL-2 through the 1-2 connection line 370-2. In this case, current can flow to the second semiconductor light emitting device 351- 2 through the second-second signal line SL-2' and the 2-2 connection line 371-2, and at the same time, another current can flow to the second semiconductor light emitting device 351-2 through the first-second signal line SL- 2 and the 1-2 connection line 370 - 2. Accordingly, since the current flowing through the second semiconductor light emitting device 351-2 can increase, the luminance of the red light emitted from the second semiconductor light emitting device 351-2 can increase. The current supplied through the second-second signal line SL-2' and the current supplied through the first-second signal line SL-2 can be the same, but are not limited thereto.

Although not shown, since the first electrode pads 353-1 or the third electrode pads 353-3 can be also provided with two, the two first electrode pads 353-1 can be connected to the first semiconductor light emitting device 351-1 or the two third electrode pads 353-3 can be connected to the third semiconductor light emitting device 351-3.

### <Third embodiment>

FIG. 24 is a plan view illustrating a semiconductor light emitting device package according to a third embodiment.

The third embodiment is the same as the first embodiment or the second embodiment except that one pixel PX2 is added or one redundancy pixel PX_R is included. In the third embodiment, the same reference numerals are given to components having the same structure, shape and/or function as those in the first or second embodiment, and detailed descriptions are omitted.

The third embodiment can also be applied to the second embodiment.

Although a cross-sectional view of the semiconductor light emitting device package 350A according to the third embodiment is not shown, since it is the same as the cross-sectional view (FIG. 10) of the semiconductor light emitting device package 350 according to the first embodiment, reference can be made to FIG. 10 in the following description.

Referring to FIGS. 10 and 24, the semiconductor light emitting device package 350B according to the third embodiment can comprise a first layer 3510, a common electrode wiring 352, and a plurality of semiconductor light emitting devices 351-1 to 351-6, a plurality of electrode pads 353-1 to 353-6, 354-1, and 354-2, a plurality of electrode wirings 355-1 to 355-6, and a second layer 3520. The semiconductor light emitting device package 350B according to the third embodiment can comprise more components than these.

The first layer 3510 can be divided into a first region 311 and a second region 312. The second region 312 can surround the first region 311. The second region 312 can comprise a second-first region 312-1, a second-second region 312-2, a second-third region 312-3 and a second-fourth region 312-4.

The plurality of electrode pads 353-1 to 353-3, 354-1, and 354-2 can be disposed on a second region 312 of the first layer 3510.

The plurality of electrode pads can include a first electrode pad 353-1, a second electrode pad 353-2, a third electrode pad 353-3, a fourth electrode pad 353-4, and a fifth electrode pad (353-5), a sixth electrode pad 353-6, and at least one or more common electrode pads 354-1 and 354-2.

The first electrode pad 353-1, the second electrode pad 353-2, and the third electrode pad 353-3 can be disposed on the second-first region 312-1. The fourth electrode pad 353-4, the fifth electrode pad 353-5, and the sixth electrode pad 353-6 can be disposed on the second-second region 312-2. The first electrode pad 353-1, the second electrode pad 353-2, and the third electrode pad 353-3 can be arranged in a line along a first round-shape side surface 312-1a on the second-first region 312-1. The fourth electrode pad 353-4, the fifth electrode pad 353-5, and the sixth electrode pad 353-6 can be arranged in a line along a second round-shape side surface 312-2a on the second-second region 312-2. For example, the second electrode pad 353-2 can be disposed between the first electrode pad 353-1 and the third electrode pad 353-3. For example, the fifth electrode pad 353-5 can be disposed between the fourth electrode pad 353-4 and the sixth electrode pad 353-6.

In addition, at least one or more common electrode pads 354-1 and 354-2 can be connected to the common electrode wiring 352.

Meanwhile, the common electrode wiring 352 can be disposed on the first region 311 of the first layer 3510. The plurality of semiconductor light emitting devices 351-1 to 351-6 can be disposed on the common electrode wiring 352. The common electrode wiring 352 can be commonly connected to the plurality of semiconductor light emitting devices 351-1 to 351-6.

The plurality of semiconductor light emitting devices can comprise six semiconductor light emitting devices, that is, a first semiconductor light emitting device 351-1, a second semiconductor light emitting device 351-2, a third semiconductor light emitting device 351-3, and a fourth semiconductor light emitting device 351-4, the fifth semiconductor light emitting device 351-5, and the sixth semiconductor light emitting device 351-6.

As an example, the semiconductor light emitting device package 350B according to the third embodiment can have two pixels, that is, a first pixel PX1 and a second pixel PX2. In this case, the first pixel PX1 can be defined to be long along the major axis direction of an elliptical shape of the first layer 3510 on one region of the common electrode wiring 352. The second pixel PX2 can be defined long along the major axis direction of the elliptical shape of the first layer 3510 on the other region of the common electrode wiring 352.

The first pixel PX1 can be constituted by the first semiconductor light emitting device 351-1, the second semiconductor light emitting device 351-2, and the third semiconductor light emitting device 351-3, and the second pixel PX2 can be by the fourth semiconductor light emitting device 351-4, the fifth semiconductor light emitting device 351-5, and the sixth semiconductor light emitting device 351-6.

The first semiconductor light emitting device 351-1, the second semiconductor light emitting device 351-2, and the third semiconductor light emitting device 351-3 constituting the first pixel PX1 can be arranged in a line along the major axis direction of an elliptical shape of the first layer 3510 on one region of the common electrode wiring 352. The fourth semiconductor light emitting device 351-4, the fifth semiconductor light emitting device 351-5, and the sixth semiconductor light emitting device 351-6 constituting the second pixel PX2 can be arranged in a line along the major axis direction of an elliptical shape of the first layer 3510 on the other region of the common electrode wiring 352.

The first semiconductor light emitting device 351-1 of the first pixel PX1 and the fourth semiconductor light emitting device 351-4 of the second pixel PX2 can be disposed in a diagonal direction with respect to the center of the first region 311 of the first layer 3510. The second semiconductor light emitting device 351-2 of the first pixel PX1 and the fifth semiconductor light emitting device 351-5 of the second pixel PX2 can be disposed along a minor axis direction of an elliptical shape of the first layer 3510, that is, along the first direction X. The third semiconductor light emitting device 351-3 of the first pixel PX1 and the sixth semiconductor light emitting device 351-6 of the second pixel PX2 can be disposed in a diagonal direction with respect to the center of the first region 311 of the first layer 3510.

The first semiconductor light emitting device 351-1 of the first pixel PX1 and the fourth semiconductor light emitting device 351-4 of the second pixel PX2 can emit light of the same color, for example, blue light. The second semiconductor light emitting device 351-2 of the first pixel PX1 and the fifth semiconductor light emitting device 351-5 of the second pixel PX2 can emit the same color light, that is, red light. The third semiconductor light emitting device 351-3 of the first pixel PX1 and the sixth semiconductor light emitting device 351-6 of the second pixel PX2 can emit light of the same color, that is, green light.

Meanwhile, the plurality of electrode wirings can include a first electrode wiring 355-1, a second electrode wiring 355-2, a third electrode wiring 355-3, a fourth electrode wiring 355-4, a fifth electrode wiring 355-5 and a sixth electrode wiring 355-6.

The first electrode wiring 355-1, the second electrode wiring 355-2, and the third electrode wiring 355-3 can be disposed from the first region 311 to the second-first region 312-1 of an elliptical shape of the first layer 3510. The fourth electrode wiring 355-4, the fifth electrode wiring 355-5, and the sixth electrode wiring 355-6 can be disposed from the first region 311 to the second-second region 312-2 of the elliptical shape of the first layer 3510.

The first electrode wiring 355-1 can extend from an upper side of the first semiconductor light emitting device 351-1 and be disposed on the first electrode pad 353-1. That is, the first electrode wiring 355-1 can connect the upper side of the first semiconductor light emitting device 351-1 to the first electrode pad 353-1. The second electrode wiring 355-2 can extend from an upper side of the second semiconductor light emitting device 351-2 and be disposed on the second electrode pad 353-2. That is, the second electrode wiring 355-2 can connect the upper side of the second semiconductor light emitting device 351-2 to the second electrode pad 353-2. The third electrode wiring 355-3 can extend from an upper side of the third semiconductor light emitting device 351-3 and be disposed on the third electrode pad 353-3. That is, the third electrode wiring 355-3 can connect the upper side of the third semiconductor light emitting device 351-3 to the third electrode pad 353-3.

The fourth electrode wiring 355-4 can extend from an upper side of the fourth semiconductor light emitting device 351-4 and be disposed on the fourth electrode pad 353-4. That is, the fourth electrode wiring 355-4 can connect the upper side of the fourth semiconductor light emitting device 351-4 to the fourth electrode pad 353-4. The fifth electrode wiring 355 - 5 can extend from an upper side of the fifth semiconductor light emitting device 351-5 and be disposed on the fifth electrode pad 353 - 5. That is, the fifth electrode wiring 355-5 can connect the upper side of the fifth semiconductor light emitting device 351-5 to the fifth electrode pad 353-5. The sixth electrode wiring 355 - 6 can extend from an upper side of the sixth semiconductor light emitting device 351-6 and be disposed on the sixth electrode pad 353 - 6. That is, the sixth electrode wiring 355-6 can connect the upper side of the sixth semiconductor light emitting device 351-6 to the sixth electrode pad 353-6.

Meanwhile, referring to FIGS. 7 and 24, the first electrode pad 353-1 can be connected to the first-first signal line SL-1 through the 1-1 connection line 370-1. The second electrode pad 353-2 can be connected to the first-second signal line SL-2 through the 1-2 connection line 370-2. The third electrode pad 353-3 can be connected to the first-third signal line SL-3 through the 1-3 connection line 370-3. The fourth electrode pad 353-4 can be connected to the first-fourth signal line SL-4 through the 1-4 connection line 370-4. The fifth electrode pad 353-5 can be connected the 2-2 sign line SL-2' through the 2-2 connection line 371-2. The sixth electrode pad 353-6 can be connected to the second-third signal line SL-3' through the 2-3 connection line 371-3. In addition, the at least one common or more electrode pad 354-1 or 354-2 can be connected to the at least one signal line SL-4 and SL-4' through the at least one or more common connection line 370-4 and 371-4.

A current for generating blue light can be supplied through the first-first signal line SL-1 and the second-first signal line SL-1'. A current for generating red light can be supplied through the first-second signal line SL-2 and the second-second signal line SL-2'. A current for generating green light can be supplied through the first-third signal line SL-3 and the second-third signal line SL-3'.

For example, the blue light can be emitted from the first semiconductor light emitting device 351-1 constituting the first pixel PX1 by a current supplied through the first-first signal line SL-1. For example, the red light can be emitted from the second semiconductor light emitting device 351-2 constituting the first pixel PX1 by a current supplied through the first-second signal line SL-2. For example, the green light can be emitted from the third semiconductor light emitting device 351-3 constituting the first pixel PX1 by a current supplied through the first-third signal line SL-3.

For example, the blue light can be emitted from the fourth semiconductor light emitting device 351-4 constituting the second pixel PX2 by a current supplied through the second-first signal line SL-1 '. For example, the red light can be emitted from the fifth semiconductor light emitting device 351-5 constituting the second pixel PX2 by a current supplied through the second-second signal line SL-2 '. For example, the green light can be emitted from the sixth semiconductor light emitting device 351-6 constituting the second pixel PX2 by a current supplied through the second-third signal line SL-3 '.

According to the third embodiment, the semiconductor light emitting device package 350B can comprise two pixels, that is, a first pixel PX1 and a second pixel PX2 for displaying an image. Accordingly, a smaller-sized pixel per unit area can be obtained, and an ultra-high resolution image can be implemented.

According to the third embodiment, by way of the semiconductor light emitting device package 350B comprising two pixels PX1 and PX2 compared to the semiconductor light emitting device package comprising only one pixel (350 in FIG. 9), a smaller number of semiconductor light emitting device packages 350B can be self-assembled. Accordingly, the possibility of assembly defects occurring during self-assembly can be drastically reduced, and process time can be significantly reduced

Meanwhile, the semiconductor light emitting device package 350B according to the third embodiment can have redundancy pixels PX_R. That is, as shown in FIG. 24, the first pixel PX1 can be constituted by the first semiconductor light emitting device 351-1, the second semiconductor light emitting device 351-2, and the third semiconductor light emitting device 351-3. The redundancy pixel PX_R can be constituted by the fourth semiconductor light emitting device 351-4, the fifth semiconductor light emitting device 351-5, and the sixth semiconductor light emitting device 351-6.

The first semiconductor light emitting device 351-1, the second semiconductor light emitting device 351-2, and the third semiconductor light emitting device 351-3 of the first pixel PX1 can be electrically connected to a plurality of first signal lines SL-1 to SL-3. The fourth semiconductor light emitting device 351-4, fifth semiconductor light emitting device 351-5, and sixth semiconductor light emitting device 351-6 of the redundancy pixel PX_R can be electrically connected to a plurality of second signal lines SL-1'. to SL-3'. In addition, the first semiconductor light emitting device 351-1, the second semiconductor light emitting device 351-2, the third semiconductor light emitting device 351-3, the fourth semiconductor light emitting device 351-4, the fifth semiconductor light emitting device 351-5 and the sixth semiconductor light emitting device 351-6 can be commonly connected to the first-fourth signal line SL-4 or the second-fourth signal line SL-4' through the common electrode wiring 352.

When the display is implemented, the first semiconductor light emitting device 351-1, the second semiconductor light emitting device 351-2, and the third semiconductor light emitting device 351-3 emit light so that an image of the first pixel PX1 can be displayed. At this time, no image can be displayed in the redundancy pixel PX_R. To this end, current can be supplied to each of the first-first signal line SL-1, the first-second signal line SL-2 and the first-third signal line SL-3, and no current can be supplied to the second-first signal line SL-1', the second-second signal line SL-2', and the second-third signal line SL-3'.

A specific semiconductor light emitting device of the first pixel PX1, for example, the second semiconductor light emitting device 351-2 can fail. In this case, since current can flow into the second-second signal line SL-2' connected to the semiconductor light emitting device emitting the same color light as that of the second semiconductor light emitting device 351-2, that is, the fifth semiconductor light emitting device 351-5, the fifth semiconductor light emitting device 351-5 can emit light. Accordingly, even if at least one or more semiconductor light emitting devices among the first semiconductor light emitting device 351-1, the second semiconductor light emitting device 351-2, and the third semiconductor light emitting device 351-3 of the first pixel PX1 fails, the fourth semiconductor light emitting device 351-4, the fifth semiconductor light emitting device 351-5, and/or the sixth semiconductor light emitting device 351-6 of the redundancy pixel PX_R can emit light so that image display failure can be prevented.

### <Fourth embodiment>

FIG. 25 is a plan view illustrating a semiconductor light emitting device package according to a fourth embodiment. FIG. 26 is a cross-sectional view taken along the lines D1-D2 and E1-E2 in the semiconductor light emitting device package according to the fourth embodiment of FIG. 25.

The fourth embodiment is the same as the first to third embodiments except for the color conversion layer 3430. In the fourth embodiment, the same reference numerals are given to components having the same structure, shape and/or function as those in the first to third embodiments, and detailed descriptions are omitted.

The fourth embodiment can also be applied to the second or third embodiments.

Referring to FIGS. 10, 25, and 26, the semiconductor light emitting device package 350C according to the fourth embodiment can comprise a first layer 3510, a common electrode wiring 352, and a plurality of semiconductor light emitting devices 351-1 to 351-3, a plurality of electrode pads 353-1 to 353-3, 354-1, and 354-2, a plurality of electrode wirings 355-1 to 355-3, a color conversion layer 3430, and a second layer 3520. The semiconductor light emitting device package 350C according to the fourth embodiment can comprise more components than these.

The plurality of semiconductor light emitting devices 351-1 to 351-3 can be disposed on the common electrode wiring 352. The plurality of semiconductor light emitting devices can comprise a first semiconductor light emitting device 351-1, a second semiconductor light emitting device 351-2, and a third semiconductor light emitting device 351-3.

According to an embodiment, the first semiconductor light emitting device 351-1, the second semiconductor light emitting device 351-2, and the third semiconductor light emitting device 351-3 can emit the same color light.

For example, the first semiconductor light emitting device 351-1, the second semiconductor light emitting device 351-2, and the third semiconductor light emitting device 351-3 can emit light having a wavelength range of 350 nm to 450 nm. For example, the first semiconductor light emitting device 351-1, the second semiconductor light emitting device 351-2, and the third semiconductor light emitting device 351-3 can emit purple light or blue light.

Instead of the first semiconductor light emitting device 351-1, the second semiconductor light emitting device 351-2, and the third semiconductor light emitting device 351-3, that is, three semiconductor light emitting devices, only one semiconductor light emitting device emitting purple light or blue light can be provided.

The color conversion layer 3430 can comprise a first color conversion pattern 3431 and a second color conversion pattern 3432.

No color conversion pattern can be disposed or a transparent insulating pattern can be disposed on the first semiconductor light emitting device 351-1. A thickness of the corresponding insulating pattern can be the same as a thickness of the first color conversion pattern 3431 or the second color conversion pattern 3432, but is not limited thereto.

The first color conversion pattern 3431 can be disposed on the second semiconductor light emitting device 351-2, and the second color conversion pattern 3432 can be disposed on the third semiconductor light emitting device 351-3.

For example, a size of the first color conversion pattern 3431 can be greater than a size of the second semiconductor light emitting device 351-2, and a size of the second color conversion pattern 3432 can be greater than a size of the third semiconductor light emitting device 351-3. The size of the first color conversion pattern 3431 can be large enough to receive all light emitted from the second semiconductor light emitting device 351-2. The size of the second color conversion pattern 3432 can be large enough to receive all the light emitted from the third semiconductor light emitting device 351-3.

A part of the first color conversion pattern 3431 can contact an upper side of the second semiconductor light emitting device 351-2 and another part of the first color conversion pattern 3431 can contact the second electrode wiring 355-2. A part of the second color conversion pattern 3432 can contact an upper side of the third semiconductor light emitting device 351-3 and another part of the second color conversion pattern 3432 can contact the third electrode wiring 355-3.

In the drawings, each of the first color conversion pattern 3431 and the second color conversion pattern 3432 are shown as having a square shape, but can have a circular shape or other shapes.

Meanwhile, the first color conversion pattern 3431 and the second color conversion pattern 3432 can be disposed below the second layer 3520. That is, the first color conversion pattern 3431 is disposed between the second semiconductor light emitting device 351-2 and the second layer 3520, and the second color conversion pattern 3432 is disposed between the third semiconductor light emitting device 351-3 and the second layer 3520.

A first light can be emitted from each of the first semiconductor light emitting device 351-1, the second semiconductor light emitting device 351-2, and the third semiconductor light emitting device 351-3. The first light emitted from the first semiconductor light emitting device 351-1 can propagate forward through the second layer 3520. A first light emitted from the second semiconductor light emitting device 351-2 can be incident to the first color conversion pattern 3431. The first color conversion pattern 3431 can convert the first light and output a second light. The output second light can proceed forward through the second layer 3520. A first light emitted from the third semiconductor light emitting device 351-3 can be incident to the second color conversion pattern 3432. The second color conversion pattern 3432 can convert the first light to output a third light. The output third light can proceed forward through the second layer 3520. The first light can be blue light, the second light can be red light, and the third light can be green light, but is not limited thereto. Accordingly, a color image can be displayed by the first light, the second light, and the third light.

According to the fourth embodiment, self-assembly can be performed using the semiconductor light emitting device package 350C having the color conversion layer 3430 and capable of displaying an image for the unit pixel PX. Accordingly, there is no need to separately form the light source and the color conversion layer 3430 so the structure can be simplified. Meanwhile, when a plurality of semiconductor light emitting devices 351-1 to 351-3 are used as a light source, it is difficult to assemble each of the plurality of semiconductor light emitting devices 351-1 to 351-3, and there is a limitation to reducing the size. In addition, it is very difficult to individually form color patterns of the color conversion layer 3430 corresponding to a plurality of semiconductor light emitting devices each having a size of a micrometer or less. However, as in the fourth embodiment, by being packaged as a semiconductor light emitting device package 350C to include a light source and a color conversion layer 3430, existing problems can be solved.

### <Fifth embodiment>

FIG. 27 is a plan view illustrating a semiconductor light emitting device package according to a fifth embodiment.

The fifth embodiment is the same as the first to fourth embodiments except for the reflective layer 3550 or the magnetic layer. In the fifth embodiment, the same reference numerals are given to components having the same structure, shape and/or function as those in the first to fourth embodiments, and detailed descriptions are omitted.

The fifth embodiment can also be applied to the second embodiment, the third embodiment, or the fourth embodiment.

Referring to FIGS. 10 and 27, the semiconductor light emitting device package 350D according to the fifth embodiment can comprise a first layer 3510, a common electrode wiring 352, and a plurality of semiconductor light emitting devices 351-1 to 351-3, a plurality of electrode pads 353-1 to 353-3, 354-1, and 354-2, a plurality of electrode wirings 355-1 to 355-3, a second layer 3520, and a reflective layer 3550. The semiconductor light emitting device package 350D according to the fifth embodiment can comprise more components than these.

A magnetic layer can be provided instead of the reflective layer 3550, or the reflective layer 3550 and the magnetic layer can be provided together.

The reflective layer 3550 can be disposed on a lower side of the first layer 3510. The reflective layer 3550 can contact the lower surface of the first layer 3510. The reflective layer 3550 can be disposed on the entire area of the lower surface of the first layer 3510.

The reflective layer 3550 can be disposed on a lower side of each of the first semiconductor light emitting device 351-1, the second semiconductor light emitting device 351-2, and the third semiconductor light emitting device 351-3. Accordingly, light of each of the first semiconductor light emitting device 351-1, the second semiconductor light emitting device 351-2, and the third semiconductor light emitting device 351-3 can be reflected by the reflective layer 3550 and travel forward, light efficiency and light luminance can be improved.

Meanwhile, instead of the reflective layer 3550, a magnetic layer can be disposed below the first layer 3510. That is, the magnetic layer 3550 can be disposed on the entire area of the lower surface of the first layer 3510.

As described above, since the area (or the size) of the magnetic layer 3550 can be maximized, the area magnetized by the magnet during self-assembly increases. Tus, the semiconductor light emitting device package 350D can be moved by quickly reflecting the movement of the magnet so that the assembly speed can be significantly increased.

### [Display device]

Various display devices will be described with reference to FIGS. 28 to 38. In the following description of the display device, reference numerals related to components not shown in FIGS. 28 to 38 refer to FIGS. 7 to 27.

### <First embodiment>

FIG. 28 is a plan view illustrating a display device according to a first embodiment. FIG. 29 is a cross-sectional view taken along the line F1-F2 in the display device according to the first embodiment of FIG. 28.

Referring to FIG. 28, the display device 300-1 according to the first embodiment can comprise a substrate 310, a barrier rib 340, a semiconductor light emitting device package 350, a first assembling wiring 321, and a second assembling wiring 322, a plurality of first signal lines SL-1 to SL4, and a plurality of second signal lines SL-1' to SL-4'. The display device 300-1 according to the first embodiment can comprise more components than these.

The barrier rib 340 can comprise a plurality of assembly holes 340H. At least one assembly hole 340H can be provided in each of the plurality of pixels PX. The assembly hole 340H can be a groove or a recess that goes into the inside.

Although the semiconductor light emitting device package (350 of FIGS. 9 to 22) according to the first embodiment described above is shown in the drawings, one semiconductor light emitting device package among the semiconductor light emitting device package (350A, 350B, 350C and 350D of FIGS. 23 to 27) according to the second to fifth embodiments can also be employed. Since the structure, shape and/or function of each semiconductor light emitting device package (350 of FIGS. 9 to 22) according to the first embodiment has been described in detail above, further description will be omitted.

The semiconductor light emitting device package 350 can comprise a plurality of semiconductor light emitting devices 351-1 to 351-3 capable of displaying images.

As shown in FIGS. 9 to 24, 26 and 27, the semiconductor light emitting device package 350can comprise three semiconductor light emitting devices constituting a unit pixel PX, that is, a first semiconductor light emitting device 351-1, a second semiconductor light emitting device 351-2 and a third semiconductor light emitting device 351-3. For example, the first semiconductor light emitting device 351-1 can be a blue semiconductor light emitting device, the second semiconductor light emitting device 351-2 can be a red semiconductor light emitting device, and the third semiconductor light emitting device 351-3 can be a green semiconductor light emitting device.

As shown in FIG. 24, the semiconductor light emitting device package 350B can comprise six semiconductor light emitting devices, that is, a first semiconductor light emitting device 351-1, a second semiconductor light emitting device 351-2, a third semiconductor light emitting device 351-3, a fourth semiconductor light emitting device 351-4, a fifth semiconductor light emitting device 351-5, and a sixth semiconductor light emitting device 351-6.

As an example, a first pixel PX1 can be constituted by the first semiconductor light emitting device 351-1, the second semiconductor light emitting device 351-2, and the third semiconductor light emitting device 351-3, and a second pixel PX2 can be constituted by the fourth semiconductor light emitting device 351-4, the fifth semiconductor light emitting device 351-5, and the sixth semiconductor light emitting device 351-6.

As another example, a first pixel PX1 can be constituted by the first semiconductor light emitting device 351-1, the second semiconductor light emitting device 351-2, and the third semiconductor light emitting device 351-3, and a redundancy pixel PX_R can be constituted by the semiconductor light emitting device 351-4, the fifth semiconductor light emitting device 351-5, and the sixth semiconductor light emitting device 351-6.

The semiconductor light emitting device package 350 can be disposed in an assembly hole 340H. For example, the semiconductor light emitting device package 350 can be assembled into the assembly hole 340H using a self-assembly process (FIG. 6).

A first assembling wiring 321 and a second assembling wiring 322 can be provided to pull the semiconductor light emitting device package 350 into the assembly hole 340H during self-assembly.

To this end, the first assembling wiring 321 can vertically overlap a first region 341-1 of the assembly hole 340H, and the second assembling wiring 322 can vertically overlap a second region 341-2 of the assembly hole 340H. The first assembling wiring 321 and the second assembling wiring 322 can be disposed on the same layer or on different layers.

During self-assembly, AC voltage can be applied to the first and second assembling wirings 321 and 322. A DEP force can be formed between the first assembling wiring 321 and the second assembling wiring 322 by the AC voltage applied to the first assembling wiring 321 and the second assembling wiring 322. The strength of the DEP force can increase as it is closer to the first assembling wiring 321 or the second assembling wiring 322, and can be greatest between the first assembling wiring 321 and the second assembling wiring 322. The strength of the DEP force can be large within the assembly hole 340H and small outside the assembly hole 340H.

When a magnet approaches the plurality of semiconductor light emitting device packages 350 during self-assembly, the magnetic layer 3550 of each of the plurality of semiconductor light emitting device packages 350 is magnetized by the magnet. Thus, when the magnet moves or rotates, the plurality of semiconductor light emitting device package 350 can also be moved or rotated.

Among the plurality of semiconductor light emitting device packages 350 being moved or rotated, the semiconductor light emitting device package 350 closest to the assembly hole 340H is more affected by the DEP force than other semiconductor light emitting device packages so that it can be assembled by pulling into the assembly hole 340H. Since the DEP force is continuously formed in the assembly hole 340H, the semiconductor light emitting device package 350 assembled into the assembly hole 340H can be fixed by the DEP force and does not come out of the assembly hole 340H, thereby preventing assembly defects.

The assembly hole 340H can have a shape corresponding to a shape of the semiconductor light emitting device package 350. In an embodiment, since the semiconductor light emitting device package 350 has an elliptical shape, the assembly hole 340H can also have an elliptical shape. At this time, a size of the assembly hole 340H is greater than a size of the semiconductor light emitting device package 350 so that the semiconductor light emitting device package 350 can be easily assembled into the assembly hole 340H during self-assembly.

Meanwhile, the plurality of semiconductor light emitting devices 351-1 to 351-3 can be electrically connected to a plurality of first signal lines SL-1 to SL-4 and/or a plurality of second signal lines SL-1' to SL-4'. After the semiconductor light emitting device package 350 is assembled into the assembly hole 340H, a process of connecting the plurality of first signal lines SL-1 to SL-4 and/or the plurality of second signal lines SL-1' to SL-4' to the plurality of semiconductor light emitting devices 351-1 to 351-3 of the semiconductor light emitting device package 350 can be performed.

The plurality of first signal lines SL-1 to SL-4 and the plurality of second signal lines SL-1' to SL-4' can be disposed around the assembly hole 340H or the semiconductor light emitting device package 350. The plurality of first signal lines SL-1 to SL-4 can be connected to the plurality of electrode pads 353-1 to 353-3, 354-1 and 354-2 provided in each of the plurality of pixels PX. The plurality of second signal lines SL-1' to SL-4' can be connected to the plurality of electrode pads 353-1 to 353-3, 354-1 and 354-2 provided in each of the plurality of pixels PX.

The plurality of first signal lines can comprise a first-first signal line SL-1, a first-second signal line SL-2, a first-third signal line SL-3 and a first-fourth signal line SL-4. The plurality of second signal lines can comprise a second-first signal line SL-1', a second-second signal line SL-2', a second-third signal line SL-3', and a second-fourth signal line SL-4'.

The first-first signal line SL-1, the first-second signal line SL-2, the first-third signal line SL-3 and the second-first signal line SL-1', the second-second signal line SL-2' and the second-third signal line SL-3' can be disposed parallel to each other. That is, the first-first signal line SL-1, the first-second signal line SL-2, the first-third signal line SL-3 and the second-first signal line SL-1', the second-second signal line SL-2' and the second-third signal line SL-3' can be disposed long along a second direction Y.

The first-fourth signal line SL-4 and the second-fourth signal line SL-4' can be disposed parallel to each other, and the first-first signal line SL-1, the first-second signal line SL-2, the first-third signal line SL-3 can crosse the second-first signal line SL-1', the second-second signal line SL-2' and the second-third signal line SL-3'. The first-fourth signal line SL-4 and the second-fourth signal line SL-4' can be long along a first direction X.

As shown in FIG. 29, the first-first signal line SL-1, the first-second signal line SL-2, the first-third signal line SL-3 and the first-fourth signal line SL-4 can be disposed on different layers from each other. In addition, the second-first signal line SL-1', the second-second signal line SL-2', the second-third signal line SL-3', and the second-fourth signal line SL- 4') can be disposed on different layers.

The first-fourth signal line SL-4 can be located higher than the first-first signal line SL-1, and the first-second signal line SL-2 can be located higher than the first-first signal line SL-1. The first-third signal line SL-3 can be located higher than the first-second signal line SL-2, and the first-fourth signal line SL-4 can be located higher than the first-third signal line SL-3. The second-fourth signal line SL-4' can be located higher than the second-first signal line SL-1', and the 2-2d signal line SL-2' can be located higher than the second-first signal line SL-1 '. The second-third signal line SL-3' is located higher than the second-second signal line SL-2', and the second-fourth signal line SL-4' can be located higher than the second-third signal line SL-3'.

Unlike this, the first-fourth signal line SL-4 and/or the second-fourth signal line SL-4' can be located higher than the connection lines 370-1 to 370-4 and 371-1 to 371-4. That is, another insulating layer is formed on the connection lines 370-1 to 370-4 and 371-1 to 371-4, and the first-fourth signal line SL-4 and the second-fourth signal line SL-4' can be formed on another insulating layer. In this case, the first-fourth signal line SL-4 and the second-fourth signal line SL-4' can be connected to one or more common electrode pads 354-1 and 354-2 by passing through another insulating layer.

The first-first signal line SL-1 and the second-first signal line SL-1' can be disposed on the same layer. The first-second signal line SL-2 and the second-second signal line SL-2' can be disposed on the same layer. The first-third signal line SL-3 and the second-third signal line SL-3' can be disposed on the same layer. The first-fourth signal line SL-4 and the second-fourth signal line SL-4' can be disposed on the same layer.

As shown in FIG. 28, the semiconductor light emitting device package 350 can be assembled into the assembly hole 340H in the normal position. In this case, the first-first signal line SL-1, the first-second signal line SL-2 and the first-third signal line SL-3 can be disposed adjacent to a second-first region 312-1 of an elliptical shape of the first layer 3510 of the semiconductor light emitting device package 350, and the first-fourth signal line SL-4 can be disposed adjacent to an elliptical shape of a second-third region 312-3 of the elliptical shape of the first layer 3510. The second-first signal line SL-1', the second-second signal line SL-2', and the second-third signal line SL-3' can be are disposed adjacent to a second-second region 312-2 of the elliptical shape of the first layer 3510, and the second-fourth signal line SL-4' can be disposed adjacent to a second-fourth region 312-4 of the elliptical shape of the first layer 3510.

Meanwhile, the first assembling wiring 321 can be included in at least one or more first signal line among the plurality of first signal lines SL-1 to SL-4. The second assembling wiring 322 can be included in at least one or more second signal line among the plurality of second signal lines SL-1' to SL-4'.

As shown in FIG. 29, the first assembling wiring 321 can be included in the first-first signal line SL-1, and the second assembling wiring 322 can be included in the second-first signal line SL-1'. The first assembling wiring 321 can extend from the first-first signal line SL-1 toward the assembly hole 340H and can be disposed below a first region of the assembly hole 340H. The second assembling wiring 322 can extend from the second-first signal line SL-1' toward the assembly hole 340H and can be disposed below a second region of the assembly hole 340H. The first assembling wiring 321 and the second assembling wiring 322 can be disposed to be spaced apart from each other below the assembly hole 340H. That is, the first assembling wiring 321 and the second assembling wiring 322 can be spaced apart from each other in a first insulating layer 330 corresponding to the assembly hole 340H.

The first-first signal line SL-1 and the first assembling wiring 321 can be integrally formed. That is, the first-first signal line SL-1 and the first assembling wiring 321 can be simultaneously formed of the same metal using the same process. The second-first signal line SL-1' and the second assembling wiring 322 can be integrally formed. That is, the second-first signal line SL-1' and the second assembling wiring 322 can be simultaneously formed of the same metal using the same process.

During self-assembly, an AC voltage can be applied to the first-first signal line SL-1 and the second-first signal line SL-1'. In this case, a DEP force can be formed in the assembly hole 340H in which the first assembling wiring 321 extending from the first-first signal line SL-1 and the second assembling wiring 322 extending from the second-first signal line SL-1' are positioned. The semiconductor light emitting device package 350 can be assembled into the assembly hole 340H by the DEP force formed in the assembly hole 340H.

Thereafter, the first-first signal line SL-1, the first-second signal line SL-2, and the first-third signal line SL-3 can be respectively connected to the first data line, the second data line, and the third data line via the scan transistor ST and the driving transistor DT through the post-process. In addition, the second-first signal line SL-1', the second-second signal line SL-2', and the second-third signal line SL-3' can be connected to another first data line, second data line, and third data line via another scan transistor ST and another driving transistor DT. In addition, each of the first-first signal line SL-1, the first-second signal line SL-2 and the first-third signal line SL-3 and each of the second-first signal line SL-1 ', the second-second signal line SL-2' and the second-third signal line SL-3' can be connected to the semiconductor light emitting device package 350.

When driving the display, a predetermined current can flow through each of the driving transistor DT connected to the first data line, the driving transistor DT connected to the second data line, and the driving transistor DT connected to the third data line by a first data voltage, a second data voltage, and a third data voltage supplied to the first data line, the second data line, and the third data line, respectively. Corresponding currents can be supplied to the first semiconductor light emitting device 351-1, the second semiconductor light emitting device 351-2, and the third semiconductor light emitting device 351-3, respectively, constituting the pixel PX of the semiconductor light emitting device package 350 through the first-first signal line SL-1, first-second signal line SL-2 and first-third signal line SL-3. Accordingly, each of the first semiconductor light emitting device 351-1, the second semiconductor light emitting device 351-2, and the third semiconductor light emitting device 351-3 can emit light having a luminance corresponding to the corresponding current.

Referring to FIG. 28, the semiconductor light emitting device package 350 can comprise a first semiconductor light emitting device 351-1, a second semiconductor light emitting device 351-2, and a third semiconductor light emitting device 351-3 constituting the pixel PX. The semiconductor light emitting device package 350 can comprise a first electrode pad 353-1 connecting the first semiconductor light emitting device 351-1, a second electrode pad 353-2 connecting the second semiconductor light emitting device 351-2, and a third electrode pad 353-3 connecting the third semiconductor light emitting device 351-3. The first electrode pad 353-1 and the third electrode pad 353-3 can be disposed on a second-first region of an elliptical shape of a first layer 3510, and the second electrode pad 353 -2 can be disposed on a second-second region 312-2 of the elliptical shape of the first layer 3510.

Meanwhile, the display device 300-1 according to the first embodiment can comprise a plurality of first connection lines 370-1 to 370-4 and a plurality of second connection lines 371-1 to 371-4.

The plurality of first connection lines 370-1 to 370-4 can connect the plurality of first signal lines SL-1 to SL-4 to corresponding electrode pads 353-1 to 353-3, 354-1, and 354-2 provided on the semiconductor light emitting device package 350. When the corresponding electrode pads 353-1 to 353-3, 354-1, and 354-2 are not provided on the semiconductor light emitting device package 350, the corresponding first connection lines 370-1 to 370-4 cannot be connected to the electrode pads 353-1 to 353-3, 354-1, and 354-2. The plurality of second connection lines 371-1 to 371-4 can connect include the plurality of second signal lines SL-1' to SL-4' to corresponding electrode pads 353-1 to 353-3, 354-1, and 354-2 provided on the semiconductor light emitting device package 350. When corresponding electrode pads 353-1 to 353-3, 354-1, and 354-2 are not provided on the semiconductor light emitting device package 350, the corresponding second connection lines 371-1 to 371-4 cannot be not connected to the electrode pads 353-1 to 353-3, 354-1, and 354-2.

Specifically, the plurality of first connection lines can comprise a 1-1 connection line 370-1, a 1-2 connection line 170-2, a 1-3 connection line 170-3, and a 1-4 connection line. The plurality of second connection lines can comprise a 2-1 connection line 171-1, a 2-2 connection line 171-2, a 2-3 connection line 171-3 and a 2-4 connection line 171-4.

The first-first signal line SL-1 or the second-first signal line SL-1' can be connected to the first semiconductor light emitting device 351-1 on the semiconductor light emitting device package 350. The first electrode pad 353-1 connected to the first semiconductor light emitting device 351-1 through the first electrode wiring 355-1 can be disposed on a second-first region of an elliptical shape of the first layer 3510. In this case, when the semiconductor light emitting device package 350 is assembled into the assembly hole 340H in the normal position during self-assembly, the first electrode pad 353-1 disposed on the second-first region of the elliptical shape of the first layer 3510 can be connected to the first-first signal line SL-1 through the 1-1 connection line 370-1. During self-assembly, when the semiconductor light emitting device package 350 is assembled into the assembly hole 340H while being rotated by 180° relative to the normal position, the first electrode pad 353-1 disposed on the second-first region of the elliptical shape of the first layer 3510 can be connected to the second-first signal line SL-1' through the 2-1 connection line 371-1.

The first-second signal line SL-2 or the second-second signal line SL-2' can be connected to the second semiconductor light emitting device 351-2 on the semiconductor light emitting device package 350. The second electrode pad 353-2 connected to the second semiconductor light emitting device 351-2 through the second electrode wiring 355-2 can be disposed on a second-second region of the elliptical shape of the first layer 3510. In this case, when the semiconductor light emitting device package 350 is assembled into the assembly hole 340H in the normal position during self-assembly, the second electrode pad 353-2 disposed on the second-second region 312-2 of the elliptical shape of the first layer 3510 can be connected to the second-second signal line SL-2 through the 2-2 connection line 371-2. During self-assembly, when the semiconductor light emitting device package 350 is assembled into the assembly hole 340H while being rotated by 180° relative to the normal position, the second electrode pad 353-2 disposed on the second-second region 312-2 of the elliptical shape of the first layer 3510 can be connected to the first-second signal line SL-2 through the 1-2 connection line 370-2.

The first-third signal line SL-3 or the second-third signal line SL-3 ' can be connected to the third semiconductor light emitting device 351-3 on the semiconductor light emitting device package 350. The third electrode pad 353-3 connected to the third semiconductor light emitting device 351-3 through the third electrode wiring 355-3 can be disposed on a second-first region 312-1 of the elliptical shape of the first layer 3510.

When the semiconductor light emitting device package 350 is properly assembled into the assembly hole 340H during self-assembly, the third electrode pad 353-3 disposed on the second-first region 312-1 of the elliptical shape of the first layer 3510 can be connected to the first-third signal line SL-3 through the 1-3 connection line 370-3. During self-assembly, when the semiconductor light emitting device package 350 is assembled into the assembly hole 340H while being rotated by 180° relative to the normal position, the third electrode pad 353-3 disposed on the second-first region 312-1 of the elliptical shape of the first layer 3510 can be connected to the second-third signal line SL-3' through the 2-3 connection line 371-3.

The first-fourth signal line SL-4 or the second-fourth signal line SL-4' can be commonly connected to the first semiconductor light emitting device 351-1, the second semiconductor light emitting device 351-2 and the third semiconductor light emitting device 351-3 on the semiconductor light emitting device package 350. The first semiconductor light emitting device 351-1, the second semiconductor light emitting device 351-2, and the third semiconductor light emitting device 351-3 can be commonly connected to a common electrode wiring 352.

One side or both sides of the common electrode wiring 352 can extend along the major axis direction of the elliptical shape of the first layer 3510 and can be disposed on the second-third region 312-3 and/or the second-fourth region 312-4. At least one or more common electrode pads 354-1 and 354-2 can be disposed on the second-third region 312-3 and/or the second-fourth region 312-4. Accordingly, the at least one or more common electrode pads 354 - 1 and 354 - 2 can be connected to the common electrode wiring 352. The common electrode pad can comprise a first common electrode pad 354-1 and a second common electrode pad 354-2.

The first common electrode pad 354 - 1 can be disposed on a second-third region 312 - 3 of the elliptical shape of the first layer 3510. The second common electrode pad 354 - 2 can be disposed on a second-fourth region 312 - 4 of the elliptical shape of the first layer 3510. In this case, when the semiconductor light emitting device package 350 is assembled into the assembly hole 340H in the normal position during self-assembly, the first common electrode pad 354-1 disposed on the second-third region 312 - 3 of the elliptical shape of the first layer 3510 can be connected to the first-fourth signal line SL-4 through the 1-4 connection line 370-4. When the semiconductor light emitting device package 350 is assembled into the assembly hole 340H in the normal position during self-assembly, the second common electrode pad 354-2 disposed on the second-fourth region 312 - 4 of the elliptical shape of the first layer 3510 can be connected to the second-fourth signal line SL-4' through the 2-4 connection line 371-4.

During self-assembly, when the semiconductor light emitting device package 350 is assembled into the assembly hole 340H while being rotated by 180° relative to the normal position, the first common electrode pad 354-1 disposed on the second-third region 312 - 3 of the elliptical shape of the first layer 3510 can be connected to the second-fourth signal line SL-4' through the 2-4 connection line 371-4. During self-assembly, when the semiconductor light emitting device package 350 is assembled into the assembly hole 340H while being rotated by 180° relative to the normal position, the second common electrode pad 354-2 disposed on the second-fourth region 312 - 4 of the elliptical shape of the first layer 3510 can be connected to the first-fourth signal line SL-4 through the 1-4 connection line 370-4.

Although not shown, the first assembling wiring 321 can be included in the first-second signal line SL-2 or the first-third signal line SL-3, and the second assembling wiring 322 can be included in the second-second signal line SL-2' or the second-third signal line SL-3'.

According to the first embodiment, the first assembling wiring 321 can be included in at least one or more first signal line among the plurality of first signal lines SL-1 to SL-4, and the second assembling wiring 322 can be included in at least one or more second signal line among the plurality of second signal lines SL -1' to SL-4'. Accordingly, since there is no need to separately form the first assembling wiring 321 or the second assembling wiring 322, the structure can be simple and the process can be drastically reduced.

Meanwhile, the display device 300-1 according to the first embodiment can comprise a first insulating layer 330 and a second insulating layer 360.

The first insulating layer 330 can be disposed between the substrate 310 and the barrier rib 340. The first insulating layer 330 can insulate between the plurality of first signal lines SL-1 to SL-4. The first insulating layer 330 can insulate between the plurality of second signal lines SL-1' to SL-4'. To this end, the first insulating layer 330 can comprise a first-first insulating layer 330-1, a first-second insulating layer 330-2, a first-third insulating layer 330-3, and a first-first insulating layer 330-4. The first-first insulating layer 330-1, the first-second insulating layer 330-2, the first-third insulating layer 330-3, and the first-fourth insulating layer 330-4 are the same insulating material, but are not limited thereto.

The first-first insulating layer 330-1 can be disposed on the substrate 310 to insulate the first-fourth signal line SL-4 from the second-fourth signal line SL-4'. The first-second insulating layer 330-2 can be disposed on the first-first insulating layer 330-1 to insulate the first-third signal line SL-3 from the second-third signal line SL-3 '. The first-third insulating layer 330-3 can be disposed on the first-second insulating layer 330-2 to insulate the first-second signal line SL-2 from the second-second signal line SL-2 '.

The first-fourth insulating layer 330-4 can be disposed on the first-third insulating layer 330-3 to insulate the first-first signal line SL-1 from the second-first signal line SL-1 '. The first-fourth insulating layer 330-4 can insulate the first assembling wiring 321 extending from the first-first signal line SL-1 from the second assembling wiring 322 extending from the second-first signal line SL-1'. The first-fourth insulating layer 330-4 can be formed of an insulating material having a permittivity that affects the strength of the DEP force.

Meanwhile, the second insulating layer 360 can be a planarization layer. Accordingly, an upper surface of the second insulating layer 360 can have a horizontal surface. The second insulating layer 360 can be disposed on the barrier rib 340. The second insulating layer 360 can be disposed on the semiconductor light emitting device package 350. The second insulating layer 360 can be disposed around the semiconductor light emitting device package 350 in the assembly hole 340H.

As shown in FIG. 29, one side region of the 1-1 connection line 370-1 can be connected to the first-first signal line SL-1 by passing through the second insulating layer 360 and the barrier rib 340. The other side region of the 1-1 connection line 370-1 can be connected to the second electrode wiring 355-1 (or the first electrode pad 353-1) on the semiconductor light emitting device package 350 by passing through the second insulating layer 360. One side region of the 2-1 connection line 371-1 can be connected to the second-first signal line SL-1' by passing through the second insulating layer 360 and the barrier rib 340. The other side region of the 2-1 connection line 371-1 can be disposed on the second insulating layer 360 on the semiconductor light emitting device package 350. That is, the other region of the 2-1 connection line 371-1 cannot be connected to any of the electrode wirings 355-1 to 355-3 (or electrode pads 353-1 to 353-3, 354-1, and 354-2). This means that the second-first signal line SL-1' cannot be connected to the semiconductor light emitting devices 351-1 to 351-3 on the semiconductor light emitting device package 350.

Although not shown, one side region of the 1-2 connection line 370-2 can be connected to the first-second signal line SL-2 by passing through the second insulating layer 360, the barrier rib 340, the first-fourth insulating layer 330-4 and the first-third insulating layer 330-3 of the first insulating layer 330. The other side region of the 1-2 connection line 370 - 2 can be disposed on the second insulating layer 360 on the semiconductor light emitting device package 350. One side region of the 2-2 connection line 371-2 can be connected to the second-second signal line SL-2' by passing through the second insulating layer 360, the barrier rib 340, the 1st-4th insulating layer 330-4 and the first-third insulating layer 330-3 of the first insulating layer 330. The other side region of the 2-2 connection line 371-2 can be connected to the second electrode wiring 355-2 (or the second electrode pad 353-2) on the semiconductor light emitting device package 350 by passing through the second insulating layer 360.

In addition, although not shown, one side region of the 1-3 connection line 370-3 can be connected to the first-third signal line SL-3 by passing through the second insulating layer 360, the barrier rib 340, the first-fourth insulating layer 330 and the first-second insulating layer 330-2of the first insulating layer 330. The other side region of the 1st-3rd connection line 370-3 can be connected to the third electrode wiring 355-3 (or third electrode pad 353) on the semiconductor light emitting device package 350 by passing through the second insulating layer 360. One side region of the 2-3 connection line 371-3 can be connected to the second-third signal line SL-3' by passing through the second insulating layer 360, the barrier rib 340, the 1st-4th insulating layer 330-4, the first-third insulating layer 330-3 and the first-second insulating layer 330-2 of the first insulating layer 330. The other side region of the 2-3 connection line 371-3 can be disposed on the second insulating layer 360 on the semiconductor light emitting device package 350.

In addition, although not shown, one side region of the 1-4 connection line 370-4 can be connected to the first-fourth signal line SL-4 by passing through the second insulating layer 360, the barrier rib 340, the first-fourth connection line 370-4, the first-third insulating layer 330-3, the first-second insulating layer 330-2 and the first-first insulating layer 330-1 of the first insulating layer 330. The other side region of the 1-4 connection line 370 - 4 can be connected the first common electrode pad 354-1 on the semiconductor light emitting device package 350. One side region of the 2-4 connection line 371-4 can be connected to the second-fourth signal line SL-4' by passing through the second insulating layer 360, the barrier rib 340, the first-fourth insulating layer 330-4, the first-third insulating layer 330-3, the first-second insulating layer 330-2, and the first-first insulating layer 330-1 of the first insulating layer 330. The other side of the 2-4 connection line 371 - 4 can be connected to the second common electrode pad 354 - 2 on the semiconductor light emitting device package 350. The first common electrode pad 354 - 1 and the second common electrode pad 354 - 2 can be connected to the common electrode wiring 352.

Meanwhile, FIG. 29 shows a view in which the first assembling wiring 321 and the second assembling wiring 322 are disposed on the same layer. Alternatively, the first assembling wiring 321 and the second assembling wiring 322 can be disposed on different layers, which will be described with reference to FIG. 30 below.

FIG. 30 is another cross-sectional view taken along the line F1-F2 in the display device according to the first embodiment of FIG. 28.

As shown in FIG. 30, the first-first signal line SL-1, the first-second signal line SL-2, the first-third signal line SL-3 and the first-fourth signal line SL-4 can be disposed on different layers from each other. In addition, the second-first signal line SL-1', the second-second signal line SL-2', the second-third signal line SL-3', and the second-fourth signal line SL- 4' can be disposed on different layers from each other.

The first-fourth signal line SL-4 can be located higher than the first-first signal line SL-1, and the first-second signal line SL-2 can be located higher than the first-first signal line SL-1. The first-third signal line SL-3 can be located higher than the first-second signal line SL-2, and the first-fourth signal line SL-4 can be located higher than the first-third signal line SL-3. The second-fourth signal line SL-4' can be located higher than the second-first signal line SL-1', and the second-second signal line SL-2' can be located higher than the second-first signal line SL-1 '. The second-third signal line SL-3' is positioned higher than the second-second signal line SL-2', and the second-fourth signal line SL-4' can be located higher than the second-third signal line SL-3'.

The first-first signal line SL-1 and the second-first signal line SL-1' can bee disposed on the same layer, and the first-second signal line SL-2 and the second-second signal line SL-2' can be disposed on the same layer, the first-third signal line SL-3 and the second-third signal line SL-3' can be disposed on the same layer, and the first-fourth signal line SL-4 and the second-fourth signal line SL-4' can be disposed on the same layer.

Meanwhile, the first assembling wiring 321 can be included in the first-first signal line SL-1, and the second assembling wiring 322 can be included in the second-second signal line SL-2'. For example, the first assembling wiring 321 is disposed between the first-third insulating layer 330-3 and the first-fourth insulating layer 330-4 of the first insulating layer 330, and the second assembling wiring 322 can be disposed between the first-second insulating layers 330 - 2 and the first-third insulating layers 330 - 3 of the first insulating layer 330. Accordingly, the first assembling wiring 321 and the second assembling wiring 322 can be disposed on different layers.

The first assembling wiring 321 can extend from the first-first signal line SL-1 toward the assembly hole 340H and can be disposed below a first region of the assembly hole 340H. The second assembling wiring 322 extends from the second-second signal line SL-2' toward the assembly hole 340H and can be disposed below the second region of the assembly hole 340H. The first assembling wiring 321 and the second assembling wiring 322 can be disposed to be spaced apart from each other below the assembly hole 340H.

The first-first signal line SL-1 and the first assembling wiring 321 can be integrally formed. That is, the first-first signal line SL-1 and the first assembling wiring 321 can be simultaneously formed of the same metal using the same process. The second-second signal line SL-2' and the second assembling wiring 322 can be integrally formed. That is, the second-second signal line SL-2' and the second assembling wiring 322 can be simultaneously formed of the same metal using the same process.

Although not shown, the first assembling wiring 321 can be included in the first-second signal line SL-2 or the first-third signal line SL-3, and the second assembling wiring 322 can be included in the second-first signal line 1 SL-1' or signal line second-third signal line SL-3'. When the first assembling wiring 321 is included in the first-second signal line SL-2, the second assembling wiring 322 can be included in the second-first signal line SL-2 or the second-third signal line SL-3' to be disposed on a different layer from the first assembling wiring 321. When the first assembling wiring 321 is included in the first-third signal line SL-3, the second assembling wiring 322 can be included in the second-first signal line SL-1' or the second-second signal line SL-2' to be disposed a different layer from the first assembling wiring 321.

### <Second embodiment>

FIG. 31 is a plan view illustrating a display device according to a second embodiment.

The second embodiment is the same as the first embodiment except for the arrangement shape of the first assembling wiring 321 and the second assembling wiring 322. In the second embodiment, components having the same structure, shape, and/or function as those in the first embodiment are given the same reference numerals, and detailed descriptions are omitted.

Although a cross-sectional view of the display device 300-2 according to the second embodiment is not shown, it is similar to the cross-sectional view (FIGS. 29 and 30) of the display device 300-1 according to the first embodiment. Thus, reference can be made to FIGS. 29 and 30 in the following description.

Referring to FIG. 31, the display device 300-2 according to the second embodiment can comprise a substrate 310, a first insulating layer 330, a barrier rib 340, a semiconductor light emitting device package 350, a first assembling wiring 321, a second assembling wiring 322, a plurality of first signal lines SL-1 to SL4, a plurality of second signal lines SL-1' to SL-4', and a second insulating layer 360. The display device 300-2 according to the second embodiment can comprise more components than these.

Although the semiconductor light emitting device package (350 of FIGS. 9 to 22) according to the first embodiment described above is shown in the drawings, one semiconductor light emitting device package among the semiconductor light emitting device package (350A, 350B, 350C and 350D of FIGS. 23 to 27) according to the second to fifth embodiments can also be employed. Since the structure, shape and/or function of each semiconductor light emitting device package (350 of FIGS. 9 to 22) according to the first embodiment has been described in detail above, further description will be omitted.

In the display device according to the first embodiment (300-1 in FIGS. 28 to 30), the first assembling wiring 321 and the second assembling wiring 322 can be disposed to face each other along a first direction X.

In contrast, in the display device 300-2 according to the second embodiment, the first assembling wiring 321 and the second assembling wiring 322 can be disposed to face each other along a second direction Y.

For example, the first assembling wiring 321 can extend from the first-first signal line SL- 1 along the first direction X and is disposed in a first region 342-1 of the assembly hole 340H. That is, the first assembling wiring 321 can vertically overlap the first region of the assembly hole 340H. For example, the second assembling wiring 322 can extend from the second-first signal line SL-1' along the first direction X and is disposed in a second region 342-2 of the assembly hole 340H. That is, the second assembling wiring 322 can vertically overlap the second region of the assembly hole 340H. The first region of the assembly hole 340H and the second region of the assembly hole 340H can be located along the second direction Y. In this case, in the assembly hole 340H, the first assembling wiring 321 and the second assembling wiring 322 can be disposed to face each other along the second direction Y.

### <Third embodiment>

FIG. 32 is a plan view illustrating a display device according to a third embodiment.

The third embodiment is the same as the first embodiment or the second embodiment except that the first assembling wiring 321 and the second assembling wiring 322 are respectively included in the first-fourth signal line SL-4 and the second-fourth signal line SL-4'. In the third embodiment, components having the same structure, shape, and/or function as those in the first embodiment or the second embodiment are given the same reference numerals, and detailed descriptions are omitted.

Although a cross-sectional view of the display device 300-3 according to the third embodiment is not shown, it is similar to the cross-sectional view (FIGS. 29 and 30) of the display device 300-1 according to the first embodiment. Thus, reference can be made to FIGS. 29 and 30 in the following description.

Referring to FIG. 32, the display device 300-3 according to a third embodiment can comprise a substrate 310, a first insulating layer 330, a barrier rib 340, a semiconductor light emitting device package 350, a first assembling wiring 321, a second assembling wiring 322, a plurality of first signal lines SL-1 to SL4, a plurality of second signal lines SL-1' to SL-4', and a second insulating layer 360. The display device 300-3 according to the third embodiment can comprise more components than these.

Although the semiconductor light emitting device package (350 of FIGS. 9 to 22) according to the first embodiment described above is shown in the drawings, one semiconductor light emitting device package among the semiconductor light emitting device package (350A, 350B, 350C and 350D of FIGS. 23 to 27) according to the second to fifth embodiments can also be employed. Since the structure, shape and/or function of each semiconductor light emitting device package (350 of FIGS. 9 to 22) according to the first embodiment has been described in detail above, further description will be omitted.

The first assembling wiring 321 can be included in a first-fourth signal line SL-4, and the second assembling wiring 322 can be included in a second-fourth signal line SL-4'.

The first assembling wiring 321 can extend from the first-fourth signal line SL-4 toward an assembly hole 340H and can be disposed below a first region 342-1 of the assembly hole 340H. The second assembling wiring 322 can extend from the second-fourth signal line SL-4' toward the assembly hole 340H and can be disposed below a second region 342-2 of the assembly hole 340H. The first region and the second region of the assembly hole 340H can be located along the second direction Y. The first assembling wiring 321 and the second assembling wiring 322 can be disposed to be spaced apart from each other below the assembly hole 340H.

The first-fourth signal line SL-4 and the first assembling wiring 321 can be integrally formed. That is, the first-fourth signal line SL- 4 and the first assembling wiring 321 can be simultaneously formed of the same metal using the same process. The second-fourth signal line SL-4' and the second assembling wiring 322 can be integrally formed. That is, the second-fourth signal line SL-4' and the second assembling wiring 322 can be simultaneously formed of the same metal using the same process.

Referring to FIGS. 29, 30, and 32, one side region of a 1-4 connection line 370-4 can be connected to a first-fourth signal line SL-4 through the second insulating layer 360, the barrier rib 340, and a first-fourth insulating layer 330-4, the first-third insulating layer 330-3, a first-third insulating layer 220-3, a first-second insulating layer 330-2 and a first-first insulating layer 330-1. The other side region of the 1-4 connection line 370-4 can be connected to a first common electrode pad 354-1 on the semiconductor light emitting device package 350 through the second insulating layer 360.

One side region of a 2-4 connection line 371-4 can be connected to a second-fourth signal line SL-4 ' through the second insulating layer 360, the barrier rib 340, and a first-fourth insulating layer 330-4 of the first insulating layer 330, a first-third insulating layer 330-3, and a first-second insulating layer 330, and a first-first insulating layer 330-1. The other side region of the 2-4 connection line 371-4 can be connected to a second common electrode pad 354-2 on the semiconductor light emitting device package 350 through the second insulating layer 360.

### <Fourth embodiment>

FIG. 33 is a plan view illustrating a display device according to a fourth embodiment.

The fourth embodiment is the same as the third embodiment except for the arrangement shape of the first assembling wiring 321 and the second assembling wiring 322. In the fourth embodiment, components having the same structure, shape, and/or function as those in the third embodiment are given the same reference numerals, and detailed descriptions are omitted.

Although a cross-sectional view of the display device 300-4 according to the fourth embodiment is not shown, it is similar to the cross-sectional view (FIGS. 29 and 30) of the display device 300-1 according to the first embodiment. Thus, reference can be made to FIGS. 29 and 30 in the following description.

Referring to FIG. 33, the display device 300-4 according to a fourth embodiment can comprise a substrate 310, a first insulating layer 330, a barrier rib 340, a semiconductor light emitting device package 350, a first assembling wiring 321, a second assembling wiring 322, a plurality of first signal lines SL-1 to SL4, a plurality of second signal lines SL-1' to SL-4', and a second insulating layer 360. The display device 300-4 according to the fourth embodiment can comprise more components than these.

Although the semiconductor light emitting device package (350 of FIGS. 9 to 22) according to the first embodiment described above is shown in the drawings, one semiconductor light emitting device package among the semiconductor light emitting device package (350A, 350B, 350C and 350D of FIGS. 23 to 27) according to the second to fifth embodiments can also be employed. Since the structure, shape and/or function of each semiconductor light emitting device package (350 of FIGS. 9 to 22) according to the first embodiment has been described in detail above, further description will be omitted.

In the display device (300-3 in FIG. 32) according to the third embodiment, the first assembling wiring 321 and the second assembling wiring 322 can be disposed to face each other along a second direction Y.

In contrast, in the display device 300-4 according to the fourth embodiment, the first assembling wiring 321 and the second assembling wiring 322 can be disposed to face each other along a first direction X.

For example, the first assembling wiring 321 can extend from a first-fourth signal line SL-4 along the second direction Y and can be disposed in a first region 341-1 of the assembly hole 340H. That is, the first assembling wiring 321 can vertically overlap the first region of the assembly hole 340H. For example, the second assembling wiring 322 can extend from a second-fourth signal line SL-4' along the second direction Y and can be disposed in a second region 341-2 of the assembly hole 340H. That is, the second assembling wiring 322 can vertically overlap the second region 341 - 2 of the assembly hole 340H. The first region of the assembly hole 340H and the second region of the assembly hole 340H can be located along the first direction X. In this case, in the assembly hole 340H, the first assembling wiring 321 and the second assembling wiring 322 can be disposed to face each other along the first direction X.

### <Fifth embodiment>

FIG. 34 is a plan view illustrating a display device according to a fifth embodiment.

The fifth embodiment is the same as the first second embodiment or the second embodiment except that a plurality of first assembling wirings 321-1 to 321-3 and a plurality of second assembling wirings 322-1 to 322-3 are respectively provided. In the fifth embodiment, components having the same structure, shape, and/or function as those in the first to fourth embodiments are given the same reference numerals, and detailed descriptions are omitted.

Although a cross-sectional view of the display device 300-5 according to the fifth embodiment is not shown, it is similar to the cross-sectional view (FIGS. 29 and 30) of the display device 300-1 according to the first embodiment. Thus, reference can be made to FIGS. 29 and 30 in the following description.

Referring to FIG. 34, the display device 300-5 according to the fifth embodiment can comprise a substrate 310, a first insulating layer 330, a barrier rib 340, a semiconductor light emitting device package 350, a first assembling wiring 321-1 to 321-3, a second assembling wiring 322-1 to 322-3, a plurality of first signal lines SL-1 to SL4, a plurality of second signal lines SL-1' to SL-4' and a second insulating layer 360. The display device 300-5 according to the fifth embodiment can comprise more components than these.

Although the semiconductor light emitting device package (350 of FIGS. 9 to 22) according to the first embodiment described above is shown in the drawings, one semiconductor light emitting device package among the semiconductor light emitting device package (350A, 350B, 350C and 350D of FIGS. 23 to 27) according to the second to fifth embodiments can also be employed. Since the structure, shape and/or function of each semiconductor light emitting device package (350 of FIGS. 9 to 22) according to the first embodiment has been described in detail above, further description will be omitted.

The first assembling wiring can comprise a first-first assembling wiring 321-1, a first-second assembling wiring 321-2, and a first-third assembling wiring 321-3, but be provided with the number smaller or smaller or larger than these.

The first-first assembling wiring 321-1 can extend from a first-first signal line SL-1 toward a first-first region 343-1 of the assembly hole 340H and can be located in the first-first region 343-1 of the assembly hole 340H. The assembling wiring 321-1 can vertically overlap the first-first region 343-1 of the assembly hole 340H. The first-second assembling wiring 321-2 can extend from a first-second signal line SL-2 toward a first-second region 343-2 of the assembly hole 340H and can be located in the first-second region 343-2 of the assembly hole 340H. The first-second assembling wiring 321-2 can vertically overlap the first-second region 343-2 of the assembly hole 340H. The first-third assembling wiring 321-3 can extend from a first-third signal line SL-3 toward a first-third region 343-3 of the assembly hole 340H and can be located in the first-third region 343-3 of the assembly hole 340H. The first-third assembling wiring 321-3 can vertically overlap the first-third region 343-3 of assembly hole 340H.

The first-first assembling wiring 321-1, the first-second assembling wiring 321-2, and the first-third assembling wiring 321-3 can be disposed parallel to each other, but are not limited thereto.

The strength of the DEP force formed in the assembly hole 340H can vary depending on the structure of the assembly hole 340H. In consideration of this, the widths of each of the first-first assembling wiring 321-1, first-second assembling wiring 321-2, and first-third assembling wiring 321-3 can be varied.

For example, the width of the first-first assembling wiring 321-1 or the first-third assembling wiring 321-3 can be greater than the width of the first-second assembling wiring 321-2. Alternatively, each of the first-first assembling wiring 321-1, first-second assembling wiring 321-2, and first-third assembling wiring 321-3 can have the same width.

Meanwhile, the second assembling wiring can comprise a second-first assembling wiring 322-1, a second-second assembling wiring 322-2, and a second-third assembling wiring 322-3, but be provided with the number smaller or smaller or larger than these.

The second-first assembling wiring 322-1 can extend from a second-first signal line SL-1' toward a second-third region 344-3 of the assembly hole 340H and can be located in the second-third region 344-3 of the assembly hole 340H. The second-first assembling wiring 322-1 can vertically overlap the second-third region 344-3 of the assembly hole 340H. The second-second assembling wiring 322-2 can extend from a second-second signal line SL-2' toward a second-second region 344-2 of the assembly hole 340H and can be located in the second-second region 344-2 of the assembly hole 340H. The second-second assembling wiring 322-2 can vertically overlap the second-second region 344-2 of the assembly hole 340H. The second-third assembling wiring 322-3 can extend from a second-third signal line SL-3' toward a second-first region 344-1 of the assembly hole 340H and can be located in the second-first region 344-1 of the assembly hole 340H. The second-third assembling wiring 322-3 can vertically overlap the second-first region 344-1 of the assembly hole 340H.

The second-first assembling wiring 322-1, the second-second assembling wiring 322-2, and the second-third assembling wiring 322-3 can be disposed parallel to each other, but are not limited thereto.

The strength of the DEP force formed in the assembly hole 340H can vary depending on the structure of the assembly hole 340H. In consideration of this, the widths of each of the second-first assembling wiring 322-1, the second-second assembling wiring 322-2, and the second-third assembling wiring 322-3 can be varied.

For example, the width of the second-first assembling wiring 322-1 or the second-third assembling wiring 322-3 can be greater than the width of the second-second assembling wiring 322-2. Alternatively, each of the second-first assembling wiring 322-1, second-second assembling wiring 322-2, and second-third assembling wiring 322-3 can have the same width.

The first-first region 343-1, the first-second region 343-2, and the first-third region 343-3 of the assembly hole 340H can be located along the second direction Y, and the first-second region 343-2 can be located between the first-first region 343-1 and the first-third region 343-3. The second-first region 312-1, the second-second region 312-2 and the second-third region 312-3 of the assembly hole 340H can be located along the second direction Y, and the second-second region 312-2 can be located between the second-first region 312-1 and the second-third region 312-3.

The first-first assembling wiring 321-1 and the second-first assembling wiring 322-1 facing each other can have the same width. The first-second assembling wiring 321-2 and the second-second assembling wiring 322-2 facing each other can have the same width. The first-third assembling wirings 321-3 and the second-third assembling wirings 322-3 facing each other can have the same width.

Meanwhile, the first-first assembling wiring 321-1 and the second-third assembling wiring 322-3 can be disposed to face each other along the first direction X in the assembly hole 340H. The first-second assembling wiring 321 - 2 and the second-second assembling wiring 322 - 2 can be disposed to face each other along the first direction X in the assembly hole 340H. The first-third assembling wiring 321-3 and the second-first assembling wiring 322-1 can be disposed to face each other along the first direction X in the assembly hole 340H. In addition, the first-first assembling wiring 321-1 and the second-first assembling wiring 322-1 can be symmetrical in the diagonal direction with respect to the center of the assembly hole 340H, and the first-third assembling wiring 321 -3 and the second-third assembling wirings 322-3 can be symmetrical in a diagonal direction with respect to the center of the assembly hole 340H.

According to the fifth embodiment, various DEP forces can be formed between the plurality of first assembling wirings 321-1 to 321-3 and the plurality of second assembling wirings 322-1 to 322-3. For example, the first-first assembling wiring 321-1 can be formed with a 1-1 DEP force, a 1-2 DEP force, and a 1-3 DEP force between the second-first assembling wiring 322-1, the second-second assembling wiring 322-2, and the second-third assembling wiring 322-3, respectively.

Accordingly, a large and uniform DEP force is formed in the assembly hole 340H. Thus, even if the size of the semiconductor light emitting device package 350 is larger than the size of individual semiconductor light emitting devices, it can be easily assembled into the assembly hole 340H.

### <Sixth embodiment>

FIG. 35 is a plan view illustrating a display device according to a sixth embodiment.

The sixth embodiment is the same as the fifth embodiment except that a plurality of first assembling wirings 321-1 to 321-3 and a plurality of second assembling wirings 322-1 to 322-3 are respectively provided and are respectively disposed on different layers. In the sixth embodiment, components having the same structure, shape, and/or function as those in the fifth embodiment are given the same reference numerals, and detailed descriptions are omitted.

Although a cross-sectional view of the display device 300-6 according to the sixth embodiment is not shown, it is similar to the cross-sectional view (FIGS. 29 and 30) of the display device 300-1 according to the first embodiment. Thus, reference can be made to FIGS. 29 and 30 in the following description.

Referring to FIG. 35, the display device 300-6 according to the sixth embodiment can comprise a substrate 310, a first insulating layer 330, a barrier rib 340, a semiconductor light emitting device package 350, a plurality of first assembling wirings 321-1 to 321-3, a plurality of second assembling wirings 322-1 to 322-3, a plurality of first signal lines SL-1 to SL4, a plurality of second signal lines SL-1' to SL-4' and a second insulating layer 360. The display device 300-6 according to the sixth embodiment can comprise more components than these.

Although the semiconductor light emitting device package (350 of FIGS. 9 to 22) according to the first embodiment described above is shown in the drawings, one semiconductor light emitting device package among the semiconductor light emitting device package (350A, 350B, 350C and 350D of FIGS. 23 to 27) according to the second to fifth embodiments can also be employed. Since the structure, shape and/or function of each semiconductor light emitting device package (350 of FIGS. 9 to 22) according to the first embodiment has been described in detail above, further description will be omitted.

The first assembling wiring can comprise a first-first assembling wiring 321-1, a first-second assembling wiring 321-2, and a first-third assembling wiring 321-3, but be provided with the number smaller or smaller or larger than these.

The first-first assembling wiring 321-1 can extend from a first-first signal line SL-1 toward a first-first region 343-1 of the assembly hole 340H and can be located in the first-first region 343-1 of the assembly hole 340H. The first-second assembling wiring 321-2 can extend from a first-second signal line SL-2 toward a first-second region 343-2 of the assembly hole 340H and can be located in the first-second region 343-2 of the assembly hole 340H. The first-third assembling wiring 321-3 can extend from a first-third signal line SL-3 toward a first-third region 343-3 of the assembly hole 340H can be located in the first-third region 343-3 of the assembly hole 340H. The first-third assembling wiring 321-3 can vertically overlap the first-third region 343-3 of the assembly hole 340H.

Meanwhile, the second assembling wiring can comprise a second-first assembling wiring 322-1, a second-second assembling wiring 322-2, and a second-third assembling wiring 322-3, but be provided with the number smaller or smaller or larger than these.

The second-first assembling wiring 322-1 can extend from a second-first signal line SL-1' toward a second-first region 344-1 of the assembly hole 340H and can be located in the second-first region 344-1 of the assembly hole 340H. The second-second assembling wiring 322-2 can extend from a second-second signal line SL-2' toward a second-second region 344-2 of the assembly hole 340H and can be located in the second-second region 344-2 of the assembly hole 340H. The second-third assembling wiring 322-3 can extend from a second-third signal line SL-3' toward a second-third region 344-3 of the assembly hole 340H and can be located in the second-third region 344-3 of the assembly hole 340H.

The first-first assembling wiring 321-1 and the second-third assembling wiring 322-3 facing each other can be disposed on different layers. The first-first signal line SL-1 can be disposed between a first-third insulating layer 330-3 and a first-fourth insulating layer 330-4 of the first insulating layer 330, and the second-third signal line SL-3' can be disposed between a first-first insulating layer 330-1 and a first-second insulating layer 330-2 of the first insulating layer 330. In this case, the first-first assembling wiring 321-1 can extend from the first-first signal line SL-1, whereas the second-first assembling wiring 322-1 can extend from the second-third signal line SL-3' disposed on a different layer from the first-first signal line SL-1. Thus, the first-first assembling wiring 321-1 and the second-first assembling wiring 322-1 can be disposed on different layers.

The first-second assembling wiring 321-2 and the second-second assembling wiring 322-2 facing each other can be disposed on the same layer. The first-second signal line SL-2 and the second-second signal line SL-2' can be disposed between the first-second insulating layer 330-2 and the first-third insulating layer 330-3. In this case, the first-second assembling wiring 321-2 can extend from the first-second signal line SL-2, and the second-second assembling wiring 322-2 can extend from the second-second signal line SL-2' disposed on the same layer as the first-second signal line SL-2 Thus, the first-second assembling wiring 321-2 and the second-second assembling wiring 322-2 can be disposed on the same layer.

The first-third assembling wiring 321-3 and the second-first assembling wiring 322-1 facing each other can be disposed on different layers. The first-third signal line SL-3 can be disposed between the first-first insulating layer 330-1 and the first-second insulating layer 330-2 of the first insulating layer 330, and the second-first signal line SL-1 ' can be disposed between the 1-3 third insulating layers 330 - 3 and the first-fourth insulating layers 330 - 4 of the first insulating layer 330. In this case, the first-third assembling wiring 321-3 can extend from the first-third signal line SL-3, whereas the second-first assembling wiring 322-1 can extend from the second-first signal line SL-1' disposed on a different layer from the first-third signal line SL-3. Thus, the first-first assembling wiring 321-1 and the second-third assembling wiring 322-3 can be disposed on different layers.

According to the sixth embodiment, various DEP forces can be formed between the plurality of first assembling wirings 321-1 to 321-3 and the plurality of second assembling wirings 322-1 to 322-3. For example, the first-first assembling wiring 321-1 can be formed with a 1-1 DEP force, a 1-2 DEP force, and a 1-3 DEP force between the second-first assembling wiring 322-1, the second-second assembling wiring 322-2, and the second-third assembling wiring 322-3, respectively.

Accordingly, a large and uniform DEP force is formed in the assembly hole 340H. Thus, even if the size of the semiconductor light emitting device package 350 is larger than the size of individual semiconductor light emitting devices, it can be easily assembled into the assembly hole 340H.

### <Seventh embodiment>

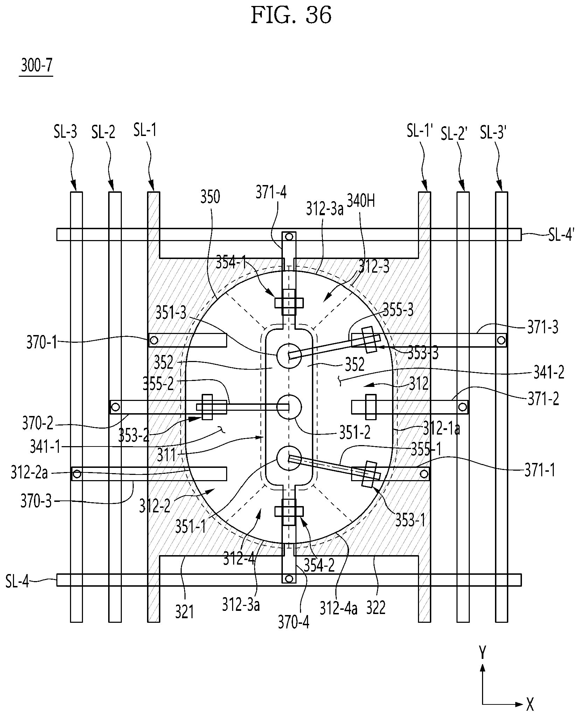

FIG. 36 is a plan view illustrating a display device according to a seventh embodiment.

The seventh embodiment is the same as the first embodiment except that the semiconductor light emitting device package 350 is rotated by 180° based on the normal position in the assembly hole 340H. In the seventh embodiment, components having the same structure, shape, and/or function as those in the fifth embodiment are given the same reference numerals, and detailed descriptions are omitted.

Although a cross-sectional view of the display device 300-7 according to the seventh embodiment is not shown, it is similar to the cross-sectional view (FIGS. 29 and 30) of the display device 300-1 according to the first embodiment. Thus, reference can be made to FIGS. 29 and 30 in the following description.

Referring to FIG. 36, the display device 300-7 according to the seventh embodiment can comprise a substrate 310, a first insulating layer 330, a barrier rib 340, a semiconductor light emitting device package 350, a first assembling wiring 321, a second assembling wiring 322, a plurality of first signal lines SL-1 to SL4, a plurality of second signal lines SL-1' to SL-4', and a second insulating layer 360. The display device 300-7 according to the seventh embodiment can comprise more components than these.

Although the semiconductor light emitting device package (350 of FIGS. 9 to 22) according to the first embodiment described above is shown in the drawings, one semiconductor light emitting device package among the semiconductor light emitting device package (350A, 350B, 350C and 350D of FIGS. 23 to 27) according to the second to fifth embodiments can also be employed. Since the structure, shape and/or function of each semiconductor light emitting device package (350 of FIGS. 9 to 22) according to the first embodiment has been described in detail above, further description will be omitted.

In the display device according to the first embodiment (300-1 in FIGS. 28 to 30), the semiconductor light emitting device package 350 can be assembled into the assembly hole 340H in the normal position.

In contrast, in the display device 300-7 according to the seventh embodiment, the semiconductor light emitting device package 350 can be assembled while being rotated by 180° relative to the normal position.

When the semiconductor light emitting device package 350 is assembled while being rotated by 180° relative to the normal position, the first-first signal line SL-1, the first-second signal line SL- 2, and the first-third signal line SL-3 can be disposed adjacent to a second-second region 312-2 of an elliptical shape of the first layer 3510 of the semiconductor light emitting device package 350, and the first-fourth signal line SL-4 can be disposed adjacent to a second-fourth region of the elliptical shape of the first layer 3510. In addition, the second-first signal line SL-1', the second-second signal line SL-2', and the second-third signal line SL-3' can be disposed adjacent to a second-first region 312-1 of the elliptical shape of the first layer 3510, and the second-fourth signal line SL-4'can be disposed adjacent to a second-third region 312-3 of the elliptical shape of the first layer 3510.

In the semiconductor light emitting device package 350, a first electrode pad 353-1 and a third electrode pad 353-3 can be disposed on the second-first region 312-3 of the elliptical shape of the first layer 3510, and the second electrode pad 353-2 can be disposed on the second-first region 312-3 of the elliptical shape of the first layer 3510.

In this case, the first-second signal line SL-2 can be connected to a second semiconductor light emitting device 351-2 on the semiconductor light emitting device package 350. The first-second signal line SL-2 can be connected to the second semiconductor light emitting device 351 through a second electrode wiring 355 - 2 (or a second electrode pad 353 - 2) on the semiconductor light emitting device package 350. That is, the first-second signal line SL-2 can be connected to a 1-2 connection line 370-2 and the second electrode wiring 355-2 (or the second electrode pad 353-2) can be connected to the second semiconductor light emitting device 351-2. In contrast, the first-first signal line SL-1 and the first-third signal line SL-3 cannot be connected to the first semiconductor light emitting device 351-1 and the third semiconductor light emitting device 351-3, respectively on the semiconductor light emitting device package 350.

Meanwhile, the second-first signal line SL-1' can be connected to the first semiconductor light emitting device 351-1 on the semiconductor light emitting device package 350. The second-first signal line SL-1' can be connected to the first semiconductor light emitting device 351-1 through the first electrode wiring 355-1 (or the first electrode pad 353-1) on the semiconductor light emitting device package 350. That is, the second-first signal line SL-1' can be connected to the first semiconductor light emitting device 351-1 through the 2-1 connection line 371-1 and the first electrode wiring 355-1 (or the first electrode pad 353-1) on the semiconductor light emitting device package 350.

The second-third signal line SL-3 ' can be connected to the third semiconductor light emitting device 351-3 on the semiconductor light emitting device package 350. The second-third signal line SL-3' can be connected to the third semiconductor light emitting device 351 - 3 through the third electrode wiring 355-3 (or the third electrode pad 353-3) on the semiconductor light emitting device package 350. That is, the 2nd-3rd signal line SL-3' can be connected to the third semiconductor light emitting device 351-3 through the 2-3 connection line 371-3 and the third electrode wiring 355-3 (or the third electrode pad 353-3) on the semiconductor light emitting device package 350.

In contrast, the second-second signal line SL-2' cannot be connected to the second semiconductor light emitting device 351-2 on the semiconductor light emitting device package 350, but is not limited thereto.

According to the seventh embodiment, even if the semiconductor light emitting device package 350 is not assembled into the assembly hole 340H in a normal position, that is, even if it is assembled while being rotated by 180° relative to the normal position, the first semiconductor light emitting device 351 -1, the second semiconductor light emitting device 351-2 and the third semiconductor light emitting device 351-3 can be connected to the corresponding signal lines, that is, the second-first signal line SL-1', the first-second signal line SL-2 and the second-third signal line SL-3', respectively and can be turned on, respectively. Accordingly, it is possible to dramatically increase the lighting rate by preventing lighting defects so that the ting yield can be improved.

Meanwhile, in the display devices 300-1 to 300-7 according to the first to seventh embodiments, the plurality of electrode pads 353-1 to 353-4, 354-1, and 354-2 can be connected the plurality of first signal lines SL-1 to SL-4 and/or the plurality of second signal lines SL-1' to SL-4' through an upper side of the semiconductor light emitting device package 350. That is, the plurality of electrode pads 353-1 to 353-4, 354-1, and 354-2 can be connected to the plurality of first signal lines SL-1 to SL-4 and/or the plurality of second signal lines SL-1' to SL-4' through contact holes formed in a second-second layer 3522 of a second layer 3520 of the semiconductor light emitting device package 350.

In contrast, the plurality of electrode pads 353-1 to 353-4, 354-1, and 354-2 can be connected to the plurality of first signal lines SL-1 to SL-4 and/or the plurality of second signal lines SL-1' to SL-4' through a lower side of the semiconductor light emitting device package 350.

It will be described in more detail with reference to FIGS. 37 and 38 below.

### <Eighth embodiment>

FIG. 37 is a plan view illustrating a display device according to an eighth embodiment. FIG. 38 is a cross-sectional view taken along the line G1-G2 in the display device according to the eighth embodiment of FIG. 37.

The eighth embodiment is the same as the fifth embodiment or the sixth embodiment except that it can be connected to a plurality of first signal lines SL-1 to SL-4 and/or a plurality of second signal lines SL-1' to SL-4' through a lower side of the semiconductor light emitting device package 350. In the eighth embodiment, components having the same structure, shape, and/or function as those in the fifth embodiment or the sixth embodiment are given the same reference numerals, and detailed descriptions are omitted.

Although a cross-sectional view of the display device 300-8 according to the eighth embodiment is not shown, it is similar to the cross-sectional view (FIGS. 29 and 30) of the display device 300-1 according to the first embodiment. Thus, reference can be made to FIGS. 29 and 30 in the following description.

Referring FIGS. 37 and 38, the display device 300-8 according to the eighth embodiment can comprise a substrate 310, a first insulating layer 330, a barrier rib 340, a semiconductor light emitting device package 350, a plurality of first assembling wiring 321-1 to 321-4, a plurality second assembling wiring 322-1 to 322-4, a plurality of first signal lines SL-1 to SL4, plurality of second signal lines SL- 1' to SL-4', and a second insulating layer 360. The display device 300-8 according to the eighth embodiment can comprise more components than these.

Although the semiconductor light emitting device package (350 of FIGS. 9 to 22) according to the first embodiment described above is shown in the drawings, one semiconductor light emitting device package among the semiconductor light emitting device package (350A, 350B, 350C and 350D of FIGS. 23 to 27) according to the second to fifth embodiments can also be employed. Since the structure, shape and/or function of each semiconductor light emitting device package (350 of FIGS. 9 to 22) according to the first embodiment has been described in detail above, further description will be omitted.

Meanwhile, the first assembling wiring can comprise a first-first assembling wiring 321-1, a first-second assembling wiring 321-2, and a first-third assembling wiring 321-3, but be provided with the number smaller or smaller or larger than these. The first-first assembling wiring 321-1 can extend from a first-first signal line SL-1 toward a first-first region 343-1 of the assembly hole 340H and can be located in the first-first region 343-1 of the assembly hole 340H. The first-second assembling wiring 321-2 can extend from a first-second signal line SL-2 toward a first-second region 343-2 of the assembly hole 340H and can be located in the first-second region 343-2 of the assembly hole 340H. The first-third assembling wiring 321-3 can extend from a first-third signal line SL-3 toward a first-third region 343-3 of the assembly hole 340H and can be located in the first-third region 343-3 of the assembly hole 340H.

The second assembling wiring can comprise a second-first assembling wiring 322-1, a second-second assembling wiring 322-2, and a second-third assembling wiring 322-3, but be provided with the number smaller or smaller or larger than these. The second-first assembling wiring 322-1 can extend from a second-first signal line SL-1' toward a second-first region 344-1 of the assembly hole 340H and can be located in the second-first region 344-1 of the assembly hole 340H. The second-second assembling wiring 322-2 can extend from a second-second signal line SL-2' toward a second-second region 344-2 of the assembly hole 340H and can be located in the second-second region 344-2 of the assembly hole 340H. The second-third assembling wiring 322-3 can extend from a second-third signal line SL-3' toward a second-third region 344-3 of the assembly hole 340H and can be located in the second-third region 344-3 of second-third region 344-3 of the assembly hole 340H.

The first-first assembling wiring 321-1 and the second-first assembling wiring 322-1 can be disposed to face each other along a first direction X in the assembly hole 340H. The first-second assembling wiring 321 - 2 and the second-second assembling wiring 322 - 2 can be disposed to face each other along the first direction X in the assembly hole 340H. The first-third assembling wirings 321-3 and the second-third assembling wirings 322-3 can be disposed to face each other along the first direction X in the assembly hole 340H. In this case, the first-first assembling wiring 321-1 and the second-first assembling wiring 322-1 can be disposed on the same layer. The first-second assembling wiring 321-2 and the second-second assembling wiring 322-1 can be disposed on the same layer. The first-third assembling wiring 321-3 and the second-third assembling wiring 322-3 can be disposed on the same layer.

The first-first assembling wiring 321-1, the first-second assembling wiring 321-2, the first-third assembling wiring 321-3, the second-first assembling wiring 322-1, the second-second assembling wiring 322-2 and the second-third assembling wiring 322-3 can be disposed. That is, the second-first assembling wiring 322-1 can extend from the second-first signal line SL-1' toward the assembly hole 340H to be disposed to face the first-first assembling wiring 321-1. The second-second assembling wiring 322-2 can extend from the second-second signal line SL-2' toward the assembly hole 340H to be disposed to face the first-second assembling wiring 321-2. The second-third assembling wiring 322-3 can extend from the second-third signal line SL-3' toward the assembly hole 340H to be disposed to face the first-third assembling wiring 321-3.

Although not shown, the first-first assembling wiring 321-1 and the second-first assembling wiring 322-1 can be diagonally symmetrical with respect to the center of the assembly hole 340H and can be disposed on the same layer. The first-second assembling wiring 321 - 2 and the second-second assembling wiring 322 - 2 can be disposed to face each other in the assembly hole 340H and can be disposed on the same layer. The first-third assembling wiring 321-3 and the second-third assembling wiring 322-3 are symmetrical in a diagonal direction with respect to the center of the assembly hole 340H and can be disposed on the same layer.

Meanwhile, the display device 300-8 according to the eighth embodiment can comprise a first-fourth assembling wiring 321-4 and a second-fourth assembling wiring 322-4.

The first-fourth assembling wiring 321-4 can extend from the first-fourth signal line SL-4 toward the assembly hole 340H along a second direction Y, and the second-fourth assembling wiring 322 -4 can extend from the second-fourth signal line SL-4' toward the assembly hole 340H along the second direction Y.

According to the eighth embodiment, during self-assembly, the DEP forces can be formed by the 1-1 to first-third assembling wirings 321-1 to 321-3 and the 2-1 to second-third assembling wirings 322-1 to 321-3 as well as the first-fourth assembling wiring 3231-4 and the second-fourth assembling wiring 322-4. Thus, the DEP forces formed in this way can greatly contribute to assembling the semiconductor light emitting device package 350.

In particular, the DEP force can be formed between the 1-1 to first-third assembling wirings 321-1 to 321-3 and the 2-1 to second-third assembling wirings 322-1 to 322-3 according to the first direction X. The DEP force can be formed between the first-fourth assembling wiring 421-4 and the second-fourth assembling wiring 422-4 along the second direction Y. Accordingly, since a uniform DEP force is applied to the semiconductor light emitting device 350 by the DEP force formed along the first direction X and the DEP force formed along the second direction Y, the semiconductor light emitting device package 350 can be more stably assembled into the assembly hole 340H, and assembly defects can be reduced.

Meanwhile, referring to FIGS. 29, 37, and 38 again, a plurality of contact holes can be formed on the first-first assembling wiring 321-1, the first-second assembling wiring 321-2, the first-third assembling wiring 321-3, the first-fourth assembling wiring 321-4, the second-first assembling wiring 322-1, the second-second assembling wiring 322-2, the second-third assembling wiring 322-3 and the second-fourth assembling wiring 322-4. The second insulating layer 360, the barrier rib 340, and the first insulating layer 330 can be removed to expose an upper surface of each of the first-first assembling wiring 321-1, the first-second assembling wiring 321-2, the first-third assembling wiring 321-3, the first-fourth assembling wiring 321-4, the second-first assembling wiring 322-1, the second-second assembling wiring 322-2, the second-third assembling wiring 322-3, and the second-fourth assembling wiring 322-4 so that contact holes can be formed.

Connection electrodes 380-1 to 380-3, 381-1 to 381-3, 382-1, and 382-2 can be formed in these contact holes. The connection electrodes 380-1 to 380-3, 381-1 to 381-3, 382-1, and 382-2 can be made of, for example, a solder material, but are not limited thereto. For example, the connection electrodes 380-1 to 380-3, 381-1 to 381-3, 382-1, and 382-2 can be In, Sn, In/Sn, Au/Sn, Ag paste, etc.

The connection electrodes 380-1 to 380-3, 381-1 to 381-3, 382-1, and 382-2 can be exposed in the assembly hole 340H, but are not limited thereto.

Meanwhile, through the lower side of the semiconductor light emitting device package 350, a plurality of contact holes can be formed to expose a first electrode pad 353-1, a second electrode pad 353-2, a third electrode pad 353-3, a fourth electrode pad 354- 4, a fifth electrode pad 353-5, the sixth electrode pad 353-6, and at least one or more common electrode pads 354-1 and 354-2.

As shown in FIG. 10, a first layer 3510 can be removed corresponding to each of the first electrode pad 353-1, the second electrode pad 353-2, the third electrode pad 353-3, the fourth electrode pad 354-4, the fifth electrode pad 353-5, the sixth electrode pad 353-6, and the at least one or more common electrode pads 354-1 and 354-2 so that contact holes can be formed. Thus, lower surfaces of the lower contact electrodes 353-1a, 353-2a, and 353-3a each of the first electrode pad 353-1, the second electrode pad 353-2, the third electrode pad 353-3, the fourth electrode pad 354-4, the fifth electrode pad 353-5, and the at least one or more common electrode pads 354-1, 354-2 can be exposed. A lower surface of the common electrode wiring 352 disposed below the t least one or more common electrode pads 354-1 and 354-2 can be exposed. As such, the plurality of contact holes can be formed in advance before the semiconductor light emitting device package 350 is self-assembled into the assembly hole 340H. At this time, the first electrode pad 353-1, the second electrode pad 353-2, the third electrode pad 353-3, the fourth electrode pad 354-4, the fifth electrode pad 353-51, and the at least one or more common electrode pads 354-1 and 354-2 can be exposed by the plurality of contact holes.

By performing a self-assembly process, the semiconductor light emitting device package 350 can be assembled into the assembly hole 340H. Accordingly, the exposed first electrode pad 353-1, the second electrode pad 353-2, the third electrode pad 353-3, the fourth electrode pad 354-4, the fifth electrode pad 353-5, the sixth electrode pad 353-6, and at least one or more common electrode pads 354-1 and 354-2 of the semiconductor light emitting device package 350 can be positioned corresponding to each other on the plurality of connection electrodes 380-1 to 380-3, 381-1 to 381-3, 382-1, and 382-2.

Thereafter, the semiconductor light emitting device package 350 can be pressurized and heated to melt the connection electrodes 380-1 to 380-3, 381-1 to 381-3, 382-1, and 382-2 made of solder material so that the connection electrodes 380-1 to 380-3, 381-1 to 381-3, 382-1, and 382-2 can fill the plurality of contact holes formed on the lower side of the semiconductor light emitting device package 350. Thereafter, a cooling process can be performed. Accordingly, the first electrode pad 353-1, the second electrode pad 353-2, the third electrode pad 353-3, the fourth electrode pad 354-4, the fifth electrode pad 353-5, the sixth electrode pad 353-6, and the at least one or more common electrode pads 354-1 and 354-2 of the semiconductor light emitting device package 350 can be connected to the first-first assembling wiring 321-1, the first-second assembling wiring 321-2, and the first-third assembling wiring 321-3, the first-fourth assembling wiring 321-4, the second-first assembling wiring 322-1, the second-second assembling wiring 322-2, the second-third assembling wiring 322-3 and/or the second-fourth assembling wiring 322-4, respectively, by the connection electrodes 380-1 to 380-3, 381-1 to 381-3, 382-1, and 382-2.

Accordingly, there is no need to form a plurality of connection lines (370-1 to 370-4 and 371-1 to 371-4 in FIG. 28) on the semiconductor light emitting device package 350 to connect the plurality of electrode pads 353-1 to 353-6, 354-1, and 354-2, the plurality of first signal lines SL-1 to SL-4, and/or the plurality of second signal lines SL-1' to SL-4'. Therefore, the structure is simple and the process time can be reduced, and electrical short defects between these connection lines (370-1 to 370-4 and 371-1 to 371-4 in FIG. 28) can be prevented.

As an example, the semiconductor light emitting device package 350 can be assembled into the assembly hole 340H in the normal position. In this case, the first electrode pad 353-1 can be connected to the first-first assembling wiring 321-1 by the first connection electrode 380-1, and the second electrode pad 353-2 can be connected to the second-second assembling wiring 321-2 by the second connecting electrode 380-2, and the third electrode pad 353-3 can be connected to the first-third assembling wiring 321-3 by the third connecting electrode 380-3. The fourth electrode pad 353-4 can be connected to the second-first assembling wiring 322-3 by the fourth connection electrode 381-1, and the fifth electrode pad 353-5 can be connected to the second-second assembling wiring 322-2 by the fifth connection electrode. 381-2, and the sixth electrode pad 353-6 can be connected to the second-third assembling wiring 322-1 by the sixth connection electrode 381-3. In addition, the first common electrode pad 354-1 can be connected to the first-fourth assembling wiring 321-4 by the seventh connection electrode 382-1, and the second common electrode pad 354-2 can be connected to the second-fourth assembling wiring 322-4 by the eighth connection electrode 382-2.

Although not shown, as shown in FIG. 36, the semiconductor light emitting device package 350 can be assembled into the assembly hole 340H shown in FIG. 37 while being rotated by 180° relative to the normal position. In this case, the first electrode pad 353-1 can be connected to the second-third assembling wiring 322-3 by the fourth connection electrode 381-1, and the second electrode pad 353-2 can be connected to the first-second assembling wiring 321-2 by the second connection electrode 380-2, and the third electrode pad 353-3 can be connected to the second-first assembling wiring 321-2 by the sixth connection electrode 381-3. In addition, the first common electrode pad 354-1 can be connected to the second-fourth assembling wiring 322-4 by the eighth connection electrode 382-2, or the second common electrode pad 354-2 can be connected to the first-fourth assembling wiring 321-4 by the seventh connection electrode 382-1.

According to the eighth embodiment, the plurality of first assembling wirings 321-1 to 321-4 and the plurality of second assembling wirings 322-1 to 322-4 can be used not only to assemble the semiconductor light emitting device package 350, but also to emit light from the semiconductor light emitting device package 350.

During self-assembly, the DEP forces can be formed between the first-first assembling wiring 321-1, the first-second assembling wiring 321-2, the first-third assembling wiring 321-3, and the first-fourth assembling wiring 321-4, the second-first assembling wiring 322-1, the second-second assembling wiring 322-2, the second-third assembling wiring 322-3, and the second-fourth assembling wiring 322- 4.

For example, voltages of the same polarity can be applied to the first-first assembling wiring 321-1, the first-second assembling wiring 321-2, the first-third assembling wiring 321-3, and the first-fourth assembling wiring 321-4.

For example, voltages of the same polarity can be applied to the second-first assembling wiring 322-1, the second-second assembling wiring 322-2, the second-third assembling wiring 322-3, and the second-fourth assembling wiring 322-4. That is, when the positive (+) voltage is applied to the first-first assembling wiring 321-1, the first-second assembling wiring 321-2, the first-third assembling wiring 321-3, and the first-fourth assembling wiring, the negative (-) voltage can be applied to the second-first assembling wiring 322-1, the second-second assembling wiring 322-2, and the second-third assembling wiring 322-3, and the second-fourth assembling wiring 322-4. Conversely, when the negative (-) voltage is applied to the first-first assembling wiring 321-1, the first-second assembling wiring 321-2, the first-third assembling wiring 321-3, and the first-fourth assembling wiring, the positive (+) voltage can be applied to the second-first assembling wiring 322-1, the second-second assembling wiring 322-2, the second-third assembling wiring 322-3, and the second-fourth assembling wiring 322-4.

At this time, even if the positive (+) voltage is applied to the first-first assembling wiring 321-1, the first-second assembling wiring 321-2, the first-third assembling wiring 321-3 and the first-fourth assembling wiring 321-4, the magnitude of the positive (+) voltage applied to each of the first-first assembling wiring 321-1, the first-second assembling wiring 321-2, the first-third assembling wiring 321-3 and the first-fourth assembling wiring 321-4 can or cannot be the same. Similarly, even if the negative (-) voltage is applied to the second-first assembling wiring 322-1, the second-second assembling wiring 322-2, the second-third assembling wiring 322-3, and the second-fourth assembling wiring 322-4, the second-first assembling wiring 322-1, the magnitude of the negative (-) voltage applied to each of the second-first assembling wiring 322-1, the second-second assembling wiring 322-2, the second-third assembling wiring 322-3, and the second-fourth assembling wiring 322-4 can or cannot be the same.

In this case, a 1-1 DEP force, a 1-2 DEP force, a 1-3 DEP force, and a 1-4 DEP forcer can be formed between the first-first assembling wiring 321-1 and each of the second-first assembling wiring 322-1, the second-second assembling wiring 322-2, the second-third assembling wiring 322-3, and the second-fourth assembling wiring 322-4. A 2-1 DEP force, a 2-2 DEP force, a 2-3 DEP force, and a 2-4 DEP forcer can be formed between the first-second assembling wiring 321-2 and each of the second-first assembling wirings 322-1, the second-second assembling wiring 322-2, the second-third assembling wiring 322-3, and the second-fourth assembling wiring 322-4. A 3-1 DEP force, a 3-2 DEP force, a 3-3 DEP force, and a 3-4 DEP forcer can be formed between the first-third assembling wiring 321-3 and each of the second-first assembling wiring 322-3, the second-second assembling wiring 322-2, the second-third assembling wiring 322-3, and the second-fourth assembling wiring 322-4. A 4-1 DEP force, a 4-2 DEP force, a 4-3 DEP force, and a 4-4 DEP forcer can be formed between the first-fourth assembling wiring 321-4 and each of the second-first assembling wiring 322-1, the second-second assembling wiring 322-2, the second-third assembling wiring 322-3, and the second-fourth assembling wiring 322-4.

Accordingly, a large and uniform DEP force is formed in the assembly hole 340H. Thus, even if the size of the semiconductor light emitting device package 350 is larger than the size of individual semiconductor light emitting devices, it can be easily assembled into the assembly hole 340H.

In addition, the plurality of electrode pads 353-1 to 353-6, 354-1, and 354-2 can be vertically connected to the plurality of assembling wirings 321-1 to 321-4 and 322-1 to 322-4 located in the assembly hole 340H through a lower side of the semiconductor light emitting device package 350 so that the electrical connection can be easy. Therefore, an additional process for electrical connection through the upper side of the semiconductor light emitting device package 350 is not required so that the structure is simple and when a separate connection electrode is formed, an electrical short defect between these connection electrodes can be prevented.

Meanwhile, the aforementioned display devices 300, 300-1, 300-2, 300-3, 300-4, 300-5, 300-6, 300-7, and 300-8 can be display panels. That is, in the embodiments, the display device and the display panel can be understood as the same meaning. In the embodiments, the display device in a practical sense can comprise a display panel and a controller (or processor) capable of controlling the display panel to display an image.

The embodiment can be adopted in the display field for displaying images or information. The embodiment can be adopted in the display field for displaying images or information using a semiconductor light emitting device. The semiconductor light emitting device can be a micro-level semiconductor light emitting device or a nano-level semiconductor light emitting device.

For example, the embodiment can be adopted for TV, signage, smart phone, mobile phone, mobile terminal, HUD for vehicle, backlight unit for laptop, display device for VR or AR.

The above detailed description should not be construed as limiting in all respects and should be considered illustrative. The scope of the embodiment should be determined by reasonable interpretation of the appended claims, and all changes within the equivalent range of the embodiment are included in the scope of the embodiment.

## Claims

1. A semiconductor light emitting device package (350, 350A, 350B, 350C and 350D), comprising:
a first layer (3510) having a first region (311) and a second region (312) surrounding the first region;
a common electrode wiring (352) on the first region of the first layer;
a plurality of semiconductor light emitting devices (351-1 to 351-6) on the common electrode wiring;
a plurality of electrode wirings (355-1 to 355-6) on upper sides of the plurality of semiconductor light emitting devices;
a plurality of electrode pads (353-1 to 353-6, 454-1 and 354-2) on the second region of the first layer; and
a second layer (3520) on the plurality of semiconductor light emitting devices, the plurality of electrode wirings, and the plurality of electrode pads,
wherein the first layer and the second layer have an elliptical shape,
wherein the plurality of electrode pads comprise a first electrode pad (353-1), a second electrode pad (353-2), a third electrode pad (353-3), and at least one or more common electrode pads (354-1 and 354-2),
wherein the first electrode pad, the second electrode pad, and the third electrode pad are configured to be disposed on the second region located on the minor axis of the elliptical shape,
wherein the common electrode pad is configured to be disposed on the second region located on the major axis of the elliptical shape, and
wherein the common electrode wiring is configured to commonly connect lower sides of the plurality of semiconductor light emitting devices to the common electrode pad.

2. The semiconductor light emitting device package of claim 1, wherein the second region comprises:
a second-first region (312-1) on a first side of the first region and a second-second region (312-2) on a second side of the first region along the minor axis direction of the elliptical shape; and
a second-third region (312-3) on a third side of the first region and a second-fourth region (312-4) on a fourth side of the first region along the major axis direction of the elliptical shape,
wherein the plurality of semiconductor light emitting devices comprise a first semiconductor light emitting device (351-1), a second semiconductor light emitting device (351-2), and a third semiconductor light emitting device (351-3) constituting a first pixel (PX1), and
wherein the first semiconductor light emitting device, the second semiconductor light emitting device, and the third semiconductor light emitting device are arranged in a line along the major axis direction of the elliptical shape.

3. The semiconductor light emitting device package of claim 1 or 2, wherein the plurality of semiconductor light emitting devices comprise a fourth semiconductor light emitting device (351-4), a fifth semiconductor light emitting device (351-5), and a sixth semiconductor light emitting device (351-6) constituting a second pixel (PX2),
wherein the plurality of electrode pads comprise a fourth electrode pad (353-4), a fifth electrode pad (353-5), and a sixth electrode pad (353-6), and
wherein the first to sixth electrode pads are configured to be connected to the first to sixth semiconductor light emitting devices.

4. The semiconductor light emitting device package of any one of the preceding claims, wherein the plurality of semiconductor light emitting devices comprise a fourth semiconductor light emitting device (351-4), a fifth semiconductor light emitting device(351-5), and a sixth semiconductor light emitting device (351-6) constituting a redundancy pixel (PX_R),
wherein the plurality of electrode pads comprise a fourth electrode pad(353-4), a fifth electrode pad (353-5), and a sixth electrode pad (353-6), and
wherein the first to sixth electrode pads are configured to be connected to the first to sixth semiconductor light emitting devices.

5. The semiconductor light emitting device package of any one of the preceding claims, wherein the first to third semiconductor light emitting devices emit a first light,
comprising:
a color conversion layer (3430) between the first to third semiconductor light emitting devices and the second layer,
wherein the color conversion layer comprises:
a first color conversion pattern (3431) configured to output a second light using the first light emitted from the second semiconductor light emitting device; and
a second color conversion pattern (3432) configured to output a third light using the first light emitted from the third semiconductor light emitting device,
wherein the first light, the second light, and the third light are different from each other.

6. The semiconductor light emitting device package of any one of the preceding claims, comprising:
at least one layer of a reflective layer (3550) or a magnetic layer below the first layer.

7. A display device (300, 300-1, 300-2, 300-3, 300-4, 300-5, 300-6, 300-7, 300-8), comprising:
a substrate (310);
a plurality of first signal lines (SL-1 to SL4) and a plurality of second signal lines (SL-1' to SL-4') on the substrate, at least one or more first signal lines among the plurality of first signal lines comprising a first assembling wiring (321), and at least one or more second signal lines among the plurality of second signal lines comprising a second assembling wiring (322);
a barrier rib (340) having an assembly hole on the first assembling wiring and the second assembling wiring; and
a semiconductor light emitting device package (350, 350A, 350B, 350C and 350D) in the assembly hole,
wherein the semiconductor light emitting device package comprises:
a first layer having a first region and a second region surrounding the first region;
a common electrode wiring on the first region of the first layer;
a plurality of semiconductor light emitting devices on the common electrode wiring;
a plurality of electrode wirings on upper sides of the plurality of semiconductor light emitting devices;
a plurality of electrode pads on the second region of the first layer; and
a second layer on the plurality of semiconductor light emitting devices, the plurality of electrode wirings, and the plurality of electrode pads,
wherein the assembly hole has a shape corresponding to a shape of the semiconductor light emitting device package, and
wherein the first layer and the second layer have an elliptical shape.

8. The display device of claim 7, wherein the plurality of electrode pads comprise a first electrode pad, a second electrode pad, a third electrode pad, and at least one or more common electrode pads,
wherein the first electrode pad, the second electrode pad, and the third electrode pad are disposed on the second region located on the minor axis of the elliptical shape,
wherein the plurality of electrode wirings are configured to connect upper sides of the plurality of semiconductor light emitting devices to the first electrode pad, the second electrode pad, and the third electrode pad,
wherein the common electrode pad is disposed on the second region located on the major axis of the elliptical shape, and
wherein the common electrode wiring is configured to commonly connects lower sides of the plurality of semiconductor light emitting devices to the common electrode pad.

9. The display device of claims 7 or 8, wherein the plurality of first signal lines comprise a first-first signal line (SL-1), a first-second signal line (SL-2), a first-third signal line (SL-3), and a first-fourth signal line (SL-4) crossing the first-third signal line,
wherein the first-first signal line among the first-first signal line, the first-second signal line, and the first-third signal line is closest to the assembly hole,
wherein the plurality of second signal lines comprise a second-first signal line (SL-1'), a second-second signal line (SL-2'), and a second-third signal line (SL-3') disposed in parallel with the plurality of first signal lines and a second-fourth signal line (SL-4') crossing the second-third signal line,
wherein the second-first signal line among the second-first signal line, the second-second signal line, and the second-third signal line is closest to the assembly hole.

10. The display device of any one of the preceding claims, wherein the first assembling wiring comprises a first-first assembling wiring (321-1), a first-second assembling wiring (321-2), and a first-third assembling wiring (321-3) extending toward the assembly hole from the first-first signal line, the first-second signal line, and the first-third signal line, and
wherein the second assembling wiring comprises a second-first assembling wiring (322-1), a second-second assembling wiring (322-2), and a second-third assembling wiring (322-3) extending toward the assembly hole from the second-first signal line, the second-second signal line, and the second-third signal line.

11. The display device of any one of the preceding claims, wherein two among the first electrode pad, the second electrode pad, and the third electrode pad are configured to be connected to two among the first-first signal line, the first-second signal line, and the first-third signal line, and
wherein one of the first electrode pad, the second electrode pad, and the third electrode pad is configured to be connected to one of the second-first signal line, the second-second signal line, and the second-third signal line.

12. The display device of any one of the preceding claims, wherein one of the first electrode pad, the second electrode pad, and the third electrode pad is configured to be connected to one of the first-first signal line, the first-second signal line, and the first-third signal line, and
wherein two among the first electrode pad, the second electrode pad, and the third electrode pad are configured to be connected to two among the second-first signal line, the second-second signal line, and the second-third signal line.

13. The display device of any one of the preceding claims, wherein the first assembling wiring comprises a first-fourth assembling wiring extending from the first-fourth signal line toward the assembly hole, and
wherein the second assembling wiring comprises a second-fourth assembling wiring extending from the second-fourth signal line toward the assembly hole.

14. The display device of any one of the preceding claims, wherein two among the first electrode pad, the second electrode pad, and the third electrode pad are configured to be connected to two among the first-first assembling wiring, the first-second assembling wiring, and the first-third assembling wiring in the assembly hole,
wherein one of the first electrode pad, the second electrode pad, and the third electrode pad is configured to be connected to one of the second-first assembling wiring, the second-second assembling wiring, and the second-third assembling wiring in the assembly hole, and
wherein the common electrode pad is configured to be connected to one of the first-fourth assembling wiring and the second-fourth assembling wiring.

15. The display device of any one of the preceding claims, wherein one of the first electrode pad, the second electrode pad, and the third electrode pad is configured to be connected to one of the first-first assembling wiring, the first-second assembling wiring, and the first-third assembling wiring in the assembly hole,
wherein two among the first electrode pad, the second electrode pad, and the third electrode pad are configured to be connected to two among the second-first assembling wiring, the second-second assembling wiring, and the second-third assembling wiring in the assembly hole, and
wherein the common electrode pad is configured to be connected to one of the first-fourth assembling wiring and the second-fourth assembling wiring.
